(19) Europäisches Patentamt / European Patent Office / Office européen des brevets

(11) EP 4 159 456 B1

(12) # EUROPEAN PATENT SPECIFICATION

(45) Date of publication and mention of the grant of the patent:
**11.03.2026 Bulletin 2026/11**

(21) Application number: **21812647.2**

(22) Date of filing: **26.05.2021**

(51) International Patent Classification (IPC):
***B41C 1/10*** *(2006.01)* ***B41M 1/06*** *(2006.01)*
***B41N 1/08*** *(2006.01)* ***B41N 3/03*** *(2006.01)*

(52) Cooperative Patent Classification (CPC):
**B41C 1/1008; B41M 1/06; G03F 7/004; G03F 7/027; G03F 7/029; G03F 7/033; G03F 7/09; G03F 7/11;** B41C 1/1016; B41C 2201/04; B41C 2210/04; B41C 2210/08; B41C 2210/22; B41C 2210/24

(86) International application number:
**PCT/JP2021/020022**

(87) International publication number:
**WO 2021/241638 (02.12.2021 Gazette 2021/48)**

(54) **ON-PRESS-DEVELOPMENT-TYPE LITHOGRAPHIC PRINTING PLATE PRECURSOR, LITHOGRAPHIC PRINTING PLATE PRODUCTION METHOD, AND LITHOGRAPHIC PRINTING METHOD**

LITHOGRAFIEDRUCKPLATTENVORLÄUFER MIT ENTWICKLUNG AUF DER DRUCKPRESSE, LITHOGRAFIEDRUCKPLATTENHERSTELLUNGSVERFAHREN UND LITHOGRAFIEDRUCKVERFAHREN

PRÉCURSEUR DE PLAQUE D'IMPRESSION LITHOGRAPHIQUE DE TYPE À DÉVELOPPEMENT À LA PRESSE, PROCÉDÉ DE FABRICATION DE PLAQUE D'IMPRESSION LITHOGRAPHIQUE ET PROCÉDÉ D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.05.2020 JP 2020095078**

(43) Date of publication of application:
**05.04.2023 Bulletin 2023/14**

(73) Proprietor: **FUJIFILM Corporation**
**Tokyo 106-8620 (JP)**

(72) Inventor: **MATSUURA, Atsushi**
**Haibara-gun, Shizuoka 421-0396 (JP)**

(74) Representative: **HGF**
**HGF Limited**
**4th Floor, 1 City Square**
**Leeds LS1 2ES (GB)**

(56) References cited:
**EP-A1- 3 511 174**
**EP-A1- 3 991 983**
**JP-A- 2006 205 394**
**JP-A- 2019 162 854**
**JP-A- 2019 162 855**
**JP-A- 2020 069 790**
**US-A1- 2004 081 911**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## BACKGROUND OF THE INVENTION

1. Field of the Invention

The present invention relates to an on-press development type lithographic printing plate precursor, a method of preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (non-ink-receiving portion) respectively, the adhesiveness of ink is varied within the surface of the lithographic printing plate such that only the image area receives the ink, and then printing is performed by the transfer of the ink to a printing substrate such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, on-press development is a method of exposing a lithographic printing plate precursor, then immediately mounting the precursor on a printer without performing development of the related art, and removing an unnecessary portion of the image-recording layer at an early stage of the ordinary printing step.

In the present invention, a lithographic printing plate precursor that can be used for such on-press development is called "on-press development type lithographic printing plate precursor".

Examples of the lithographic printing plate precursors in the related art include the lithographic printing plate precursor described in WO2019/219560A.

WO2019/219560A describes a negative tone lithographic printing plate precursor having a topcoat layer that contains an infrared absorber having a pyrolytic group.

EP3511174 discloses a lithographic printing plate precursor including an aluminum support, and an image recording layer on the aluminum support, in which the aluminum support includes an anodized film on a surface of the image recording layer side, the anodized film has micropores extending in a depth direction from the surface of the anodized film on the image recording layer side, an average pore diameter of the micropores in the surface of the anodized film is greater than 0 μm and 0.03 μm or less, an average maximum diameter of the micropores inside the anodized film is in a range of 0.04 μm to 0.30 μm, an average value A nm of thicknesses of surface opening portions and an average value B nm of thicknesses of internal maximum diameter portions satisfy a relationship of $2.5 \leq B/A \leq 28.0$, and the image recording layer contains an acid color former.

EP3991983 is prior art under Article 54(3) EPC. EP3991983 discloses an on-press development type lithographic printing plate precursor including an aluminum support and an image-recording layer on the aluminum support, in which the image-recording layer contains an infrared absorber, a polymerization initiator, a polymerizable compound, and an addition polymerization-type resin having a hydrophilic structure, a water contact angle on a surface of the aluminum support on a side of the image-recording layer that is determined by an airborne water droplet method is 110° or less, and the polymerizable compound includes a polymerizable compound having 7 or more functional groups.

## SUMMARY OF THE INVENTION

An object of an embodiment of the present invention is to provide an on-press development type lithographic printing plate precursor excellent in visibility and contamination suppressiveness.

An object of another embodiment of the present invention is to provide a method of preparing a lithographic printing plate and a lithographic printing method in which the on-press development type lithographic printing plate

precursor is used.

Means for achieving the above objects include the following aspects. The invention is defined in the appended claim set.

According to an embodiment of the present invention, it is possible to provide an on-press development type lithographic printing plate precursor excellent in visibility and contamination suppressiveness.

According to another embodiment of the present invention, it is possible to provide a method of preparing a lithographic printing plate and a lithographic printing method in which the on-press development type lithographic printing plate precursor is used.

## BRIEF DESCRIPTION OF THE DRAWINGS

Fig. 1 is a schematic cross-sectional view of an embodiment of an aluminum support suitably used in the present invention.

Fig. 2 is a schematic cross-sectional view of an embodiment of an aluminum support having an anodic oxide film.

Fig. 3 is an example of a waveform graph of alternating current used for an electrochemical roughening treatment in a manufacturing method of an aluminum support having an anodic oxide film.

Fig. 4 is a lateral view showing an example of a radial cell in an electrochemical roughening treatment using alternating current in a manufacturing method of an aluminum support having an anodic oxide film.

Fig. 5 is a schematic view of an anodization treatment device used for an anodization treatment in a manufacturing method of an aluminum support having an anodic oxide film.

## DESCRIPTION OF THE PREFERRED EMBODIMENTS

Hereinafter, the contents of the present invention will be specifically described. The following configuration requirements will be described on the basis of typical embodiments of the present invention, but the present invention is not limited to such embodiments.

Herein, a numerical range expressed using "to" includes numerical values listed before and after "to" as the lower limit and the upper limit.

In addition, herein, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

Herein, "(meth)acryl" is a term used to explain a concept including both the acryl and methacryl, and "(meth) acryloyl" is a term used to explain a concept including both the acryloyl and methacryloyl.

In addition, the term "step" herein means not only an independent step but also a step that cannot be clearly differentiated from other steps as long as the intended goal of the step is achieved. In the present disclosure, "% by mass" has the same definition as "% by weight", and "part by mass" has the same definition as "part by weight".

Herein, unless otherwise specified, as each component contained in a composition or each constitutional unit contained in a polymer, one kind of component or one kind of constitutional unit may be used alone, or two or more kinds of components or two or more kinds of constitutional units may be used in combination.

Furthermore, herein, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

Herein, a combination of two or more preferred aspects is a more preferred aspect.

In addition, herein, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

Herein, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not

used, in a case where monochromatic or dichromatic printing is carried out on a part of paper during, for example, color newspaper printing.

Herein, "excellent in printing durability" means that a large number of sheets can be printed using a lithographic printing plate, and printing durability exhibited in a case where a UV ink used as a printing ink will be also described as "UV printing durability" hereinafter.

Hereinafter, the present invention will be specifically described.

(On-press development type lithographic printing plate precursor)

The on-press development type lithographic printing plate precursor according to the present invention (also simply called "lithographic printing plate precursor") has an aluminum support, an image-recording layer, and an outermost layer in this order, in which the image-recording layer contains an infrared absorber, a polymerization initiator, and a polymerizable compound, the aluminum support has an aluminum plate and an anodic oxide film of aluminum disposed on the aluminum plate, a steepness a45 that represents an area ratio of a component having a wavelength of 0.2 μm to 2 μm in a portion having an inclination of 45° or more within a surface of the anodic oxide film on a side of the image-recording layer is 30% or less, and the outermost layer contains a discoloring compound.

In addition, the on-press development type lithographic printing plate precursor is preferably a negative tone lithographic printing plate precursor.

The inventors of the present invention have found that in a case where an outermost layer containing a discoloring compound is provided as in the lithographic printing plate precursor of the related art described in WO2019/219560A, although the visibility of an exposed portion and a non-exposed portion is improved, the component of the outermost layer, such as the discoloring compound, adheres to the precursor surface during development, which leads to a problem in that a non-image area is contaminated during printing.

As a result of intensive studies, the inventors of the present invention have found that adopting the above constitution makes it possible to provide an on-press development type lithographic printing plate precursor excellent in visibility and contamination suppressiveness.

The detailed mechanism that brings about the aforementioned effect is unclear, but is assumed to be as below.

Presumably, in a case where a steepness a45 which represents an area ratio of a portion that is composed of a component having a wavelength of 0.2 μm to 2 μm and has an inclination of 45° or more within the surface of the anodic oxide film on the side of the image-recording layer is 30% or less, the shape corresponding to the component having a wavelength of 0.2 μm to 2 μm is gentle in the surface shape of the aluminum support, which may inhibit the component of the outermost layer, such as the discoloring compound, from adhering to the precursor surface, and result in excellent visibility and excellent contamination suppressiveness.

Hereinafter, each of the configuration requirements in the lithographic printing plate precursor according to the present invention will be specifically described.

<Aluminum support>

The lithographic printing plate precursor according to the present invention has an aluminum support, an image-recording layer, and an outermost layer in this order, in which the aluminum support has an aluminum plate and an anodic oxide film of aluminum disposed on the aluminum plate, and a steepness a45 that represents an area ratio of a portion that is composed of a component having a wavelength of 0.2 μm to 2 μm and has an inclination of 45° or more within a surface of the anodic oxide film on a side of the image-recording layer is 30% or less.

The aluminum support used in the present invention has an aluminum plate and an anodic oxide film of aluminum disposed on the aluminum plate.

One of the examples of preferred aspects of the aluminum support used in the present invention (the aluminum support according to this example is also called "support (1)") is as below.

That is, the support (1) preferably has an aluminum plate and an anodic oxide film of aluminum disposed on the aluminum plate, the anodic oxide film is preferably at a position closer to a side of the image-recording layer than the aluminum plate and preferably has micropores extending in a depth direction from the surface of the anodic oxide film on the side of the image-recording layer, the average diameter of the micropores within the surface of the anodic oxide film is preferably more than 10 nm and 100 nm or less, and a value of brightness L* of the surface of the anodic oxide film on the side of the image-recording layer is preferably 70 to 100 in the L*a*b* color system.

The thickness of the anodic oxide film is not particularly limited, but is preferably 200 nm to 4,000 nm, more preferably 200 nm to 3,000 nm, even more preferably 500 nm to 2,000 nm, and particularly preferably 750 nm to 2,000 nm.

The aluminum plate (aluminum support) consists of a dimensionally stable metal containing aluminum as a main component, that is, aluminum or an aluminum alloy. The aluminum plate consists of a pure aluminum plate or an alloy plate containing aluminum as main component and traces of different elements.

The different elements contained in the aluminum alloy include silicon, iron, manganese, copper, magnesium, chromium, zinc, bismuth, nickel, titanium, and the like. The content of the different elements in the alloy is 10% by mass or less. As the aluminum plate, a pure aluminum plate is suitable. However, the aluminum plate may contain traces of different elements, because it is difficult to manufacture perfectly pure aluminum by smelting technologies. The composition of the aluminum plate is not limited, and aluminum plates made of generally known materials (for example, JIS A 1050, JIS A 1100, JIS A 3103, and JIS A 3005) can be appropriately used.
The width of the aluminum plate is preferably about 400 mm to 2,000 mm. The thickness of the aluminum plate is preferably about 0.1 mm to 0.6 mm. This width or thickness can be appropriately changed depending on the size of the printer and the printing plate or changed as the user wishes.
Fig. 1 is a schematic cross-sectional view of an embodiment of an aluminum support 12a.
The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the image-recording layer side than the aluminum plate 18. That is, it is preferable that the lithographic printing plate precursor have at least an anodic oxide film and an image-recording layer in this order on an aluminum plate.

-Anodic oxide film-

In the aluminum support used, the anodic oxide film is positioned such that the anodic oxide film is closer to the side of the image-recording layer than the aluminum plate, and has micropores extending in a depth direction from a surface of the anodic oxide film on the side of the image-recording layer.
Hereinafter, preferred aspects of the anodic oxide film 20a shown in Fig. 1 will be described.
The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image-recording layer side (that is, a surface of the anodic oxide film 20a opposite to the aluminum plate 18) along the thickness direction (that is, toward the aluminum plate 18).

-Steepness a45-

The steepness a45 which represents the area ratio of a portion having an inclination of 45° or more obtained by extracting a component having a wavelength of 0.2 $\mu$m to 2 $\mu$m within the surface of the anodic oxide film on the side of the image-recording layer is 30% or less. From the viewpoint of on-press developability, visibility, and contamination suppressiveness, the steepness a45 is preferably 2% to 30%, more preferably 2% to 25%, even more preferably 5% to 20%, and particularly preferably 8% to 18%.
The steepness a45 is one of the factors representing the surface shape, and is a value obtained according to the following procedures (1) to (3).

(1) Measuring surface shape and obtaining three-dimensional data

First, the surface shape of the aluminum support on the side of the anodic oxide film is measured using an atomic force microscope (AFM), thereby obtaining three-dimensional data.
The measurement is performed under the following conditions, for example. Specifically, the aluminum support 12a is cut in a size of 1 cm $\times$ 1 cm, set on a horizontal sample stage of a piezo scanner, and a cantilever is caused to approach the sample surface. At a point in time when the cantilever reaches a region where atom force works, the sample is scanned in the XY direction, and the irregularity of the sample observed at that time is adopted as piezo displacement in the Z direction. As the piezo scanner, a scanner that can scan 150 $\mu$m in the XY direction and 10 $\mu$m in the Z direction is used. As the cantilever, a cantilever having a resonance frequency of 120 kHz to 150 kHz and a spring constant of 12 N/m to 20 N/m (SI-DF20, manufactured by NANOPROBE) is used, and the measurement is performed in a Dynamic Force mode (DFM). The obtained three-dimensional data is subjected to least squares approximation such that the slight inclination of the sample is corrected, thereby obtaining a reference surface.
During the measurement, 512 $\times$ 512 points in a 25 $\mu$m $\times$ 25 $\mu$m region within the surface are measured. The resolution in the XY direction is 1.9 $\mu$m, the resolution in the Z direction is 1 nm, and the scanning speed is 60 $\mu$m/sec.

(2) Performing correction

For the calculation of the steepness a45, data is used which is obtained by correction as a process of selecting components having a wavelength of 0.2 $\mu$m to 2 $\mu$m from the three-dimensional data obtained in the above section (1). The

correction makes it possible to remove noise that occurs when the probe touches the edge portion of a projection portion and thus bounces or when a portion of the probe other than the probe tip touches the wall surface of a deep recess portion in a case where the surface having deep irregularities, such as the aluminum support used in the lithographic printing plate precursor, is scanned with the AFM probe.

The correction is performed by subjecting the three-dimensional data obtained in the above section (1) to high-speed Fourier transform to obtain frequency distribution, then selecting components having a wavelength of 0.2 μm to 2 μm, and then performing an inverse Fourier transform.

(3) Calculating steepness a45

By using the three-dimensional data (f (x, y)) obtained by the correction in the above section (2), three adjacent points are extracted, and the angle formed between the reference surface and a minute triangle formed by the three points is calculated for all data, thereby obtaining an inclination distribution curve. Furthermore, the total area of the minute triangle is calculated and adopted as an actual area. From the inclination distribution curve, the steepness a45 (unit: %), which is the ratio of the area of the portion having an inclination of 45° or more to the actual area, is calculated.

-Average diameter of micropores within surface of the anodic oxide film-

In the anodic oxide film, from the viewpoint of UV printing durability, on-press developability, and contamination suppressiveness, the average diameter (average opening diameter, hereinafter, also simply called "average diameter") of the micropores within the surface of the anodic oxide film is preferably more than 10 nm and 100 nm or less, more preferably 12.5 nm to 60 nm, even more preferably 15 nm to 50 nm, and particularly preferably 20 nm to 40 nm. The internal diameter of the pores may be larger or smaller than the pore diameter within the surface layer.

The average diameter of the micropores is calculated by a method of observing the surface of the anodic oxide film with a field emission scanning electron microscope (FE-SEM) at 150,000X magnification (N = 4), measuring the size (diameter) of 50 micropores existing in a range of 400 nm × 600 nm in the obtained 4 images, and calculating the arithmetic mean thereof.

In a case where the shape of the micropores is not circular, the equivalent circular diameter is used. "Equivalent circular diameter" is a diameter determined on an assumption that the opening portion is in the form of a circle having the same projected area as the projected area of the opening portion.

The depth of the micropores is not particularly limited, but is preferably 10 nm to 3,000 nm, more preferably 50 nm to 2,000 nm, and even more preferably 300 nm to 1,600 nm.

The depth is a value obtained by taking a photograph (150,000X magnification) of a cross section of the anodic oxide film, measuring the depths of 25 or more micropores, and calculating the average thereof.

The shape of the micropores is not particularly limited. In Fig. 1, the micropores have a substantially straight tubular shape (substantially cylindrical shape). However, the micropores may have a conical shape that tapers along the depth direction (thickness direction). The shape of the bottom portion of the micropores is not particularly limited, and may be a curved (convex) or flat surface shape.

In the L*a*b* color system, the value of brightness L* of the surface of the aluminum support on the image-recording layer side (surface of the anodic oxide film on the image-recording layer side) is preferably 70 to 100. Particularly, from the viewpoint of printing durability and visibility, the value of brightness L* is preferably 75 to 100, and more preferably 75 to 90.

The brightness L* is measured using a color difference meter Spectro Eye manufactured by X-Rite, Incorporated.

[Specific surface area ΔS]

A specific surface area ΔS of the aluminum support used is calculated by Equation (i) from Sx which represents an actual area obtained by an approximate three-point method from three-dimensional data obtained by measuring 512 × 512 points in a 25 μm × 25 μm region within the surface of the anodic oxide film on the side of the image-recording layer by using an atomic force microscope, and $S_0$ which represents a geometrically measured area.

$$\Delta S = (S_X - S_0)/S_0 \times 100\ (\%) \cdots (i)$$

The geometrically measured area $S_0$ represents an area of a 25 μm × 25 μm region.

From the viewpoint of on-press developability, visibility, and contamination suppressiveness, the specific surface area ΔS is preferably 25% or more, more preferably 25% to 60%, even more preferably 30% to 50%, and particularly preferably 35% to 45%.

The specific surface area ΔS can be adjusted by controlling the etching amount of aluminum of a surface subjected to a roughening treatment by means of changing the temperature of an aqueous alkali solution used in the alkaline etching treatment that will be described later.

In the measuring method of the specific surface area ΔS, first, three-dimensional data (f(x, y)) is obtained according to the same procedure as in the section (1) performed for calculating the steepness a45 described above.

Then, by using the three-dimensional data (f (x, y)) obtained as above, three adjacent points are extracted, and the total area of the minute triangle formed by the three points is calculated and adopted as an actual area $S_x$.

A surface area difference ΔS, that is, the specific surface area ΔS is calculated by Equation (i) from the obtained actual area $S_x$ and the geometrically measured area $S_0$.

Specifically, in the measuring method of the specific surface area ΔS, the aluminum support is cut in a size of 1 cm × 1 cm to prepare a sample, the sample is set on a horizontal sample stage of a piezo scanner, and a cantilever is caused to approach the sample surface. At a point in time when the cantilever reaches a region where atomic force works, the sample is scanned in the XY direction, and the irregularity of the sample observed at that time is adopted as piezo displacement in the Z direction. As the piezo scanner, a scanner that can scan 150 μm in the XY direction and 10 μm in the Z direction is used. As the cantilever, a cantilever having a resonance frequency of 130 kHz to 200 kHz and a spring constant of 7 N/m to 20 N/m (OMCL-AC200-TS, manufactured by Olympus Corporation) is used, and the measurement is performed in a Dynamic Force (DFM) mode. The obtained three-dimensional data is subjected to least squares approximation such that the slight inclination of the sample is corrected, thereby obtaining a reference surface.

The measurement is performed on 512 × 512 points in a 25 μm× 25 μm region within the surface of the sample. The specific surface area ΔS is measured under the conditions of a resolution in the X direction of 0.05 μm, a resolution in the Y direction of 1.9 μm, a resolution in the Z direction of 1 nm, and a scanning speed of 18 μm/sec.

From the viewpoint of printing durability, on-press developability, visibility, and contamination suppressiveness, a density of recess portions having a depth of 0.7 μm or more from a centerline in a roughness curve, the density being obtained by measuring a 400 μm × 400 μm region of a surface of the aluminum support on the side of the image-recording layer by using a non-contact three-dimensional roughness meter, is 300 or more, more preferably 300 to 1,000, even more preferably 300 to 700, and particularly preferably 320 to 500.

The density of recess portions having a depth of 0.7 μm or more from the centerline refers to a value measured as below.

First, by using a non-contact three-dimensional roughness meter (for example, VertScan, manufactured by Ryoka Systems Inc.), a 400 μm × 400 μm region of the surface of the aluminum support on the side of the image-recording layer is scanned in a non-contact manner at a resolution of 0.01 μm, thereby obtaining three-dimensional data.

Then, the obtained three-dimensional data is subjected to image analysis using software (SX Viewer, manufactured by Ryoka Systems Inc.), and the number of recess portions having a depth of 0.70 μm or more from the centerline in the obtained roughness curve is counted.

For each sample, the density of recess portions is measured at 5 sites, and the average thereof is calculated and adopted as the density of recess portions.

The opening ratio by the micropores within the surface of the anodic oxide film is not particularly limited. From the viewpoint of printing durability, on-press developability, visibility, and contamination suppressiveness, the opening ratio to the total area of the anodic oxide film is preferably 10% to 90%, more preferably 20% to 80%, and particularly preferably 30% to 80%.

The aforementioned opening ratio by the micropores is determined by observing the surface of the anodic oxide film (N = 4) with a field emission scanning electron microscope (FE-SEM) at 150,000X magnification, analyzing the obtained 4 images with image analysis software image factory to calculate a proportion of an area occupied by the micropores, and adopting the ratio as the opening ratio.

The density of the micropores within the surface of the anodic oxide film is not particularly limited. From the viewpoint of printing durability, on-press developability, visibility, and contamination suppressiveness, the density of the micropores per unit area of the anodic oxide film is preferably 200/$\mu m^2$ to 2,000/$\mu m^2$, and more preferably 300/$\mu m^2$ to 2,000/$\mu m^2$.

The above density is determined by observing the surface of the anodic oxide film 20 with a field emission scanning electron microscope (FE-SEM) at 150,000X magnification (N = 4), counting the number of micropores (large diameter portions) existing in a range of 400 nm × 600 nm in the obtained 4 images, and calculating the arithmetic mean of the counted number.

From the viewpoint of on-press developability and contamination suppressiveness, for example, an aspect is also preferable in which the micropores in the support (1) are each composed of a large diameter portion that extends to a position at a depth of 10 nm to 1,000 nm from the surface of the anodic oxide film and a small diameter portion that is in communication with the bottom portion of the large diameter portion and extends to a position at a depth of 20 nm to 2,000 nm from a communicate position, an average diameter of the large diameter portion within the surface of the anodic oxide film is 15 nm to 100 nm, and an average diameter of the small diameter portion at a communicate position is 13 nm or less

(hereinafter, the support according to this aspect will be also called "support (2)").

Fig. 2 is a schematic cross-sectional view of an aluminum support which is an embodiment different from the aluminum support 12a shown in Fig. 1.

In Fig. 2, an aluminum support 12b includes an aluminum plate 18 and an anodic oxide film 20b having micropores 22b each composed of a large diameter portion 24 and a small diameter portion 26.

The micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communicate position to a position at a depth of 20 nm to 2,000 nm.

Hereinafter, the large diameter portion and the small diameter portion will be specifically described.

The average diameter of the large diameter portion within the surface of the anodic oxide film is the same as the average diameter of the micropores that the aforementioned anodic oxide film has within the surface of the anodic oxide film. From the viewpoint of UV printing durability, on-press developability, and contamination suppressiveness, the average diameter of the large diameter portion is preferably 15 nm to 150 nm, and more preferably 30 nm to 100 nm.

The method for measuring the average diameter of the large diameter portion within the surface of the anodic oxide film is the same as the method for measuring the average diameter of the micropores in the anodic oxide film within the surface of the anodic oxide film.

The bottom portion of the large diameter portion is in a position at a depth of 10 nm to 1,000 nm (hereinafter, also called depth D) from the surface of the anodic oxide film. That is, the large diameter portion is a pore portion extending to a position at a depth of 10 nm to 1,000 nm from the surface of the anodic oxide film in the depth direction (thickness direction).

From the viewpoint of UV printing durability, on-press developability, and contamination suppressiveness, the depth of the large diameter portion is preferably 10 nm to 650 nm, more preferably 10 nm to 200 nm, and even more preferably 10 nm to 130 nm.

The depth is a value obtained by taking a photograph (150,000X magnification) of a cross section of the anodic oxide film, measuring the depths of 25 or more large diameter portions , and calculating the average thereof.

The shape of the large diameter portion is not particularly limited. Examples of the shape of the large diameter portion include a substantially straight tubular shape (substantially cylindrical shape) and a conical shape that tapers along the depth direction (thickness direction). Among these, a substantially straight tubular shape is preferable.

As shown in Fig. 2, the small diameter portion is a pore portion that is in communication with the bottom portion of the large diameter portion and further extends from the communicate position in the depth direction (that is, the thickness direction).

The average diameter of the small diameter portion at the communicate position is preferably 15 nm or less. Particularly, the average diameter is preferably 11 nm or less, and more preferably 10 nm or less. The lower limit thereof is not particularly limited, but is 5 nm or more in many cases.

The average diameter of the small diameter portion is obtained by observing the surface of the anodic oxide film 20a with FE-SEM at 150,000X magnification (N = 4), measuring the size (diameter) of the micropores (small diameter portion) existing in a range of 400 nm × 600 nm in the obtained 4 images, and calculating the arithmetic mean thereof. In a case where the large diameter portion is deep, as necessary, the upper portion of the anodic oxide film (region where the large diameter portion is located) may be cut (for example, by using argon gas), then the surface of the anodic oxide film may be observed with FE-SEM described above, and the average diameter of the small diameter portion may be determined.

In a case where the shape of the small diameter portion is not circular, the equivalent circular diameter is used. "Equivalent circular diameter" is a diameter determined on an assumption that the opening portion is in the form of a circle having the same projected area as the projected area of the opening portion.

The bottom portion of the small diameter portion is in a position 20 nm to 2,000 nm distant from the communicate position with the large diameter portion in the depth direction. In other words, the small diameter portion is a pore portion that extends further from the communicate position with the large diameter portion in the depth direction (thickness direction), and the depth of the small diameter portion is 20 nm to 2,000 nm. The depth is preferably 500 nm to 1,500 nm.

The depth is a value determined by taking a photograph (50,000X magnification) of a cross section of the anodic oxide film, measuring the depths of 25 or more small diameter portions, and calculating the average thereof.

The shape of the small diameter portion is not particularly limited. Examples of the shape of the small diameter portion include a substantially straight tubular shape (substantially cylindrical shape) and a conical shape that tapers along the depth direction. Among these, a substantially straight tubular shape is preferable.

-Manufacturing method of aluminum support-

As a manufacturing method of the aluminum support used, for example, a manufacturing method is preferable in which the following steps are sequentially performed.

· Roughening treatment step: step of performing roughening treatment on aluminum plate
· Anodization treatment step: step of subjecting aluminum plate having undergone roughening treatment to anodization
· Pore widening treatment step: step of bringing aluminum plate having anodic oxide film obtained by anodization treatment step into contact with aqueous acid solution or aqueous alkali solution such that diameter of micropores in anodic oxide film increases

Hereinafter, the procedure of each step will be specifically described.

[Roughening treatment step]

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a preferable shape, the roughening treatment step may not be performed.
As the roughening treatment, only an electrochemical roughening treatment may be performed, or an electrochemical roughening treatment and mechanical roughening treatment and/or a chemical roughening treatment may be performed in combination.
**In** a case where the mechanical roughening treatment and the electrochemical roughening treatment are combined, it is preferable to perform the electrochemical roughening treatment after the mechanical roughening treatment.
It is preferable to perform the electrochemical roughening treatment by using direct current or alternating current in an aqueous solution containing nitric acid or hydrochloric acid as a main component.
The method of the mechanical roughening treatment is not particularly limited. Examples thereof include the method described in JP1975-40047B (JP-S50-40047B).
Furthermore, the chemical roughening treatment is not particularly limited, and examples thereof include known methods.
After the mechanical roughening treatment, it is preferable to perform the following chemical etching treatment.
By the chemical etching treatment performed after the mechanical roughening treatment, the edge portion of surface irregularities of the aluminum plate smoothed, such that ink clotting that may occur during printing is prevented, the antifouling properties of the printing plate are improved, and unnecessary substances such as abrasive particles remaining on the surface are removed.
Examples of the chemical etching treatment include etching with an acid and etching with an alkali. One of the examples of particularly efficient etching methods is a chemical etching treatment using an aqueous alkali solution (hereinafter, also called "alkaline etching treatment").
The alkaline agent used in the aqueous alkali solution is not particularly limited. Examples thereof include caustic soda, caustic potash, sodium metasilicate, sodium carbonate, sodium aluminate, and sodium gluconate.
The aqueous alkali solution may contain aluminum ions.
The concentration of the alkaline agent in the aqueous alkali solution is preferably 0.01% by mass or more, and more preferably 3% by mass or more. Furthermore, the concentration of the alkaline agent is preferably 30% by mass or less.
Changing the temperature of the aqueous alkali solution used in the alkaline etching treatment makes it possible to control the etching amount of aluminum of a surface subjected to a roughening treatment and to adjust the specific surface area $\Delta S$.
From the viewpoint described above, the liquid temperature of the aqueous alkali solution is preferably 20°C to 80°C, more preferably 20°C to 70°C, even more preferably 20°C to 55°C, and particularly preferably 25°C to 55°C.
In a case where the alkaline etching treatment is performed, in order to remove products generated by the alkaline etching treatment, it is preferable to perform the chemical etching treatment by using a low-temperature aqueous acidic solution (hereinafter, also called "desmutting treatment").
The acid used in the aqueous acidic solution in the desmutting treatment is not particularly limited, and examples thereof include sulfuric acid, nitric acid, and hydrochloric acid. From the viewpoint of UV printing durability and residual color suppressiveness, the temperature of the aqueous acidic solution is preferably 20°C to 80°C, more preferably 25°C to 40°C, and even more preferably 30°C to 40°C.
As the roughening treatment step, a method is preferable in which the treatments described in an aspect A or an aspect B are performed in the following order.

~Aspect A~

(2) Chemical etching treatment using aqueous alkali solution (first alkaline etching treatment)
(3) Chemical etching treatment using aqueous acidic solution (first desmutting treatment)
(4) Electrochemical roughening treatment using aqueous solution containing nitric acid as main component (first electrochemical roughening treatment)
(5) Chemical etching treatment using aqueous alkali solution (second alkaline etching treatment)
(6) Chemical etching treatment using aqueous acidic solution (second desmutting treatment)
(7) Electrochemical roughening treatment in aqueous solution containing hydrochloric acid as main component (second electrochemical roughening treatment)
(8) Chemical etching treatment using aqueous alkali solution (third alkaline etching treatment)
(9) Chemical etching treatment using aqueous acidic solution (third desmutting treatment)

~Aspect B~

(10) Chemical etching treatment using aqueous alkali solution (fourth alkaline etching treatment)
(11) Chemical etching treatment using aqueous acidic solution (fourth desmutting treatment)
(12) Electrochemical roughening treatment using aqueous solution containing hydrochloric acid as main component (third electrochemical roughening treatment)
(13) Chemical etching treatment using aqueous alkali solution (fifth alkaline etching treatment)
(14) Chemical etching treatment using aqueous acidic solution (fifth desmutting treatment)

As necessary, (1) mechanical roughening treatment may be performed before the treatment (2) of the aspect A or before the treatment (10) of the aspect B.

The amount of the aluminum plate dissolved by the first alkaline etching treatment and the fourth alkaline etching treatment is preferably 0.5 $g/m^2$ to 30 $g/m^2$, and more preferably 1.0 $g/m^2$ to 20 $g/m^2$.

Examples of the aqueous solution containing nitric acid as a main component used in the first electrochemical roughening treatment of the aspect A include aqueous solutions used in the electrochemical roughening treatment using direct current or alternating current. Examples thereof include an aqueous solution obtained by adding aluminum nitrate, sodium nitrate, ammonium nitrate, or the like to a 1 g/L to 100 g/L aqueous nitric acid solution.

Examples of the aqueous solution containing hydrochloric acid as a main component used in the second electrochemical roughening treatment of the aspect A and in the third electrochemical roughening treatment of the aspect B include aqueous solutions used in the general electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, and ammonium nitrate; hydrochloric acid ions such as aluminum chloride, sodium chloride, and ammonium chloride may be further added to this solution.

As the waveform of an alternating current power source for the electrochemical roughening treatment, a sine wave, a square wave, a trapezoidal wave, a triangular wave, and the like can be used. The frequency is preferably 0.1 Hz to 250 Hz.

Fig. 3 is an example of a waveform graph of alternating current used for an electrochemical roughening treatment.

In Fig. 3, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents current for an anodic reaction of an aluminum plate, and CA represents current for a cathodic reaction of an aluminum plate. For a trapezoidal wave, the time tp taken for current to reach a peak from 0 is preferably 1 ms to 10 ms. Regarding the conditions of one cycle of alternating current used for the electrochemical roughening, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 ms to 1,000 ms. The peak current density of the trapezoidal wave is preferably 10 $A/dm^2$ to 200 $A/dm^2$ at both the anodic cycle side Ia and the cathodic cycle side Ic of the current. Ic/Ia is preferably 0.3 to 20. At a point in time when the electrochemical roughening has ended, the total quantity of electricity that participates in the anodic reaction of the aluminum plate is preferably 25 $C/dm^2$ to 1,000 $C/dm^2$.

The electrochemical roughening using alternating current can be performed using the device shown in Fig. 4.
Fig. 4 is a lateral view showing an example of a radial cell in an electrochemical roughening treatment using alternating current.
In Fig. 4, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In Fig. 4, the arrow S represents a supply direction of an electrolytic solution, and the arrow Ex represents a discharge direction of the electrolytic solution. In a case where two or more electrolytic cells are used, the electrolysis conditions may be the same as or different from each other.
The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is supplied to flow in the space between the auxiliary anode 58 and the aluminum plate W.
In view of easily manufacturing a predetermined printing plate precursor, the amount of the aluminum plate dissolved by the second alkaline etching treatment is preferably 1.0 g/m$^2$ or more, and more preferably 2.0 g/m$^2$ to 10 g/m$^2$.
In view of easily manufacturing a predetermined printing plate precursor, the amount of the aluminum plate dissolved by the third alkaline etching treatment and the fourth alkaline etching treatment is preferably 0.01 g/m$^2$ to 0.8 g/m$^2$, and more preferably 0.05 g/m$^2$ to 0.3 g/m$^2$.
In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.
The concentration of the acid in the aqueous acidic solution is preferably 0.5% by mass to 60% by mass.

[Anodization treatment step]

The procedure of the anodization treatment step is not particularly limited as long as the aforementioned micropores can be obtained. Examples thereof include known methods.
In the anodization treatment step, an aqueous solution of sulfuric acid, phosphoric acid, oxalic acid, or the like can be used as an electrolytic cell. For example, the concentration of sulfuric acid is 100 g/L to 300 g/L.
The conditions of the anodization treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 5 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

[Pore widening treatment]

The pore widening treatment is a treatment of enlarging the diameter of micropores (also called "pore diameter") present in the anodic oxide film formed by the aforementioned anodization treatment step (also called "pore diameter enlarging treatment").
The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method.
As necessary, the aluminum support may have a backcoat layer on the side opposite to the image-recording layer, the backcoat layer containing the organic polymer compound described in JP1993-45885A (JP-H5-45885A) or the alkoxy compound of silicon described in JP1994-35174A (JP-H6-35174A).

<Image-recording layer>

The lithographic printing plate precursor according to the present invention includes an aluminum support, an image-recording layer, and an outermost layer in this order, and the image-recording layer contains an infrared absorber, a polymerization initiator, and a polymerizable compound.
The image-recording layer used in the present invention is preferably a negative tone image-recording layer and more preferably a water-soluble or water-dispersible negative tone image-recording layer.
In the lithographic printing plate precursor according to the present invention, from the viewpoint of on-press developability, a non-exposed portion of the image-recording layer is preferably removable by at least any of dampening

water or printing ink.

Hereinafter, each of the components to be incorporated into the image-recording layer will be specifically described.

[Infrared absorber]

The image-recording layer in the present invention contains an infrared absorber.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are preferable, and a cyanine dye or an indolenine cyanine dye is more preferable. Among these, a cyanine dye is particularly preferable.

The aforementioned infrared absorber is preferably a cationic polymethine colorant having an oxygen atom, a nitrogen atom, or a halogen atom at the meso-position. Preferred examples of the cationic polymethine colorant include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used. As pigments, the compounds described in paragraphs "0072" and" 0076" of JP2008-195018A are preferable.

**In** addition, as the aforementioned infrared absorber, a decomposable compound that decomposes due to exposure to infrared, which will be described later as a discoloring compound of the outermost layer, is also suitably used.

From the viewpoint of printing durability and visibility, the highest occupied molecular orbital (HOMO) of the infrared absorber is preferably -5.250 eV or less, more preferably -5.30 eV or less, even more preferably -5.80 eV or more and -5.35 eV or less, and particularly preferably -5.65 eV or more and -5.40 eV or less.

From the viewpoint of temporal stability, sensitivity improvement, and UV printing durability, the lowest unoccupied molecular orbital (LUMO) of the infrared absorber is preferably less than -3.70 eV, more preferably less than -3.80 eV, even more preferably -4.20 eV or more and less than -3.80 eV, and particularly preferably -4.00 eV or more and less than -3.80 eV.

One kind of infrared absorber may be used alone, or two or more kinds of infrared absorbers may be used in combination.

**In** addition, as the infrared absorber, a pigment and a dye may be used in combination.

The content of the infrared absorber with respect to the total mass of the image-recording layer is preferably 0.1% by mass to 10.0% by mass, and more preferably 0.5% by mass to 5.0% by mass.

[Polymerization initiator]

The image-recording layer in the present invention contains a polymerization initiator.

The polymerization initiator preferably includes an electron-donating polymerization initiator, and more preferably includes an electron-accepting polymerization initiator and an electron-donating polymerization initiator.

<<Electron-accepting polymerization initiator>>

It is preferable that the image-recording layer in the present invention contain an electron-accepting polymerization initiator as a polymerization initiator.

The electron-accepting polymerization initiator is a compound which accepts an electron by intermolecular electron migration in a case where electrons of an infrared absorber are excited by exposure to infrared, and generates a polymerization initiation species such as radicals.

The electron-accepting polymerization initiator is a compound that generates a polymerization initiation species

such as a radical or a cation by either or both of light energy and heat energy, and can be appropriately selected from known thermal polymerization initiators, compounds having a bond that requires low bond dissociation energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

Among the above electron-accepting polymerization initiators, from the viewpoint of curing properties, an oxime ester compound and an onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below, but is not limited thereto.

As the iodonium salt compound, for example, a diaryliodonium salt compound is preferable. Particularly, a diphenyl iodonium salt compound substituted with an electron-donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium= 1-perfluorobutane sulfonate, 4-octyloxyphenyl-2,4,6-trimethoxyphenyliodonium=hexafluorophosphate, and bis(4-t-butylphenyl)iodonium=hexafluorophosphate.

Examples of counteranions of the iodonium salt compound and the sulfonium salt compound include a sulfonate anion, a carboxylate anion, a tetrafluoroborate anion, a hexafluorophosphate anion, a p-toluene sulfonate anion, a tosylate anion, a sulfonamide anion, and a sulfonimide anion.

Among the above, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion and the sulfonimide anion include those described in WO2019/013268A.

From the viewpoint of temporal visibility after exposure, developability, and UV printing durability of the lithographic printing plate to be obtained, the aforementioned electron-accepting polymerization initiator preferably includes a compound represented by Formula (II) or Formula (III), and particularly preferably includes a compound represented by Formula (II).

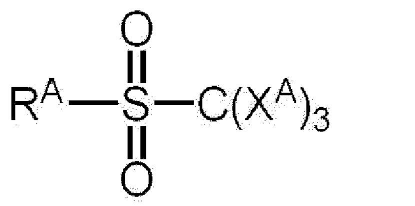

( II )

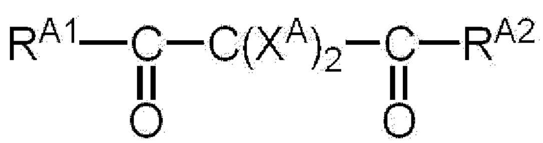

( III )

In Formula (II) and Formula (III), $X^A$ represents a halogen atom, and $R^A$, $R^{A1}$, and $R^{A2}$ each independently represent a monovalent hydrocarbon group having 1 to 20 carbon atoms.

$R^A$ in Formula (II) is preferably an aryl group.

Examples of $X^A$ in Formula (II) and Formula (III) include a fluorine atom, a chlorine atom, a bromine atom, and an iodine atom. Among these, a chlorine atom or a bromine atom is preferable because these have excellent sensitivity, and a bromine atom is particularly preferable.

$R^A$, $R^{A1}$, and $R^{A2}$ in Formula (II) and Formula (III) preferably each independently represent an aryl group. Particularly, from the viewpoint of excellent balance between sensitivity and storage stability, $R^A$, $R^{A1}$, and $R^{A2}$ more preferably each independently represent an aryl group substituted with an amide group.

The aforementioned electron-accepting polymerization initiator particularly preferably includes a compound represented by Formula (IV).

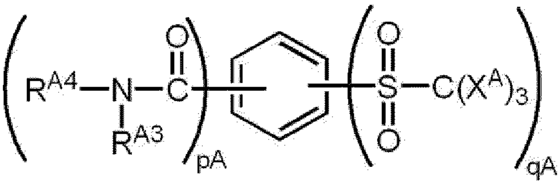 ( IV )

In Formula (IV), $X^A$ represents a halogen atom, $R^{A3}$ and $R^{A4}$ each independently represent a hydrogen atom or a monovalent hydrocarbon group having 1 to 20 carbon atoms, and pA and qA each independently represent an integer of 1 to 5. Here, pA + qA = 2 to 6.

Specific examples of the electron-accepting polymerization initiator include compounds represented by the following formulas. However, it is not limited thereto.

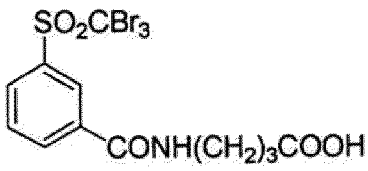
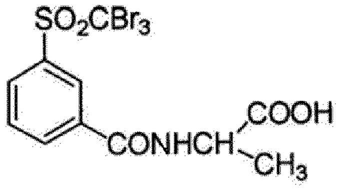
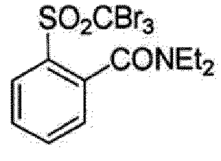

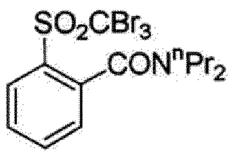
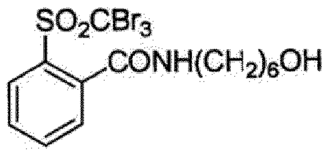
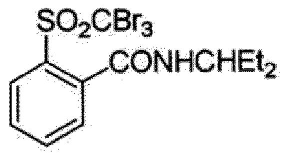

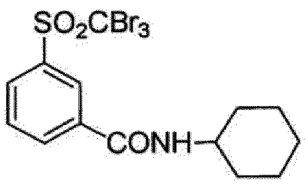
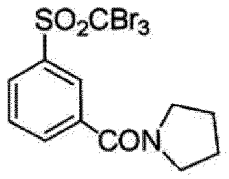
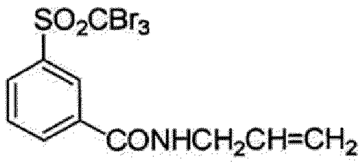

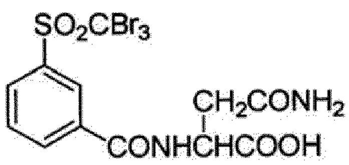
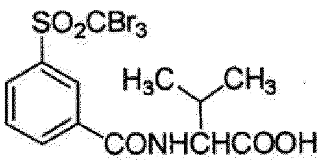
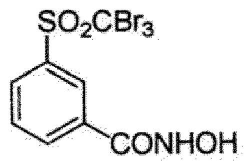

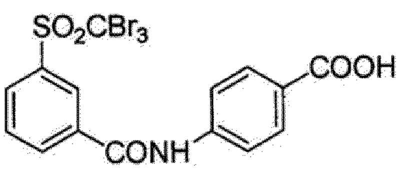
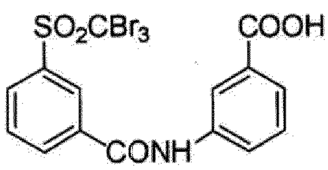
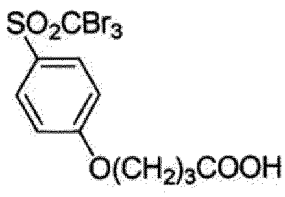

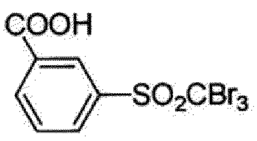
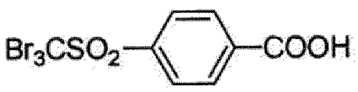
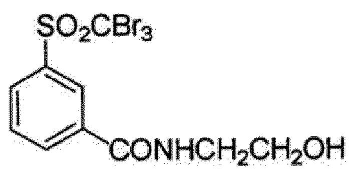

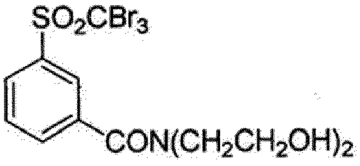 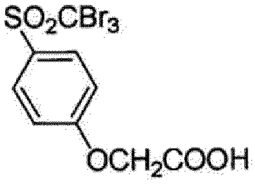 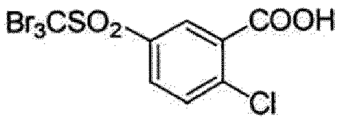

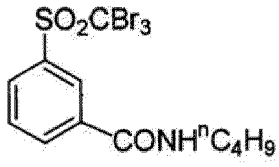 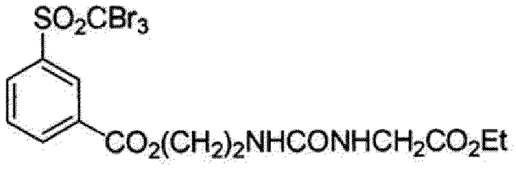

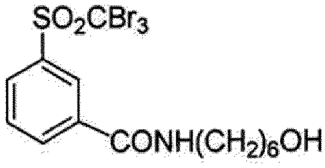 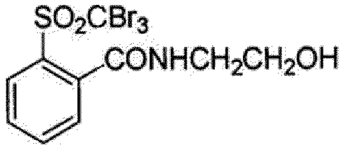

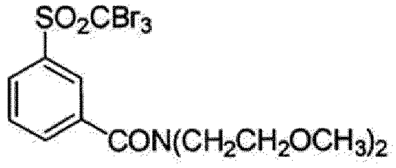 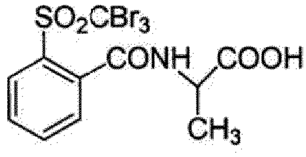

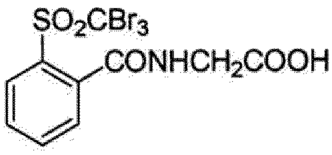 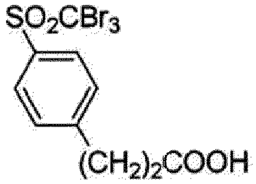 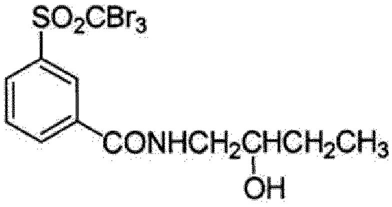

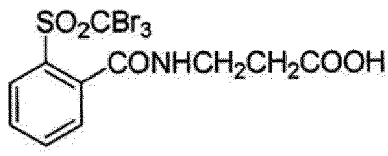 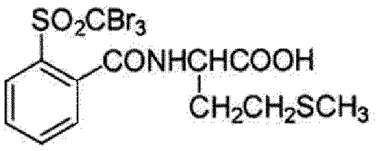

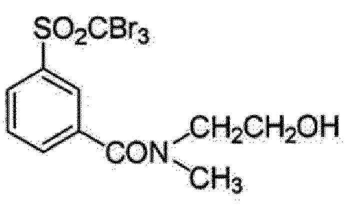 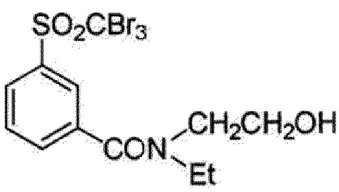 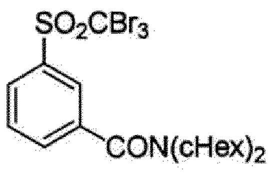

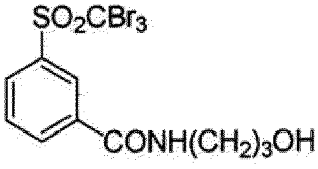 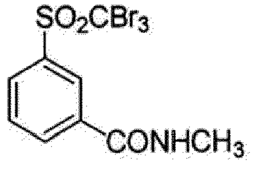 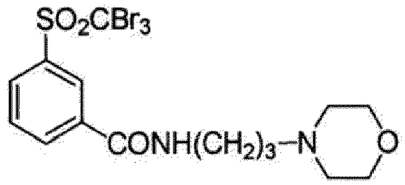

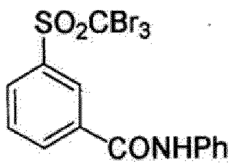
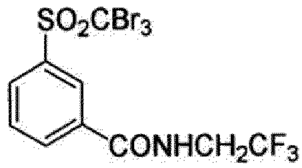
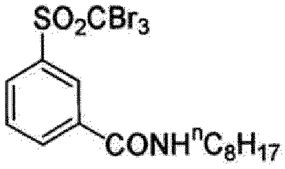

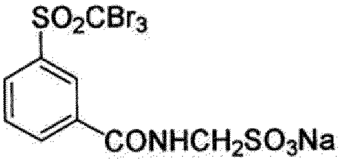
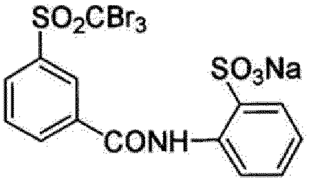
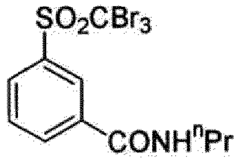

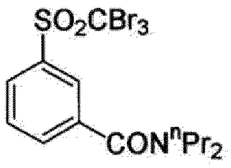
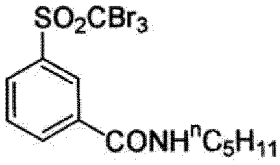
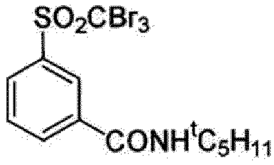

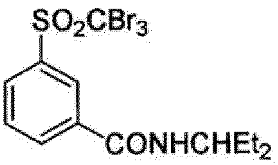
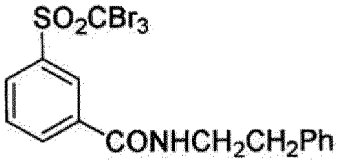
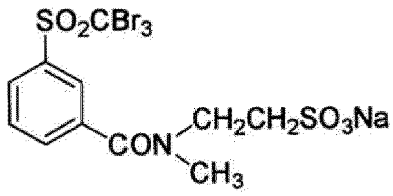

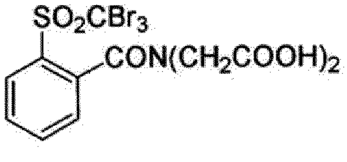
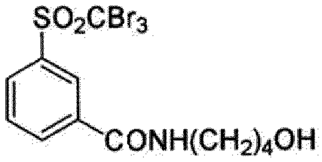

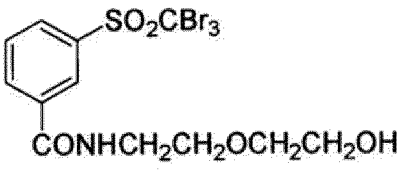
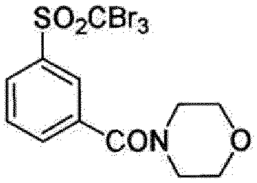
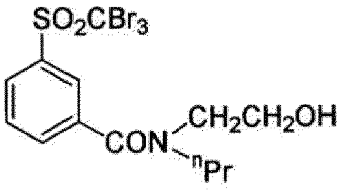

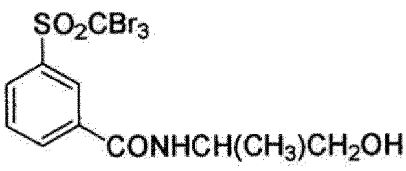
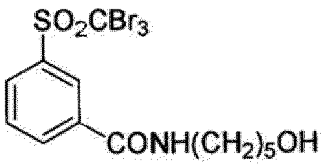

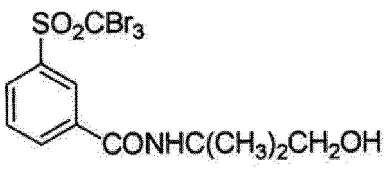
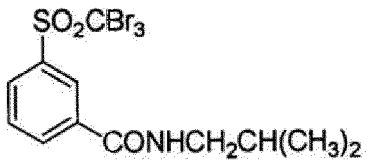

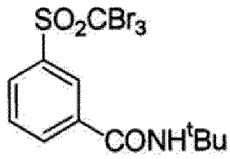
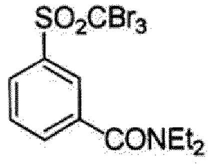
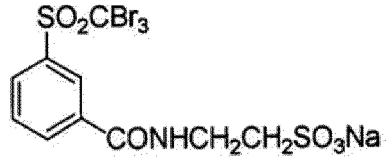

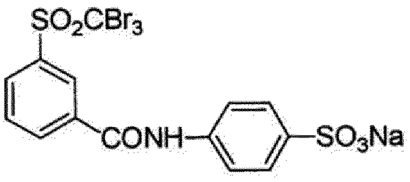
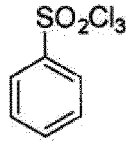
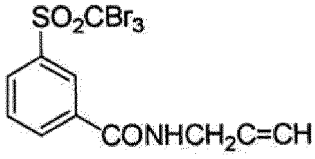

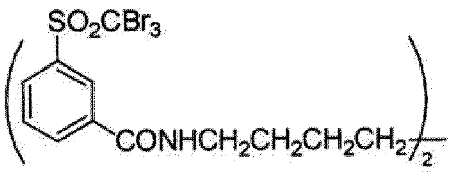
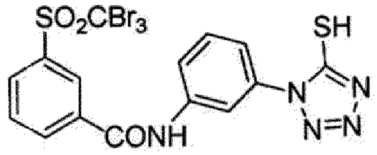

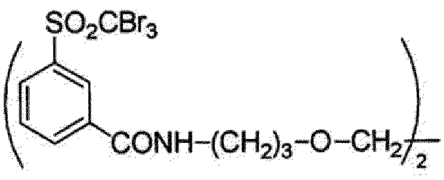
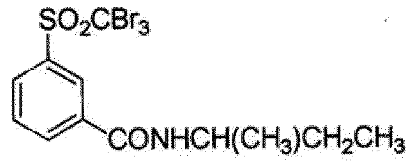

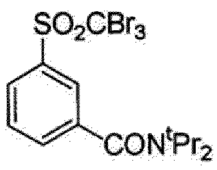
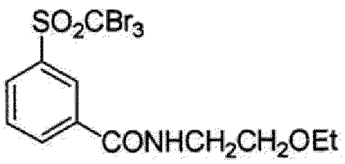
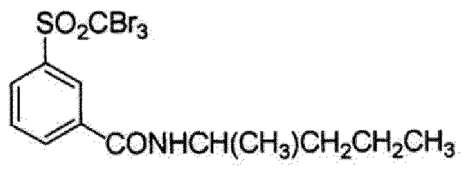

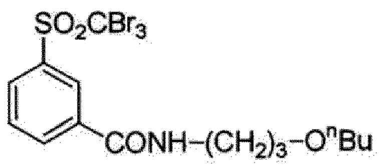
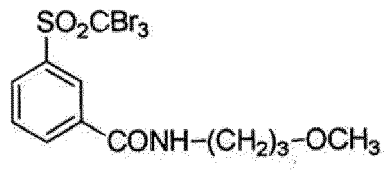

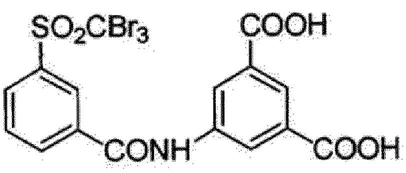
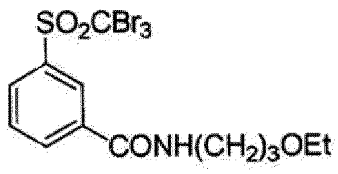

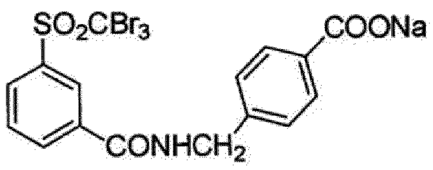
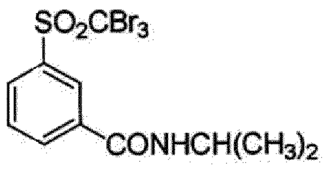

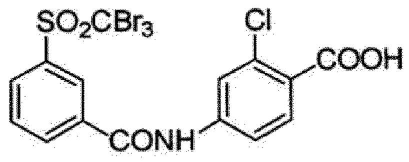

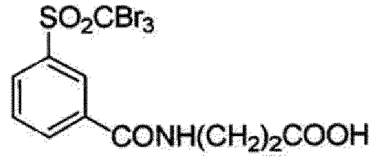

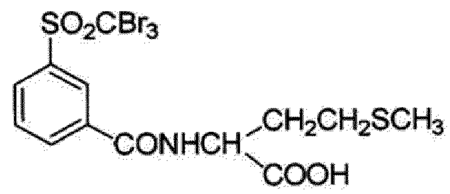

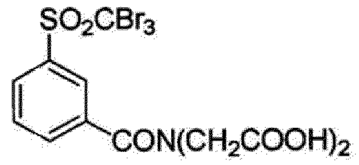

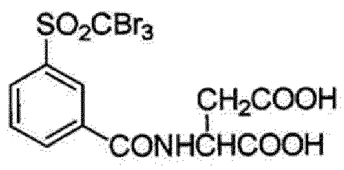

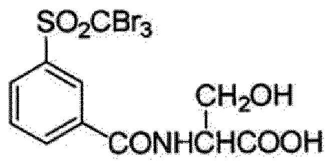

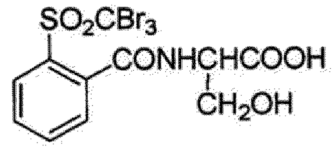

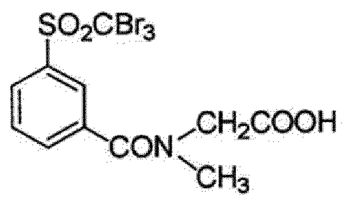

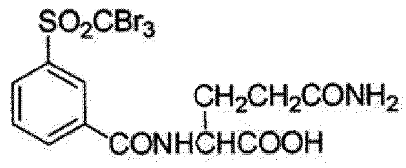

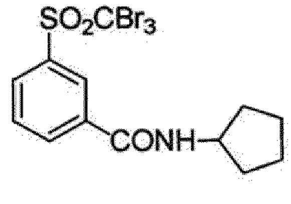

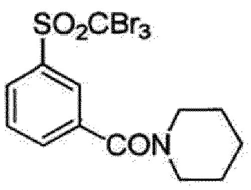

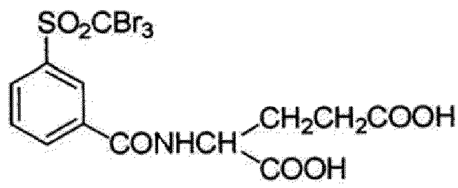

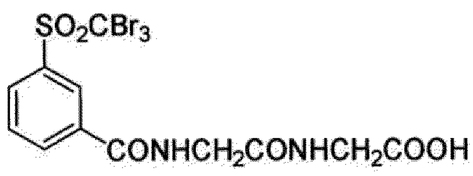

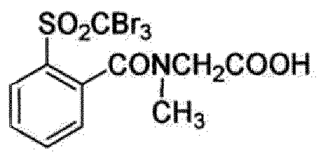

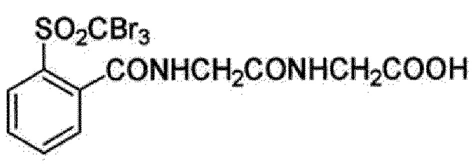

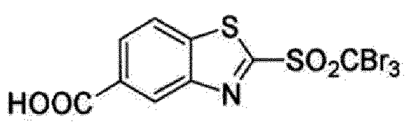

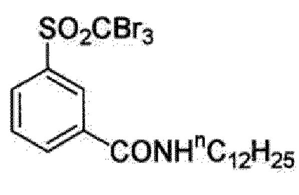

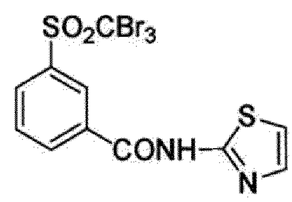

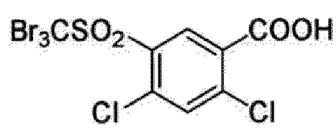

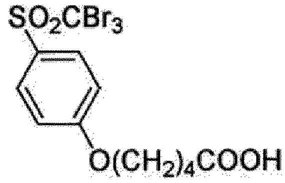 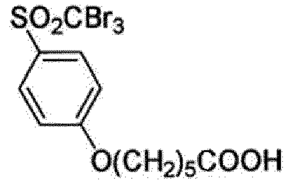

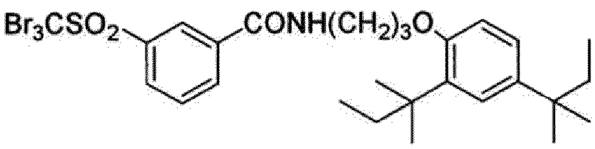 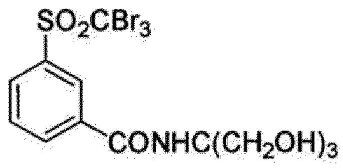

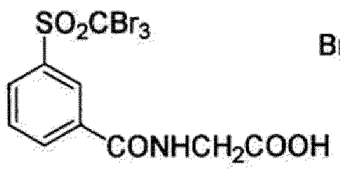 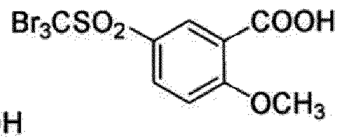 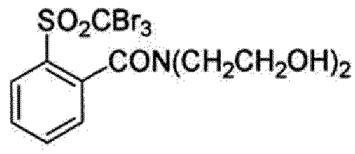

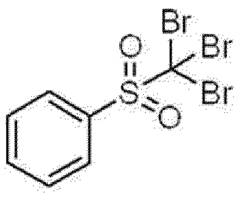

(IS-1)

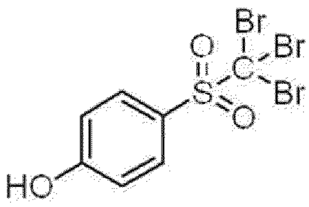

(IS-2)

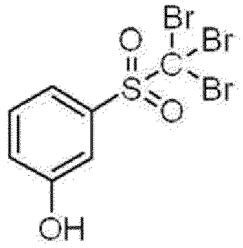

(IS-3)

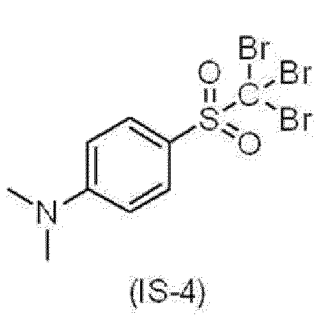

(IS-4)

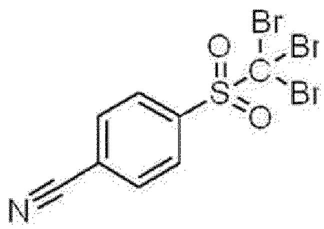

(IS-5)

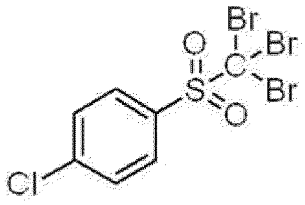

(IS-6)

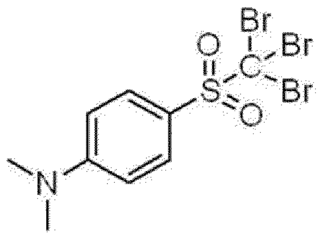

(IS-7)

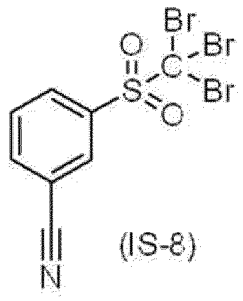

(IS-8)

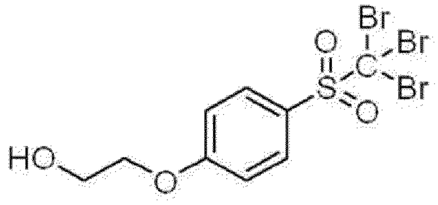

(IS-9)

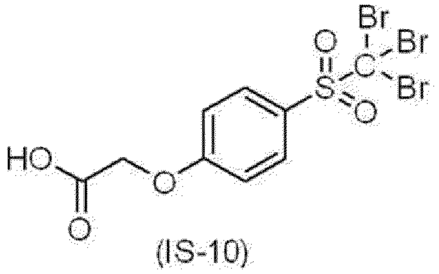

(IS-10)

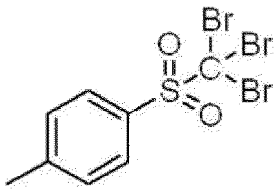

(IS-11)

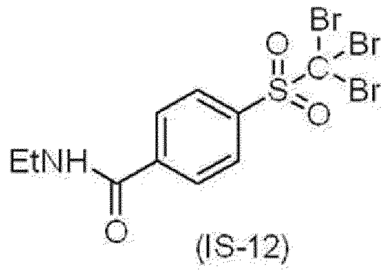

(IS-12)

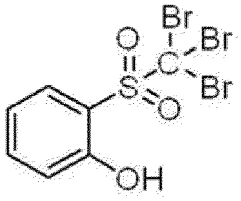

(IS-13)

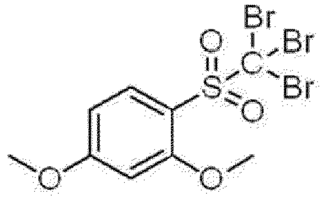

(IS-14)

From the viewpoint of temporal stability, UV plate missing suppressiveness, GLV suitability, and UV printing durability, the lowest unoccupied molecular orbital (LUMO) of the electron-accepting polymerization initiator is preferably more than -3.3 eV, and more preferably more than -3.2 eV.

From the viewpoint of sensitivity improvement and making it difficult for plate missing to occur, the upper limit of LUMO is preferably -3.00 eV or less, and more preferably -3.02 eV or less.

One kind of electron-accepting polymerization initiator may be used alone, or two or more kinds of electron-accepting polymerization initiators may be used in combination.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

<<Electron-donating polymerization initiator (polymerization aid)>>

It is preferable that the image-recording layer contain an electron-donating polymerization initiator (also called "polymerization aid") as a polymerization initiator.

The electron-donating polymerization initiator is a compound which donates one electron by intermolecular electron migration to an orbit of an infrared absorber that has lost one electron in a case where electrons of the infrared absorber are excited or perform intramolecular migration by exposure to infrared, and thus generates polymerization initiation species such as radicals.

The electron-donating polymerization initiator is preferably an electron-donating radical polymerization initiator.

From the viewpoint of printing durability, the image-recording layer preferably contains a borate compound.

From the viewpoint of printing durability and visibility, the borate compound is preferably a tetraaryl borate compound or a monoalkyl triaryl borate compound, and more preferably a tetraaryl borate compound.

A countercation that the borate compound has is not particularly limited, but is preferably an alkali metal ion or a tetraalkyl ammonium ion and more preferably a sodium ion, a potassium ion, or a tetrabutylammonium ion.

The countercation that the borate compound has may also be a cationic polymethine colorant in the infrared absorber described in the present specification. For example, the aforementioned borate compound may be used as the countercation of the cyanine dye.

Specifically, preferred examples of the borate compound include sodium tetraphenyl borate.

Specifically, as the electron-donating polymerization initiator, for example, the following B-1 to B-9 are preferable. It goes without saying that it is not limited thereto. In the following chemical formulas, Ph represents a phenyl group, and Bu represents a n-butyl group.

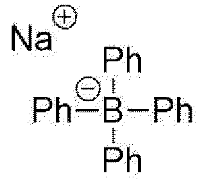
B - 1

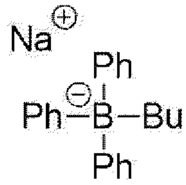
B - 2

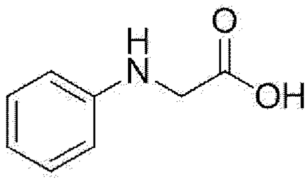
B - 3

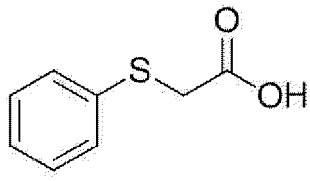
B - 4

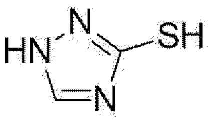
B - 5

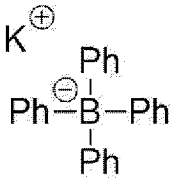
B - 6

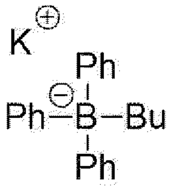
B - 7

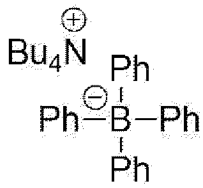
B - 8

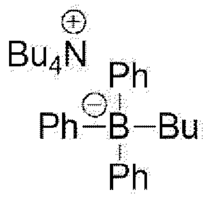
B - 9

From the viewpoint of sensitivity improvement and making it difficult for plate missing to occur, the highest occupied molecular orbital (HOMO) of the electron-donating polymerization initiator is preferably -6.00 eV or more, more preferably -5.95 eV or more, even more preferably -5.93 eV or more, and particularly preferably more than -5.90 eV.

The upper limit of HOMO is preferably -5.00 eV or less, and more preferably -5.40 eV or less.

Only one kind of electron-donating polymerization initiator may be used alone, or more kinds of electron-donating polymerization initiators may be used in combination.

From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

The polymerization initiator may be a compound in the form of a conjugate salt of an electron-donating polymerization initiator and an electron-accepting polymerization initiator, and preferably includes, as the electron-accepting polymerization initiator and the electron-donating polymerization initiator, a compound in the form of a salt composed of a cation having the structure of an electron-accepting polymerization initiator and an anion having the structure of an electron-donating polymerization initiator. Examples of the cation having the structure of an electron-accepting polymerization initiator include oniums in the onium compound described above. Examples of the cation having the structure of an electron-donating polymerization initiator include borate in the borate compound described above.

For example, the polymerization initiator is preferably a compound in the form of a conjugate salt of an anion in the electron-donating polymerization initiator and a cation in the electron-accepting polymerization initiator, more preferably a compound in the form of a conjugate salt of an onium cation and a borate anion, even more preferably a compound in the form of a conjugate salt of an iodonium cation or sulfonium cation and a borate anion, and particularly preferably a compound in the form of a conjugate salt of a diaryliodonium cation or a triarylsulfonium cation and a tetraarylborate anion.

Preferred aspects of the anion in the electron-donating polymerization initiator and the cation in the electron-accepting polymerization initiator are the same as the preferred aspects of the anion in the aforementioned electron-donating polymerization initiator and the cation in the aforementioned electron-accepting polymerization initiator.

In a case where the image-recording layer contains an anion as an electron-donating polymerization initiator and a cation as an electron-accepting polymerization initiator (that is, in a case where the image-recording layer contains a compound in the form of a conjugate salt described above), the image-recording layer is regarded as containing an electron-accepting polymerization initiator and an electron-donating polymerization initiator.

The compound in the form of a conjugate salt of an electron-donating polymerization initiator and an electron-accepting polymerization initiator may be used as an electron-donating polymerization initiator or an electron-accepting polymerization initiator.

The compound in the form of a conjugate salt of an electron-donating polymerization initiator and an electron-accepting polymerization initiator may be used in combination with the aforementioned electron-donating polymerization initiator or used in combination with the aforementioned electron-accepting polymerization initiator.

[Relationship between infrared absorber and electron-donating polymerization initiator]

In the image-recording layer, from the viewpoint of UV plate missing suppressiveness and printing durability,

HOMO of the infrared absorber - HOMO of the electron-donating polymerization initiator is preferably 0.70 eV or less, more preferably 0.60 eV or less, even more preferably 0.55 eV or less, particularly preferably 0.50 eV or less, and most preferably 0.50 eV to -0.10 eV.

"HOMO of the infrared absorber - HOMO of the electron-donating polymerization initiator" means a value (obtained by subtracting the value of HOMO of the electron-donating polymerization initiator from the value of HOMO of the infrared absorber.

The negative sign means that HOMO of the electron-donating polymerization initiator is higher than HOMO of the infrared absorber.

[Relationship between electron-accepting polymerization initiator and infrared absorber]

In the image-recording layer, from the viewpoint of sensitivity improvement and printing durability, LUMO of the electron-accepting polymerization initiator - LUMO of the infrared absorber is preferably 1.00 eV or less, more preferably 0.80 eV or less, even more preferably 0.70 eV or less, particularly preferably 0.70 eV to -0.10 eV, and most preferably 0.70 eV to 0.30 eV.

"LUMO of the electron-accepting polymerization initiator - LUMO of the infrared absorber" means a value obtained by subtracting the value of LUMO of the infrared absorber from the value of LUMO of the electron-accepting polymerization initiator.

The negative sign means that LUMO of the infrared absorber is higher than LUMO of the electron-accepting polymerization initiator.

The energy of molecular orbital (MO) such as highest occupied molecular orbital (HOMO) and the lowest unoccupied molecular orbital (LUMO) is calculated by the following methods.

First, free counterions in the compound as a calculation object are excluded from the calculation object. For example, for a cationic electron-accepting polymerization initiator and a cationic infrared absorber, counteranions are excluded from the calculation object, and for an anionic electron-donating polymerization initiator, countercations are excluded from the calculation object. "Free" mentioned herein means that the compound as an object and the counterions thereof are not covalently linked to each other.

The structural optimization is carried out by DFT (B3LYP/6-31G(d)) using quantum chemical calculation software Gaussian 09 (manufactured by Gaussian).

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO.

$$\text{Escaled} = 0.823168 \times 27.2114 \times \text{Ebare} - 1.07634$$

27.2114 is simply a coefficient for converting hartree into eV, and 0.823168 and -1.07634 are adjustment coefficients. These are determined such that the calculated values of HOMO and LUMO of the compound as a calculation object match the measured values.

[Polymerizable compound]

The image-recording layer in the present invention contains a polymerizable compound.

In the present invention, a polymerizable compound refers to a compound having a polymerizable group.

The polymerizable group is not particularly limited and may be a known polymerizable group. As the polymerizable group, an ethylenically unsaturated group is preferable. The polymerizable group may be a radically polymerizable group or a cationically polymerizable group. The polymerizable group is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound used in the present invention may be, for example, a radically polymerizable compound or a cationically polymerizable compound. As the polymerizable compound, an addition polymerizable compound having at least one ethylenically unsaturated bond (ethylenically unsaturated compound) is preferable.

The ethylenically unsaturated compound is preferably a compound having at least one ethylenically unsaturated bond on a terminal, and more preferably a compound having two or more ethylenically unsaturated bonds on a terminal. The chemical form of the polymerizable compound is, for example, a monomer, a prepolymer which is in other words a dimer, a trimer, or an oligomer, a mixture of these, or the like.

Particularly, from the viewpoint of UV printing durability, the aforementioned polymerizable compound preferably includes a polymerizable compound having functionalities of 3 or more, more preferably includes a polymerizable compound having functionalities of 7 or more, and even more preferably includes a polymerizable compound having functionalities of 10 or more. From the viewpoint of UV printing durability of the lithographic printing plate to be obtained, the aforementioned polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

From the viewpoint of on-press developability and contamination suppressiveness, the aforementioned polymerizable compound preferably includes a polymerizable compound having functionalities of 2 or less, more preferably includes a difunctional polymerizable compound, and particularly preferably includes a difunctional (meth)acrylate compound.

From the viewpoint of printing durability, on-press developability, and contamination suppressiveness, the content of the polymerizable compound having functionalities of 2 or less (preferably a difunctional polymerizable compound) with respect to the total mass of polymerizable compounds in the image-recording layer is preferably 5% by mass to 100% by mass, more preferably 10% by mass to 100% by mass, and even more preferably 15% by mass to 100% by mass.

<<Oligomer>>

As the polymerizable compound to be incorporated into the image-recording layer, a polymerizable compound which is an oligomer (hereinafter, also simply called "oligomer") is preferable.

Herein, an oligomer represents a polymerizable compound which has a molecular weight (weight-average molecular weight in a case where the compound has molecular weight distribution) of 600 or more and 10,000 or less and at least one polymerizable group.

From the viewpoint of excellent chemical resistance and excellent UV printing durability, the molecular weight of the oligomer is preferably 1,000 or more and 5,000 or less.

Furthermore, from the viewpoint of improving UV printing durability, the number of polymerizable groups in one molecule of the oligomer is preferably 2 or more, more preferably 3 or more, even more preferably 6 or more, and particularly preferably 10 or more.

The upper limit of the number of polymerizable groups in the oligomer is not particularly limited. The number of polymerizable groups is preferably 20 or less.

From the viewpoint of UV printing durability and on-press developability, an oligomer having 7 or more polymerizable groups and a molecular weight of 1,000 or more and 10,000 or less is preferable, and an oligomer having 7 or more and 20 or less polymerizable groups and a molecular weight of 1,000 or more and 5,000 or less is more preferable.

The oligomer may contain a polymer component which is likely to be generated in the process of manufacturing the oligomer.

From the viewpoint of UV printing durability, visibility, and on-press developability, the oligomer preferably has at least one kind of compound selected from the group consisting of a compound having a urethane bond, a compound having an ester bond, and a compound having an epoxy residue, and more preferably has a compound having a urethane bond.

Herein, an epoxy residue refers to a structure formed of an epoxy group. For example, the epoxy residue means a structure similar to a structure established by the reaction between an acid group (carboxylic acid group or the like) and an epoxy group.

As the compound having a urethane bond, which is an example of the oligomer, for example, a compound having at least a group represented by Formula (Ac-1) or Formula (Ac-2) is preferable, and a compound having at least a group represented by Formula (Ac-1) is more preferable.

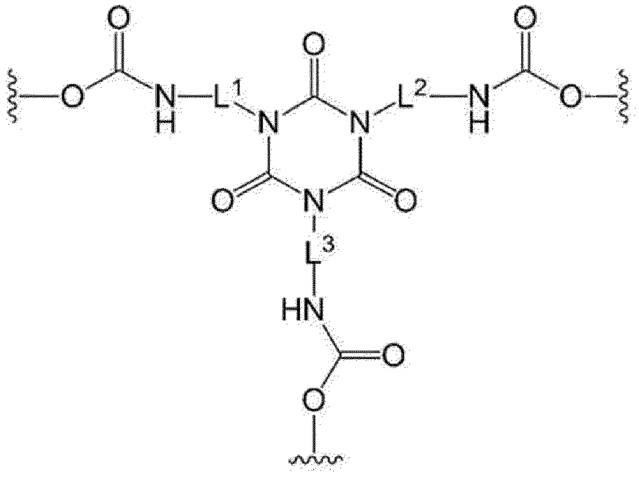

( Ac - 1 )

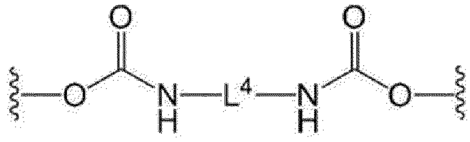

( Ac - 2 )

In Formula (Ac-1) and Formula (Ac-2), $L^1$ to $L^4$ each independently represent a divalent hydrocarbon group having 2 to 20 carbon atoms, and the portion of the wavy line represents a bonding position with other structures.

$L^1$ to $L^4$ preferably each independently represent an alkylene group having 2 to 20 carbon atoms, more preferably each independently represent an alkylene group having 2 to 10 carbon atoms, and even more preferably each independently represent an alkylene group having 4 to 8 carbon atoms. The alkylene group may have a branched structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

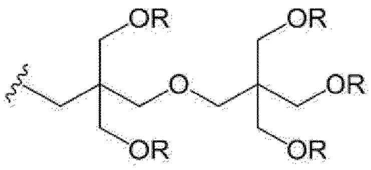

( Ae - 1 )

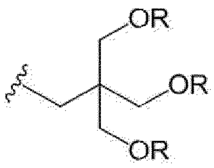

( Ae - 2 )

**In** Formula (Ae-1) and Formula (Ae-2), R each independently represent an acryloyloxy group or a methacryloyloxy group, and the portion of the wavy line represents a position binding to the portion of the wavy line in Formula (Ac-1) and Formula (Ac-2).

As the compound having a urethane bond, a compound may also be used which is prepared by obtaining polyurethane by a reaction between a polyisocyanate compound and a polyol compound and introducing a polymerizable group into the polyurethane by a polymer reaction.

For example, the compound having a urethane bond may be obtained by reacting a polyol compound having an acid group with a polyisocyanate compound to obtain a polyurethane oligomer and reacting this polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

Specific examples of oligomers will be shown below, but the oligomer is not limited thereto.

As the oligomer, commercially available products may also be used. Examples thereof include UA-510H, UA-306H, UA-306I, and UA-306T (manufactured by KYOEISHA CHEMICAL Co., LTD.), UV-1700B, UV-6300B, and UV7620EA (manufactured by NIHON GOSEI KAKO Co., Ltd.), U-15HA (manufactured by SHIN-NAKAMURA CHEMICAL Co., LTD.), EBECRYL450, EBECRYL657, EBECRYL885, EBECRYL800, EBECRYL3416, and EBECRYL860

(manufactured by DAICEL-ALLNEX LTD.), and the like. However, the oligomer is not limited to these.

From the viewpoint of improving chemical resistance and UV printing durability and further suppressing the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

<<Low-molecular-weight polymerizable compound>>

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least a polymerizable compound selected from the group consisting of a polymerizable compound having three or more ethylenically unsaturated groups and a polymerizable compound having an isocyanuric ring structure.

Herein, a low-molecular-weight polymerizable compound refers to a polymerizable compound having a molecular weight (weight-average molecular weight in a case where the compound has molecular weight distribution) of 50 or more and less than 600.

From the viewpoint of excellent chemical resistance, excellent UV printing durability, and excellently suppressing the residues of on-press development, the molecular weight of the low-molecular-weight polymerizable compound is preferably 100 or more and less than 600, more preferably 300 or more and less than 600, and even more preferably 400 or more and less than 600.

In a case where the polymerizable compound includes a low-molecular-weight polymerizable compound as the polymerizable compound other than an oligomer (total amount in a case where the polymerizable compound includes two or more kinds of low-molecular-weight polymerizable compounds), from the viewpoint of chemical resistance, UV printing durability, and suppressing the residues of on-press development, the ratio of the oligomer to the low-molecular-weight polymerizable compound (oligomer/low-molecular-weight polymerizable compound) is preferably 10/1 to 1/10, more preferably 10/1 to 3/7, and even more preferably 10/1 to 7/3, based on mass.

As the low-molecular-weight polymerizable compound, the polymerizable compounds described in paragraphs "0082" to "0086" of WO2019/013268A can also be suitably used.

The details of how to use the polymerizable compound, such as the structure of the compound, whether the compound is used alone or used in combination with other compounds, and the amount of the compound to be added, can be randomly set.

Particularly, from the viewpoint of UV printing durability, the image-recording layer preferably contains two or more kinds of polymerizable compounds.

The content of the polymerizable compound (total content of polymerizable compounds in a case where the image-recording layer contains two or more kinds of polymerizable compounds) with respect to the total mass of the image-recording layer is preferably 5% by mass to 75% by mass, more preferably 10% by mass to 70% by mass, and even more preferably 15% by mass to 60% by mass.

[Particles]

From the viewpoint of developability and UV printing durability, it is preferable that the image-recording layer contain particles. The particles may be inorganic particles or organic particles.

Particularly, the image-recording layer preferably contains organic particles as particles, and more preferably contains resin particles as particles.

Known inorganic particles can be used as inorganic particles, and metal oxide particles such as silica particles and titania particles can be suitably used.

<<Resin particles>>

Examples of the resin particles include particles containing an addition polymerization-type resin (that is, addition polymerization-type resin particles), particles containing a polyaddition-type resin (that is, polyaddition-type resin particles), particles containing a polycondensation-type resin (that is, polycondensation-type resin particles), and the like. Among these, addition polymerization-type resin particles or polyaddition-type resin particles are preferable.

From the viewpoint of enabling thermal fusion, the resin particles may also be particles containing a thermoplastic resin (that is, thermoplastic resin particles).

The resin particles may be in the form of microcapsules, a microgel (that is, crosslinked resin particles), or the like.

The resin particles are preferably selected from the group consisting of thermoplastic resin particles, thermal reactive resin particles, resin particles having a polymerizable group, microcapsules encapsulating a hydrophobic compound, and a microgel (crosslinked resin particles). Among these, resin particles having a polymerizable group are preferable.

In a particularly preferred embodiment, the resin particles have at least one ethylenically unsaturated group. The presence of such resin particles brings about effects of improving the printing durability of an exposed portion and improving the on-press developability of a non-exposed portion.

As the thermoplastic resin particles, the thermoplastic resin particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like are preferable.

Specific examples of resins constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these.

From the viewpoint of ink receptivity and UV printing durability, the thermoplastic resin particles preferably contain a resin that has a constitutional unit formed of an aromatic vinyl compound and a nitrile group-containing constitutional unit.

The aforementioned aromatic vinyl compound may have a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

From the viewpoint of ink receptivity, the content of the constitutional unit formed of an aromatic vinyl compound is preferably higher than the content of the nitrile group-containing constitutional unit that will be described later. The content of the constitutional unit formed of an aromatic vinyl compound with respect to the total mass of the thermoplastic resin is more preferably 15% by mass to 85% by mass, and even more preferably 30% by mass to 70% by mass.

The nitrile group-containing constitutional unit is preferably introduced using a monomer having a nitrile group.

Examples of the monomer having a nitrile group include an acrylonitrile compound. As the monomer having a nitrile group, for example, (meth)acrylonitrile is suitable.

As the nitrile group-containing constitutional unit, a constitutional unit formed of (meth)acrylonitrile is preferable.

From the viewpoint of ink receptivity, the content of the nitrile group-containing constitutional unit is preferably lower than the content of the aforementioned constitutional unit formed of an aromatic vinyl compound. The content of the nitrile group-containing constitutional unit with respect to the total mass of the resin is more preferably 55% by mass to 90% by mass, and even more preferably 60% by mass to 85% by mass.

In a case where the resin contained in the thermoplastic resin particles has the constitutional unit formed of an aromatic vinyl compound and the nitrile group-containing constitutional unit, the content ratio between the constitutional unit formed of an aromatic vinyl compound and the nitrile group-containing constitutional unit (constitutional unit formed of aromatic vinyl compound:nitrile group-containing constitutional unit) is preferably 5:5 to 9: 1, and more preferably 6:4 to 8:2, based on mass.

From the viewpoint of UV printing durability and chemical resistance, the resin contained in the thermoplastic resin particles preferably further has a constitutional unit formed of a N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

The content of the constitutional unit formed of a N-vinyl heterocyclic compound with respect to the total mass of the thermoplastic resin is preferably 5% by mass to 50% by mass, and more preferably 10% by mass to 40% by mass.

The resin contained in the thermoplastic resin particles may contain an acidic group-containing constitutional unit. From the viewpoint of on-press developability and ink receptivity, it is preferable that the resin do not contain an acidic group-containing constitutional unit.

Specifically, in the thermoplastic resin, the content of the acidic group-containing constitutional unit is preferably 20% by mass or less, more preferably 10% by mass or less, and even more preferably 5% by mass or less. The lower limit of the content is not particularly limited, and may be 0% by mass.

The acid value of the thermoplastic resin is preferably 160 mg KOH/g or less, more preferably 80 mg KOH/g or less, and even more preferably 40 mg KOH/g or less. The lower limit of the acid value is not particularly limited, and may be 0 mg KOH/g.

Herein, the acid value is determined by the measurement method based on JIS K0070: 1992.

From the viewpoint of ink receptivity, the resin contained in the thermoplastic resin particles may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

**In** the resin contained in the thermoplastic resin particles, the content of the hydrophobic group-containing constitutional unit with respect to the total mass of the resin is preferably 5% by mass to 50% by mass, and more preferably 10% by mass to 30% by mass.

From the viewpoint of UV printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a nitrile group, a polyalkylene oxide structure, and the like.

From the viewpoint of UV printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

From the viewpoint of on-press developability, among the above hydrophilic groups, groups having a polypropylene oxide structure as a polyalkylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, as the aforementioned hydrophilic group, a group represented by Formula Z, which will be described later, is preferable.

Among the hydrophilic groups that the thermoplastic resin has, a group represented by Formula PO is preferable.

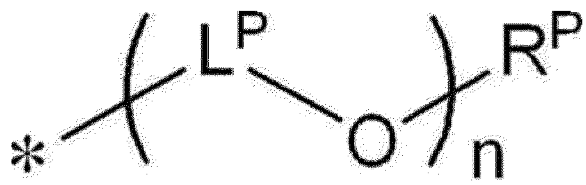

Formula PO

In Formula PO, $L^P$ each independently represent an alkylene group, $R^P$ represents a hydrogen atom or an alkyl group, n represents an integer of 1 to 100, and * represents a bonding position with other structures.

In Formula PO, $L^P$ preferably each independently represent an ethylene group, a 1-methylethylene group, or a 2-methylethylene group, and more preferably each independently represent an ethylene group.

In Formula PO, $R^P$ is preferably a hydrogen atom or an alkyl group having 1 to 18 carbon atoms, more preferably a hydrogen atom or an alkyl group having 1 to 10 carbon atoms, even more preferably a hydrogen atom or an alkyl group having 1 to 4 carbon atoms, and particularly preferably a hydrogen atom or a methyl group.

In Formula PO, n is preferably an integer of 1 to 10, and more preferably an integer of 1 to 4.

The content of the hydrophilic group-containing constitutional unit with respect to the total mass of the resin is preferably 5% by mass to 60% by mass, and more preferably 10% by mass to 30% by mass.

The resin contained in the thermoplastic resin particles may further contain other constitutional units. The resin can contain, as those other constitutional units, constitutional units other than the constitutional units described above without particular limitations. Examples thereof include constitutional units formed of an acrylamide compound, a vinyl ether compound, and the like.

**In** the resin contained in the thermoplastic resin particles, the content of other constitutional units with respect to the total mass of the resin is preferably 5% by mass to 50% by mass, and more preferably 10% by mass to 30% by mass.

Examples of the thermal reactive resin particles include resin particles having a thermal reactive group. The thermal reactive resin particles form a hydrophobic region through crosslinking by a thermal reaction and the accompanying change in functional groups.

The thermal reactive group in the resin particles having a thermal reactive group may be a functional group that causes any reaction as long as chemical bonds are formed. The thermal reactive group is preferably a polymerizable group. Preferred examples of the polymerizable group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

The resin having a thermal reactive group may be an addition polymerization-type resin, a polyaddition-type resin, or a polycondensation-type resin or may be a thermoplastic resin.

As the microcapsules, for example, microcapsules are preferable which encapsulate at least some of the constituent components (preferably a hydrophobic compound) of the image-recording layer as described in JP2001-277740A and JP2001-277742A. **In** a preferred aspect of the image-recording layer containing microcapsules as resin particles, the image-recording layer is composed of microcapsules that encapsulate a hydrophobic component (that is, a hydrophobic compound) among the constituent components of the image-recording layer and a hydrophilic component (that is, a hydrophilic compound) that is on the outside of the microcapsules.

The microgel (crosslinked resin particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, a reactive microgel having a polymerizable group on the surface thereof is particularly preferable.

In order to obtain microcapsules containing a constituent component of the image-recording layer, known synthesis methods can be used.

The microgel (crosslinked resin particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, a reactive microgel having a polymerizable group on the surface thereof is particularly preferable.

In order to obtain a microgel containing a constituent component of the image-recording layer, known synthesis methods can be used.

As the resin particles, from the viewpoint of printing durability, antifouling properties, and storage stability of the lithographic printing plate to be obtained, polyaddition-type resin particles are preferable which are obtained by a reaction between a polyvalent isocyanate compound that is an adduct of a polyhydric phenol compound having two or more hydroxy groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one kind of compound selected from the group consisting of propylene glycol, glycerin, and trimethylolpropane is even more preferable. As the aforementioned active hydrogen compound, water can also be used. In a case where water is used, the amine generated by the reaction between an isocyanato group and water can form a urea bond to form particles.

Preferred examples of the resin particles obtained by the reaction between a polyvalent isocyanate compound that is an adduct of a polyhydric phenol compound having two or more hydroxy groups in a molecule and isophorone diisocyanate and a compound having active hydrogen include the resin particles described in paragraphs "0230" to "0234" of WO2018/043259A.

As the resin particles, from the viewpoint of printing durability and solvent resistance of the lithographic printing plate to be obtained, addition polymerization-type resin particles are preferable which have a hydrophobic main chain and include both i) constitutional unit having a nitrile group directly bonded to the hydrophobic main chain and ii) constitutional unit having a pendant group including a hydrophilic polyalkylene oxide segment. Specifically, the particles described in paragraph "0156" of JP2019-64269A are preferable.

<<Group represented by Formula Z>>

It is preferable that the resin particles have a group represented by Formula Z as a hydrophilic group.

$$*\text{-Q-W-Y} \qquad \text{Formula Z}$$

In formula Z, Q represents a divalent linking group, W represents a divalent group having a hydrophilic structure

or a divalent group having a hydrophobic structure, and Y represents a monovalent group having a hydrophilic structure or a monovalent group having a hydrophilic structure, either W or Y has a hydrophilic structure, and * represents a bonding site with another structure.

Furthermore, it is preferable that any of the hydrophilic structures included in Formula Z include a polyalkylene oxide structure.

Q in Formula Z is preferably a divalent linking group having 1 to 20 carbon atoms, and more preferably a divalent linking group having 1 to 10 carbon atoms.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a group having a polyalkylene oxide structure, and more preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represent a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (divalent group formed by removing one hydrogen atom from an alkylaryl group), or an aralkylene group having 6 to 120 carbon atoms.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. Particularly, the monovalent group having a hydrophilic structure is preferably a group having a polyalkylene oxide structure, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 6 to 120 carbon atoms (alkylaryl group), an aralkyl group having 6 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in the resin particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

The group represented by Formula Z may function as a dispersible group for improving the dispersibility of the resin particles.

From the viewpoint of printing durability and on-press developability, the resin particles preferably have a polymerizable group (preferably an ethylenically unsaturated group). Particularly, the resin particles more preferably include resin particles having a polymerizable group on the surface thereof. Using the resin particles having a polymerizable group makes it easy to suppress plate missing (preferably UV plate missing) and improves printing durability (preferably UV printing durability) as well.

From the viewpoint of printing durability, it is preferable that the resin particles be resin particles having a hydrophilic group and a polymerizable group.

The polymerizable group may be a cationically polymerizable group or a radically polymerizable group. From the viewpoint of reactivity, the polymerizable group is preferably a radically polymerizable group.

The aforementioned polymerizable group is not particularly limited as long as it is a polymerizable group. From the viewpoint of reactivity, an ethylenically unsaturated group is preferable, a vinylphenyl group (styryl group), a (meth)acryloxy group, or a (meth)acrylamide group is more preferable, and a (meth)acryloxy group is particularly preferable.

**In** addition, it is preferable that the resin constituting the resin particles having a polymerizable group have a polymerizable group-containing constitutional unit.

The polymerizable group may be introduced into the surface of the resin particles by a polymer reaction.

Furthermore, from the viewpoint of printing durability, receptivity, on-press developability, and suppression of the occurrence of development residues during on-press development, the resin particles preferably contain a polyaddition-type resin having a urea bond, more preferably contain a polyaddition-type resin having a structure obtained by reacting at least an isocyanate compound represented by Formula (Iso) with water, and particularly preferably contain a polyaddition-type resin that has a structure obtained by reacting at least an isocyanate compound represented by Formula (Iso) with water and has a polyethylene oxide structure and a polypropylene oxide structure as polyoxyalkylene structures. Furthermore, the particles containing the polyaddition-type resin having a urea bond are preferably a microgel.

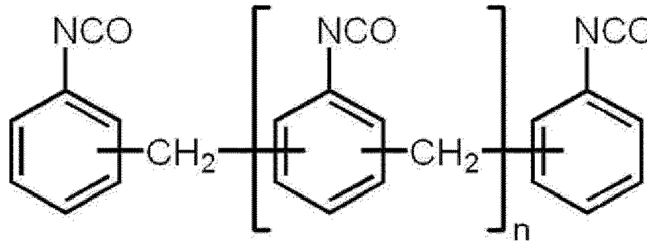

( Iso )

In Formula (Iso), n represents an integer of 0 to 10.

An example of the reaction between the isocyanate compound represented by Formula (Iso) and water is the reaction shown below. In the following example, a 4,4-isomer in which n = 0 is used.

As shown below, in a case where the isocyanate compound represented by Formula (Iso) is reacted with water, the isocyanate group is partially hydrolyzed by water and generates an amino group. The generated amino group reacts with the isocyanate group and generates a urea bond, and a dimer is consequently formed. Furthermore, the following reaction is repeated to form a polyaddition-type resin having a urea bond.

In the following reaction, by adding a compound (compound having active hydrogen) such as an alcohol compound or an amine compound reactive with an isocyanate group, it is possible to introduce the structure of an alcohol compound, an amine compound, or the like to the polyaddition-type resin having a urea bond.

Preferred examples of the compound having active hydrogen include the aforementioned compound having active hydrogen.

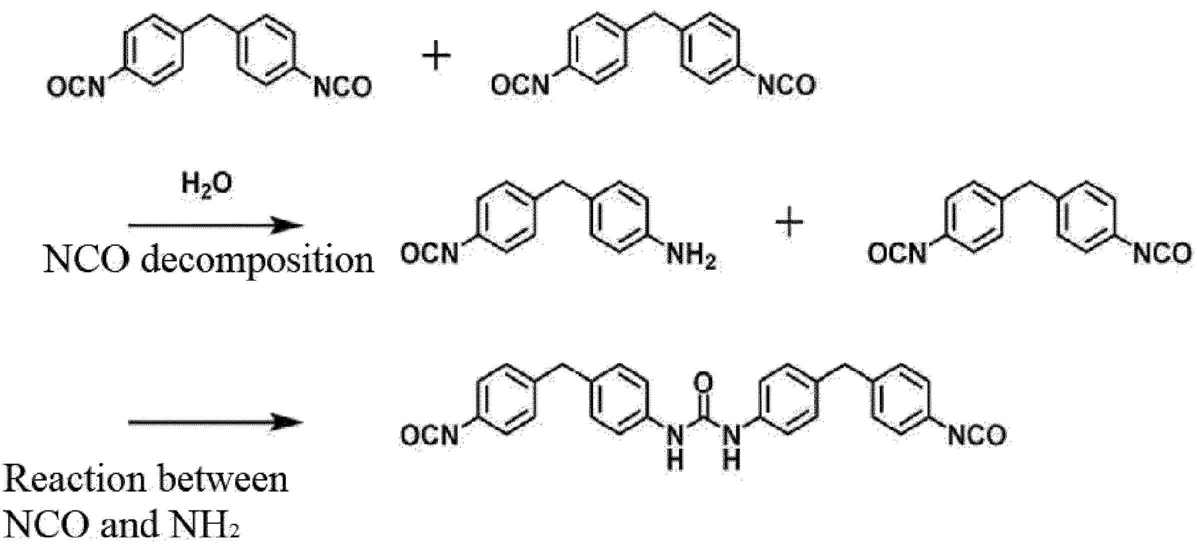


The polyaddition-type resin having a urea bond preferably has an ethylenically unsaturated group, and more preferably has a group represented by Formula (PETA).

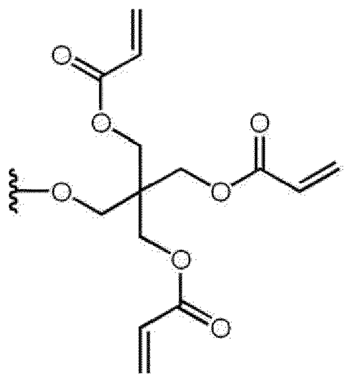

( PETA )

In Formula (PETA), the portion of the wavy line represents a bonding position with other structures.

<<Synthesis of resin particles>>

The synthesis method of the resin particles is not particularly limited, and may be a **method** that makes it possible to synthesize particles with various resins described above. Examples of the synthesis method of the resin particles include known synthesis methods of resin particles, such as an emulsion polymerization method, a suspension polymerization method, a dispersion polymerization method, a soap-free polymerization method, and a microemulsion polymerization method.
**In** addition, for the synthesis of the resin particles, a known microcapsule synthesis method, a known microgel (crosslinked resin particle) synthesis method, and the like may be used.

<<Average particle diameter of particles >>

The average particle diameter of the particles is preferably 0.01 μm to 3.0 μm, more preferably 0.03 μm to 2.0 μm, and even more preferably 0.10 μm to 1.0 μm. **In** a case where the average particle diameter is in this range, excellent resolution and temporal stability are obtained.
The average particle diameter of the particles is measured using a light scattering method or by capturing an electron micrograph of the particles, measuring the particle diameter of a total of 5,000 particles in the photograph, and calculating the average thereof. For nonspherical particles, the equivalent circular diameter of the particles in a photograph is adopted.
Note that unless otherwise specified, the average particle diameter of the particles means a volume average particle diameter.
As the particles (preferably resin particles), only one kind of particles may be used, or two or more kinds of particles may be used in combination.
From the viewpoint of developability and printing durability, the content of the particles (preferably resin particles) with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

[Other components]

The image-recording layer may contain other components in addition to the components described above.
Examples of those other components include a binder polymer, a color developing agent, a chain transfer agent, a low-molecular-weight hydrophilic compound, an oil sensitizing agent, other additives, and the like.
Examples of those other components include a colorant, a bakeout agent, a polymerization inhibitor, a higher fatty acid derivative, a plasticizer, inorganic particles, and a low-molecular-weight hydrophilic compound disclosed in paragraphs "0181" to "0190" of JP2009-255434A, and the like.
Examples of other compounds also include a hydrophilic precursor (fine particles capable of converting the image-recording layer into a hydrophobic image-recording layer in a case where heat is applied thereto), a low-molecular-weight hydrophilic compound, an oil sensitizing agent (for example, a phosphonium compound, a nitrogen-containing low-molecular-weight compound, or an ammonium group-containing polymer), and a chain transfer agent disclosed in paragraphs "0191" to "0217" of JP2012-187907A.

-Binder polymer-

As necessary, the image-recording layer may contain a binder polymer.
The binder polymer refers to a polymer other than resin particles, that is, a polymer that is not in the form of particles.
**In** addition, the binder polymer excludes an ammonium salt-containing polymer in an oil sensitizing agent and a polymer used as a surfactant.
As the binder polymer, known binder polymers (for example, a (meth) acrylic resin, polyvinyl acetal, a polyurethane resin, and the like) used for the image-recording layer of a lithographic printing plate precursor can be suitably used.
As an example, a binder polymer that is used for an on-press development type lithographic printing plate precursor (hereinafter, also called binder polymer for on-press development) will be specifically described.
As the binder polymer for on-press development, a binder polymer having an alkylene oxide chain is preferable. The binder polymer having an alkylene oxide chain may have a poly(alkylene oxide) moiety in a main chain or side chain. **In** addition, the binder polymer may be a graft polymer having poly(alkylene oxide) in a side chain or a block copolymer of a block composed of a poly(alkylene oxide)-containing repeating unit and a block composed of an (alkylene oxide)-free

repeating unit.

As a binder polymer having a poly(alkylene oxide) moiety in the main chain, a polyurethane resin is preferable.

In a case where the binder polymer has a poly(alkylene oxide) moiety in the side chain, examples of polymers include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

In addition, as the binder polymer, for example, a polymer compound is also preferable which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

As the star-shaped polymer compound, for example, the compounds described in JP2012-148555A can be preferably used.

Examples of the star-shaped polymer compound include the compound described in JP2008-195018A that has a polymerizable group such as an ethylenically unsaturated bond for improving the film hardness of an image area in a main chain or side chain and preferably in a side chain. The polymerizable group of the star-shaped polymer compound forms crosslinks between the molecules of the star-shaped polymer compound, which facilitates curing.

As the polymerizable group, an ethylenically unsaturated group such as a (meth)acryloyl group, a vinyl group, an allyl group, or a vinyl phenyl group (styryl group), an epoxy group, or the like is preferable, a (meth)acryloyl group, a vinyl group, or a vinyl phenyl group (styryl group) is more preferable from the viewpoint of polymerization reactivity, and a (meth)acryloyl group is particularly preferable. These groups can be introduced into the polymer by a polymer reaction or copolymerization. Specifically, for example, it is possible to use a reaction between a polymer having a carboxy group in a side chain and glycidyl methacrylate or a reaction between a polymer having an epoxy group and an ethylenically unsaturated group-containing carboxylic acid such as methacrylic acid.

The molecular weight of the binder polymer that is a polystyrene-equivalent weight-average molecular weight (Mw) determined by Gel permeation chromatography (GPC) is preferably 2,000 or more, more preferably 5,000 or more, and even more preferably 10,000 to 300,000.

As the binder polymer, as necessary, a hydrophilic polymer, such as polyacrylic acid, polyvinyl alcohol, or polyvinyl acetal described in JP2008-195018A, can be used in combination. In addition, a lipophilic polymer and a hydrophilic polymer can be used in combination.

Particularly, from the viewpoint of on-press developability, the image-recording layer preferably contains polyvinyl acetal. Suitable examples of the polyvinyl acetal include polyvinyl butyral and the like.

One kind of binder polymer may be used alone, or two or more kinds of binder polymers may be used in combination.

The content of the binder polymer to be incorporated into the image-recording layer can be randomly set. The content of the binder polymer with respect to the total mass of the image-recording layer is preferably 1% by mass to 90% by mass, and more preferably 5% by mass to 80% by mass.

-Color developing agent-

The image-recording layer preferably contains a color developing agent, and more preferably contains an acid color developing agent. Furthermore, the color developing agent preferably includes a leuco compound.

"Color developing agent" used herein means a compound that develops or removes color by a stimulus such as light or acid and thus changes the color of the image-recording layer. Furthermore, "acid color developing agent" means a compound that develops or removes color by being heated in a state of accepting an electron accepting compound (for example, a proton of an acid or the like) and thus changes the color of the image-recording layer. The acid color developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

Examples of such an acid color developing agent include the compounds described in paragraphs "0184" to "0191" of JP2019-18412A.

Particularly, from the viewpoint of visibility, the color developing agent is preferably at least one kind of compound selected from the group consisting of a spiropyran compound, a spirooxazine compound, a spirolactone compound, and a spirolactam compound.

From the viewpoint of visibility, the color of a colorant after color development preferably has maximum absorption wavelength in the range of 450 to 650 nm. The tint is preferably red, purple, blue, or dark green.

From the viewpoint of visibility and visibility of exposed portions, the acid color developing agent is preferably a leuco colorant.

The aforementioned leuco colorant is not particularly limited as long as it has a leuco structure. The leuco colorant

preferably has a spiro structure, and more preferably has a spirolactone ring structure.

From the viewpoint of visibility and visibility of exposed portions, the leuco colorant is preferably a leuco colorant having a phthalide structure or a fluoran structure.

Furthermore, from the viewpoint of visibility and visibility of exposed portions, the leuco colorant having a phthalide structure or a fluoran structure is preferably a compound represented by any of Formula (Le-1) to Formula (Le-3), and more preferably a compound represented by Formula (Le-2).

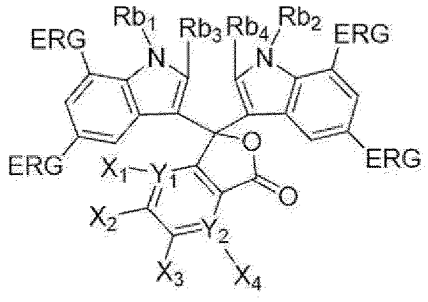

( Le - 1 )

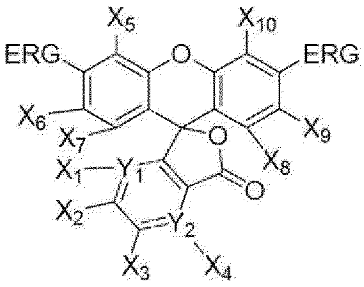

( Le - 2 )

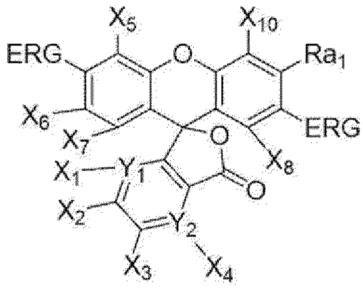

( Le - 3 )

In Formula (Le-1) to Formula (Le-3), ERG each independently represent an electron-donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

As the electron-donating groups represented by ERG in Formula (Le-1) to Formula (Le-3), from the viewpoint of visibility and visibility of exposed portions, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable an arylamino group, a monoalkyl monoarylamino group, or a diarylamino group is even more preferable, and an arylamino group or a monoalkyl monoarylamino group is particularly preferable.

From the viewpoint of visibility and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of visibility and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of visibility and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of visibility and visibility of exposed portions, $Ra_1$ in Formula (Le-3) is preferably an alkyl group or an alkoxy group, more preferably an alkoxy group, and particularly preferably a methoxy group.

From the viewpoint of visibility and visibility of exposed portions, $Rb_1$ to $Rb_4$ in Formula (Le-1) preferably each independently represent a hydrogen atom or an alkyl group, more preferably each independently represent an alkyl group, and particularly preferably each independently represent a methyl group.

From the viewpoint of visibility and visibility of exposed portions, the leuco colorant having a phthalide structure or a fluoran structure is more preferably a compound represented by any of Formula (Le-4) to Formula (Le-6), and even more preferably a compound represented by Formula (Le-5).

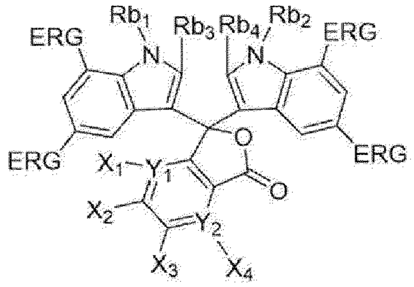

( Le - 4 )

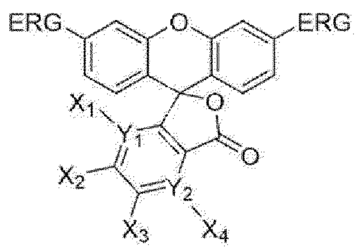

( Le - 5 )

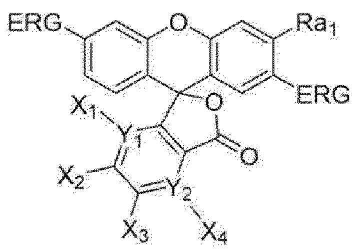

( Le - 6 )

In Formula (Le-4) to Formula (Le-6), ERG each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

From the viewpoint of visibility and visibility of exposed portions, the leuco colorant having a phthalide structure or a fluoran structure is more preferably a compound represented by any of Formula (Le-7) to Formula (Le-9), and particularly preferably a compound represented by Formula (Le-8).

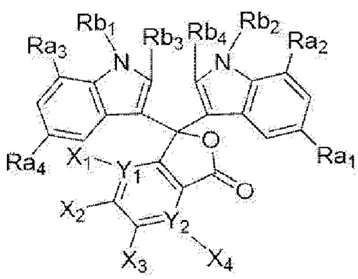

( Le - 7 )

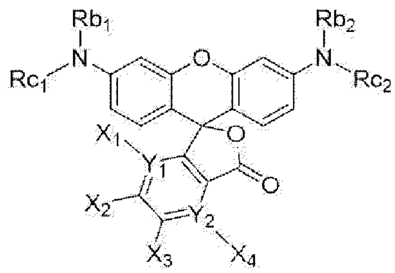

( Le - 8 )

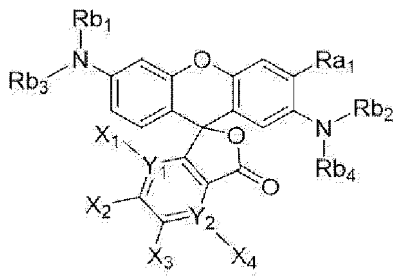

( Le - 9 )

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of visibility and visibility of exposed portions, $Ra_1$ to $Ra_4$ in Formula (Le-7) preferably each independently represent an alkyl group or an alkoxy group, more preferably each independently represent an alkoxy group, and particularly preferably each independently represent a methoxy group.

From the viewpoint of visibility and visibility of exposed portions, $Rb_1$ to $Rb_4$ in Formula (Le-7) to Formula (Le-9) preferably each independently represent a hydrogen atom, an alkyl group, or an aryl group substituted with an alkyl group or alkoxy group, more preferably each independently represent a hydrogen atom or an alkyl group, and particularly preferably each independently represent a hydrogen atom or a methyl group.

From the viewpoint of visibility and visibility of exposed portions, $Rc_1$ and $Rc_2$ in Formula (Le-8) preferably each independently represent a phenyl group or an alkylphenyl group, and more preferably each independently represent a phenyl group.

In Formula (Le-8), from the viewpoint of visibility and visibility of exposed portions, $X_1$ to $X_4$ preferably each represent a hydrogen atom, and $Y_1$ and $Y_2$ preferably each represent C.

From the viewpoint of visibility and visibility of exposed portions, $Rb_1$ and $Rb_2$ in Formula (Le-8) preferably each independently represent a hydrogen atom, an alkyl group, or an aryl group substituted with an alkyl group or an alkoxy group, more preferably each independently represent a hydrogen atom or an alkyl group.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9), such as a monovalent organic group, an alkyl group, an aryl group, a dialkylanilino group, an alkylamino group, and an alkoxy group, may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, a cyano group, and the like. These substituents may be further substituted with these substituents.

Examples of the leuco colorant having the phthalide structure or the fluoran structure that are suitably used include the following compounds.

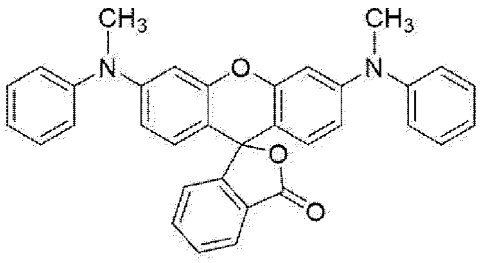

S - 1

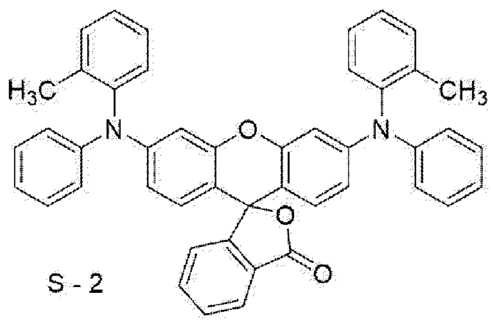

S - 2

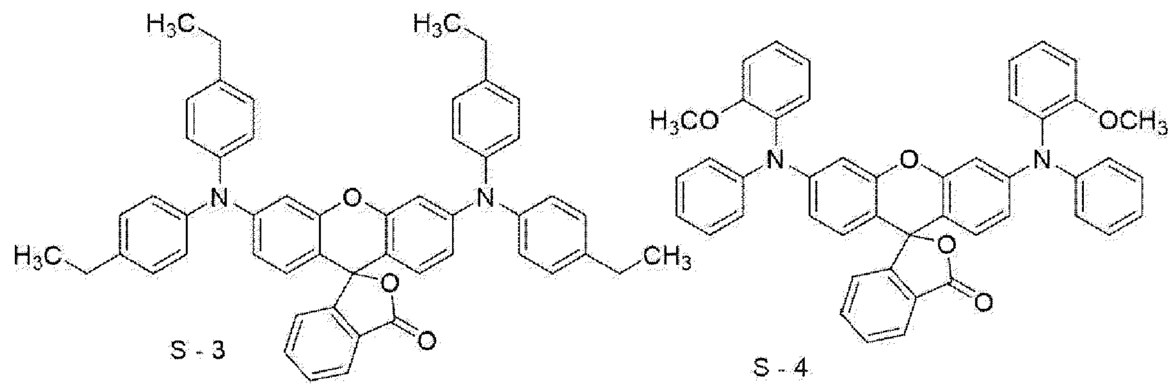

S - 3

S - 4

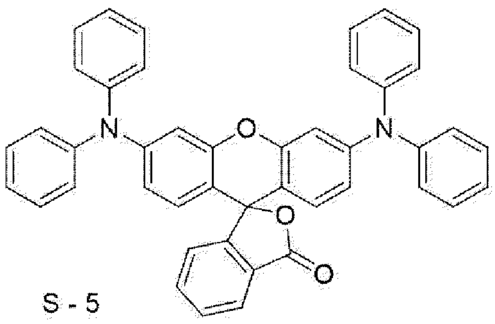

S - 5

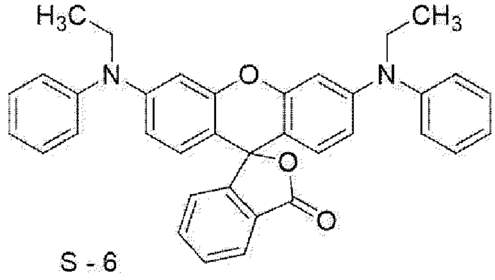

S - 6

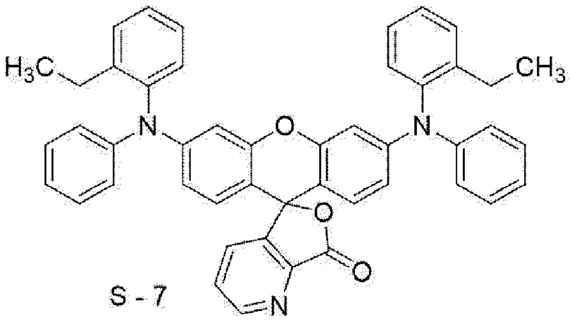

S - 7

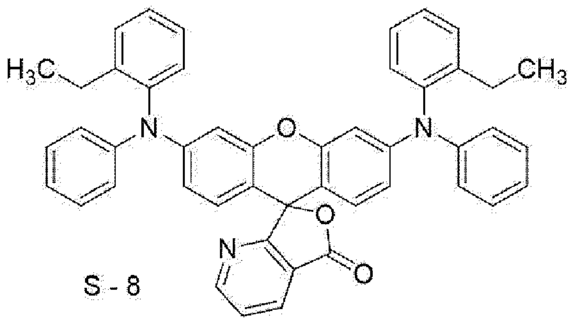

S - 8

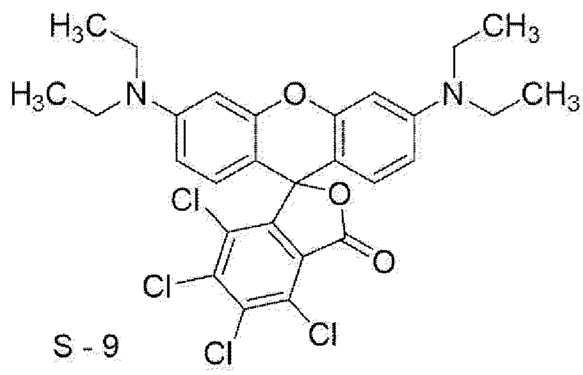

S - 9

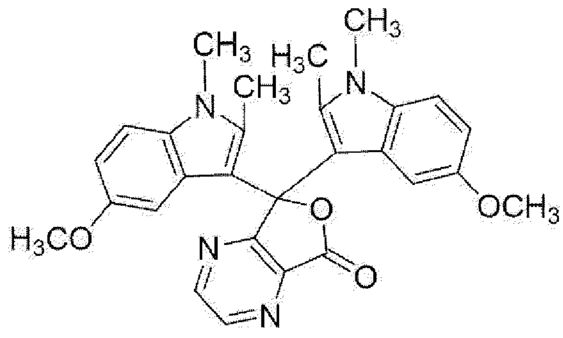

S - 10

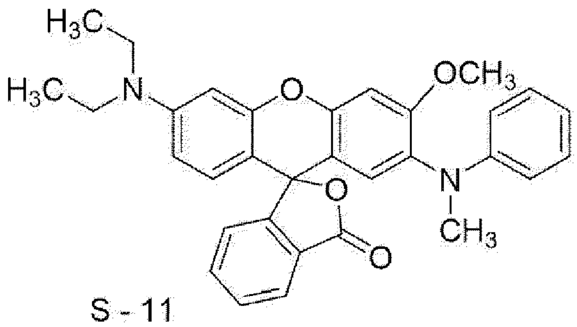

S - 11

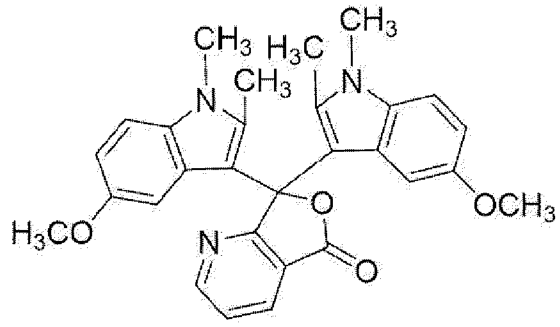

S - 12

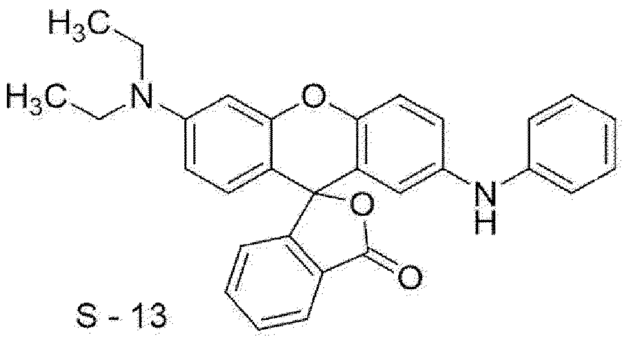

S - 13

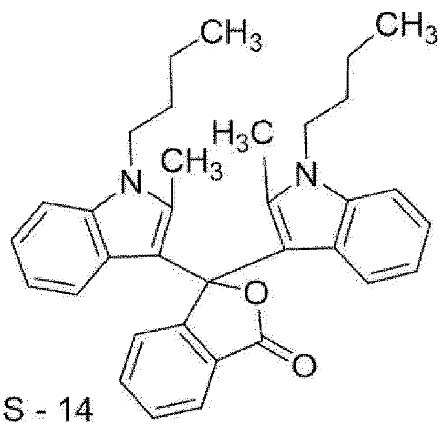

S - 14

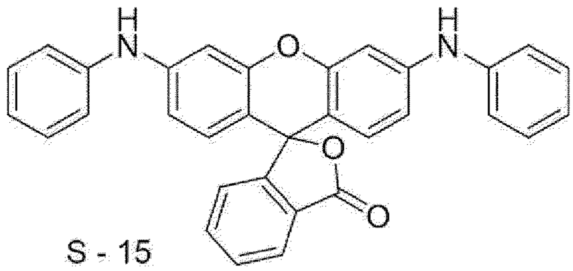

S - 15

As the acid color developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

From the viewpoint of visibility and visibility of exposed portions, examples of suitably used a leuco colorant include the following compounds.

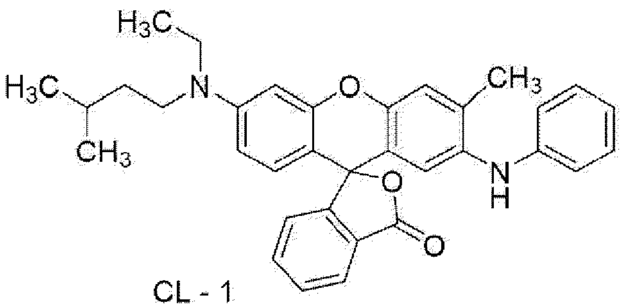

CL - 1

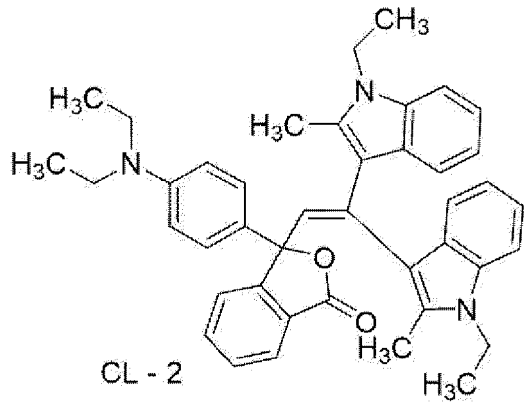

CL - 2

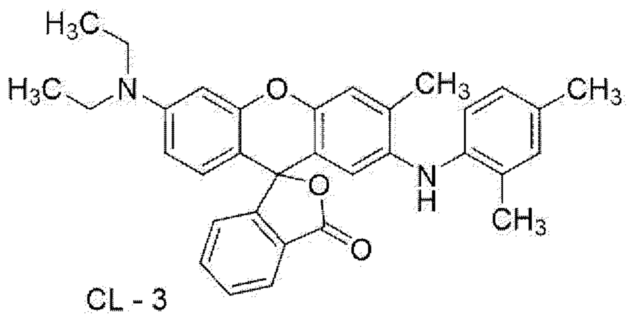

CL - 3

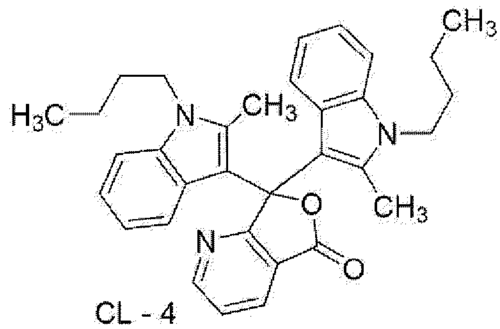

CL - 4

One kind of each of these color developing agents may be used alone. Alternatively, two or more kinds of components can be used in combination.

The content of the color developing agent with respect to the total mass of the image-recording layer is preferably 0.5% by mass to 10% by mass, and more preferably 1% by mass to 5% by mass.

[Formation of image-recording layer]

The image-recording layer in the lithographic printing plate precursor can be formed, for example, by preparing a coating liquid by dispersing or dissolving the necessary components described above in a known solvent, coating a

support with the coating liquid by a known method such as bar coating, and drying the coating liquid, as described in paragraphs "0142" and "0143" of JP2008-195018A. The coating amount (solid content) of the image-recording layer after coating and drying varies with uses, but is preferably 0.3 g/m$^2$ to 3.0 g/m$^2$. In a case where the coating amount is in this range, excellent sensitivity and excellent film characteristics of the image-recording layer are obtained.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate, ethyl lactate, and the like. One kind of solvent may be used alone, or two or more kinds of the solvents may be used in combination. The concentration of solid contents in the coating liquid is preferably 1% by mass to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 g/m$^2$ to 3.0 g/m$^2$.

The film thickness of the image-recording layer in the lithographic printing plate precursor is preferably 0.1 $\mu$m to 3.0 $\mu$m, and more preferably 0.3 $\mu$m to 2.0 $\mu$m.

Herein, the film thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Outermost layer>

The on-press development type lithographic printing plate precursor according to the present invention has an aluminum support, an image-recording layer, and an outermost layer in this order, and the outermost layer contains a discoloring compound.

In the on-press development type lithographic printing plate precursor, the outermost layer is the outermost layer on the side of the image-recording layer that is on the support.

The outermost layer may have a function of suppressing the reaction inhibiting image formation by blocking oxygen, a function of preventing the damage of the image-recording layer, a function of preventing ablation during exposure to high-illuminance lasers, and the like.

-Discoloring compound-

The outermost layer contains a discoloring compound.

The outermost layer may contain other components, such as a water-soluble polymer, a hydrophobic polymer, an oil sensitizing agent, an acid generator, and an infrared absorber, in addition to a discoloring compound. The outermost layer preferably contains a discoloring compound and a water-soluble polymer, and more preferably contains a discoloring compound, a water-soluble polymer, and a hydrophobic polymer.

In the present invention, "discoloring compound" refers to a compound which undergoes change in absorption in the visible light region (wavelength: 400 nm or more and less than 750 nm) due to the exposure to infrared. That is, in the present invention, "discoloring" means that the absorption in the visible light region (wavelength: 400 nm or more and less than 750 nm) changes due to the exposure to infrared.

Specifically, examples of the discoloring compound in the present disclosure include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared.

The infrared in the present invention is a ray having a wavelength of 750 nm to 1 mm, and preferably a ray having a wavelength of 750 nm to 1,400 nm.

The discoloring compound preferably includes a compound that develops color due to the exposure to infrared.

Furthermore, the discoloring compound preferably includes a decomposable compound that decomposes due to the exposure to infrared, and particularly preferably includes a decomposable compound that decomposes by either or both of heat and electron migration due to the exposure to infrared.

More specifically, the discoloring compound in the present invention is preferably a compound that decomposes due to the exposure to infrared (more preferably, decomposes by either or both of heat or electron migration due to the

exposure to infrared) and absorbs more light in the visible light region than before the exposure to infrared or is made capable of absorbing light of shorter wavelengths and thus capable of absorbing light in the visible light region.

"Decomposes by electron migration" mentioned herein means that electrons excited to the lowest unoccupied molecular orbital (LUMO) from the highest occupied molecular orbital (HOMO) of the discoloring compound by exposure to infrared move to electron accepting groups (groups having potential close to LUMO) in a molecule by means of intramolecular electron migration and thus result in decomposition.

Hereinafter, as an example of the discoloring compound, a decomposable compound will be described.

There are no limitations on the decomposable compound as long as it absorbs at least a part of light in the infrared wavelength region (wavelength region of 750 nm to 1 mm, preferably a wavelength region of 750 nm to 1,400 nm) and decomposes. The decomposable compound is preferably a compound having maximum absorption wavelength in a wavelength region of 750 nm to 1,400 nm.

More specifically, the decomposable compound is preferably a compound that decomposes due to the exposure to infrared and generates a compound having maximum absorption wavelength in a wavelength region of 500 nm to 600 nm.

From the viewpoint of improving visibility of exposed portions, the decomposable compound is preferably a cyanine dye having a group that decomposes by exposure to infrared (specifically, $R^1$ in Formula 1-1 to Formula 1-7).

From the viewpoint of improving visibility of exposed portions, the decomposable compound is more preferably a compound represented by Formula 1-1.

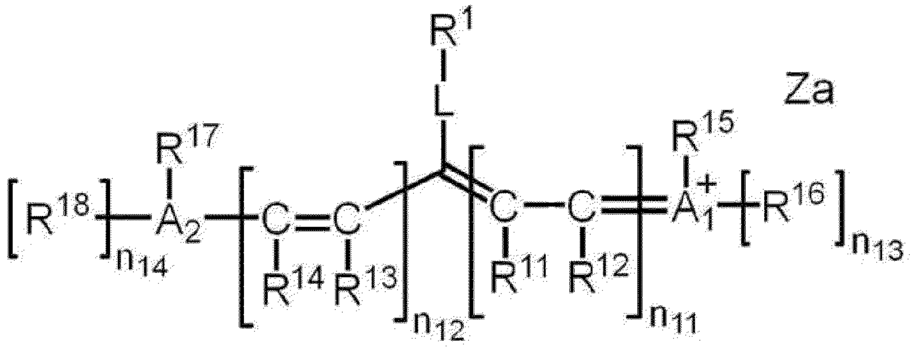

Formula 1-1

In Formula 1-1, $R^1$ represents a group that is represented by any of Formula 2-1 to Formula 4-1, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R_{11}$ to $R_{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, the sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

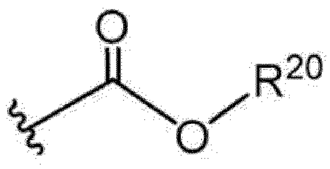

Formula 2-1

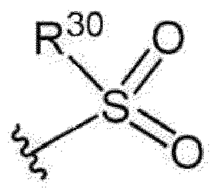

Formula 3-1

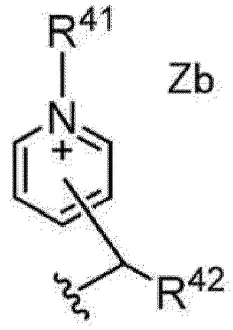

Formula 4-1

In Formula 2-1 to Formula 4-1, $R^{20}$, $R^{30}$, $R^{41}$, and $R^{42}$ each independently represent an alkyl group or an aryl group, Zb represents a counterion that neutralizes charge, a wavy line represents a bonding site with a group represented by L in Formula 1-1.

In a case where the compound represented by Formula 1-1 is exposed to infrared, the $R^1$-L bond is cleaved, L turns into =O, =S, or $=NR^{10}$, and the compound is discolored.

In Formula 1-1, $R^1$ represents a group represented by any of Formula 2-1 to Formula 4-1.

Hereinafter, each of the group represented by Formula 2-1, the group represented by Formula 3-1, and the group represented by Formula 4-1 will be described.

In Formula 2-1, $R^{20}$ represents an alkyl group or an aryl group, and the portion of the wavy line represents a bonding site with the group represented by L in Formula 1-1.

As the alkyl group represented by $R^{20}$, an alkyl group having 1 to 30 carbon atoms is preferable, an alkyl group having 1 to 15 carbon atoms is more preferable, and an alkyl group having 1 to 10 carbon atoms is even more preferable.

The alkyl group may be linear or branched, or may have a ring structure.

The aryl group represented by $R^{20}$ is preferably an aryl group having 6 to 30 carbon atoms, more preferably an aryl group having 6 to 20 carbon atoms, and even more preferably an aryl group having 6 to 12 carbon atoms.

From the viewpoint of visibility, $R^{20}$ is preferably an alkyl group.

From the viewpoint of decomposition properties and visibility, the alkyl group represented by $R^{20}$ is preferably a secondary alkyl group or a tertiary alkyl group, and more preferably a tertiary alkyl group.

Furthermore, from the viewpoint of decomposition properties and visibility, the alkyl group represented by $R^{20}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Specific examples of the group represented by Formula 2-1 will be shown below. However, it is not limited thereto. In the following structural formulas, • represents a bonding site with the group represented by L in Formula 1-1.

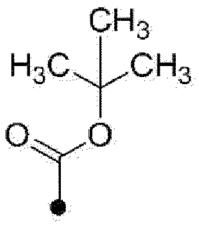
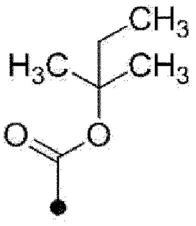
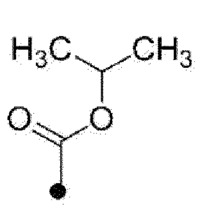
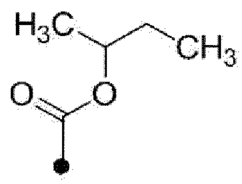
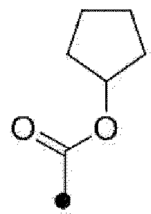

In Formula 3-1, $R^{30}$ represents an alkyl group or an aryl group, and the portion of the wavy line represents a bonding site with the group represented by L in Formula 1-1.

The alkyl group and aryl group represented by $R^{30}$ are the same as the alkyl group and aryl group represented by $R^{20}$ in Formula 2-1, and the preferred aspects thereof are also the same.

From the viewpoint of decomposition properties and visibility, the alkyl group represented by $R^{30}$ is preferably a secondary alkyl group or a tertiary alkyl group, and more preferably a tertiary alkyl group.

Furthermore, from the viewpoint of decomposition properties and visibility, the alkyl group represented by $R^{30}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

In addition, from the viewpoint of decomposition properties and visibility, the alkyl group represented by $R^{30}$ is preferably a substituted alkyl group, more preferably a fluoro-substituted alkyl group, even more preferably a perfluoroalkyl group, and particularly preferably a trifluoromethyl group.

From the viewpoint of decomposition properties and visibility, the aryl group represented by $R^{30}$ is preferably a substituted aryl group. Examples of the substituent include an alkyl group (preferably an alkyl group having 1 to 4 carbon atoms), an alkoxy group (preferably an alkoxy group having 1 to 4 carbon atoms), and the like.

Specific examples of the group represented by Formula 3-1 will be shown below. However, it is not limited thereto. In the following structural formulas, • represents a bonding site with the group represented by L in Formula 1-1.

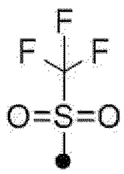
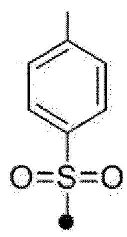

In Formula 4-1, $R^{41}$ and $R^{42}$ each independently represent an alkyl group or an aryl group, Zb represents a counterion that neutralizes charge, and the portion of the wavy line represents a bonding site with the group represented by

L in Formula 1-1.

The alkyl group and aryl group represented by $R^{41}$ or $R^{42}$ are the same as the alkyl group and aryl group represented by $R^{20}$ in Formula 2, and preferred aspects thereof are also the same.

From the viewpoint of decomposition properties and visibility, $R^{41}$ is preferably an alkyl group.

From the viewpoint of decomposition properties and visibility, $R^{42}$ is preferably an alkyl group.

From the viewpoint of decomposition properties and visibility, the alkyl group represented by $R^{41}$ is preferably an alkyl group having 1 to 8 carbon atoms, more preferably an alkyl group having 1 to 4 carbon atoms, and particularly preferably a methyl group.

From the viewpoint of decomposition properties and visibility, the alkyl group represented by $R^{42}$ is preferably a secondary alkyl group or a tertiary alkyl group, and more preferably a tertiary alkyl group.

Furthermore, from the viewpoint of decomposition properties and visibility, the alkyl group represented by $R^{42}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Zb in Formula 4-1 may be a counterion that neutralizes charge, and may be included in Za in Formula 1-1 in the entirety of the compound.

Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion.

Specific examples of the group represented by Formula 4-1 will be shown below. However, it is not limited thereto. In the following structural formulas, • represents a bonding site with the group represented by L in Formula 1-1.

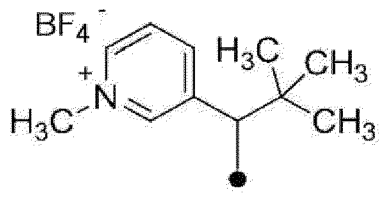

L in Formula 1-1 is preferably an oxygen atom or $-NR^{10}-$, and particularly preferably an oxygen atom.

Furthermore, $R^{10}$ in $-NR^{10}-$ is preferably an alkyl group. The alkyl group represented by $R^{10}$ is preferably an alkyl group having 1 to 10 carbon atoms. The alkyl group represented by $R^{10}$ may be linear or branched, or may have a ring structure.

Among the alkyl groups, a methyl group or a cyclohexyl group is preferable.

In a case where $R^{10}$ in $-NR^{10}-$ represents an aryl group, the aryl group is preferably an aryl group having 6 to 30 carbon atoms, more preferably an aryl group having 6 to 20 carbon atoms, and even more preferably an aryl group having 6 to 12 carbon atoms. These aryl groups may have a substituent.

In Formula 1-1, $R^{11}$ to $R^{18}$ preferably each independently represent a hydrogen atom, $-R^a$, $-OR^b$, $-SR^c$, or $-NR^dR^e$.

The hydrocarbon group represented by $R^a$ to $R^e$ is preferably a hydrocarbon group having 1 to 30 carbon atoms, more preferably a hydrocarbon group having 1 to 15 carbon atoms, and even more preferably a hydrocarbon group having 1 to 10 carbon atoms.

The hydrocarbon group may be linear or branched or may have a ring structure.

As the hydrocarbon group, an alkyl group is particularly preferable.

The aforementioned alkyl group is preferably an alkyl group having 1 to 30 carbon atoms, more preferably an alkyl group having 1 to 15 carbon atoms, and even more preferably an alkyl group having 1 to 10 carbon atoms.

The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is preferable.

The above alkyl group may have a substituent.

Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, groups obtained by combining these, and the like.

$R^{11}$ to $R^{14}$ in Formula 1-1 preferably each independently represent a hydrogen atom or $-R^a$ (that is, a hydrocarbon group), more preferably each independently represent a hydrogen atom or an alkyl group, and even more preferably each

independently represent a hydrogen atom except in the cases described below.

Particularly, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed in this way may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring or an indole ring.

Furthermore, it is preferable that $R^{12}$ bonded to the carbon atom to which $A_1^+$ is bonded be linked to $R^{15}$ or $R^{16}$ (preferably $R^{16}$) to form a ring, and $R^{14}$ bonded to the carbon atom to which $A_2$ is bonded be linked to $R^{17}$ or $R^{18}$ (preferably $R^{18}$) to form a ring.

In Formula 1-1, $n_{13}$ is preferably 1, and $R^{16}$ is preferably $-R^a$ (that is, a hydrocarbon group).

Furthermore, it is preferable that $R^{16}$ be linked to $R^{12}$ bonded to the carbon atom to which $A_1^+$ is bonded, so as to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.

In Formula 1-1, $n_{14}$ is preferably 1, and $R^{18}$ is preferably $-R^a$ (that is, a hydrocarbon group).

Furthermore, it is preferable that $R^{18}$ be linked to $R^{14}$ bonded to the carbon atom to which $A_2$ is bonded, so as to form a ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula 1-1 be the same group. In a case where $R^{16}$ and $R^{18}$ each form a ring, it is preferable that the formed rings have the same structure except for $A_1^+$ and $A_2$.

It is preferable that $R^{15}$ and $R^{17}$ in Formula 1-1 be the same group. Furthermore, $R^{15}$ and $R^{17}$ are preferably $-R^a$ (that is, a hydrocarbon group), more preferably an alkyl group, and even more preferably a substituted alkyl group.

From the viewpoint of improving water solubility, $R^{15}$ and $R^{17}$ in the compound represented by Formula 1-1 are preferably a substituted alkyl group.

Examples of the substituted alkyl group represented by $R^{15}$ or $R^{17}$ include a group represented by any of Formula (a1) to Formula (a4).

$$-W\left(R^{W0}-O\right)_{n_{W1}}R^{W1} \qquad (a1)$$

$$-R^{W2}-CO_2M \qquad (a2)$$

$$-R^{W3}-PO_3M_2 \qquad (a3)$$

$$-R^{W4}-SO_3M \qquad (a4)$$

In Formula (a1) to Formula (a4), $R^{W0}$ represents an alkylene group having 2 to 6 carbon atoms, W represents a single bond or an oxygen atom, and $n_{W1}$ represents an integer of 1 to 45, $R^{W1}$ represents an alkyl group having 1 to 12 carbon atoms or $-C(=O)-R^{W5}$, $R^{W5}$ represents an alkyl group having 1 to 12 carbon atoms, $R^{W2}$ to $R^{W4}$ each independently represent a single bond or an alkylene group having 1 to 12 carbon atoms, and M represents a hydrogen atom, a sodium atom, a potassium atom, or an onium group.

Specific examples of the alkylene group represented by $R^{W0}$ in Formula (a1) include an ethylene group, a n-propylene group, an isopropylene group, a n-butylene group, an isobutylene group, a n-pentylene group, an isopentylene group, a n-hexyl group, an isohexyl group, and the like. Among these, an ethylene group, a n-propylene group, an isopropylene group, or a n-butylene group is preferable, and a n-propylene group is particularly preferable.

$n_{W1}$ is preferably 1 to 10, more preferably 1 to 5, and particularly preferably 1 to 3.

Specific examples of the alkyl group represented by $R^{W1}$ include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, a n-dodecyl group, and the like. Among these, a methyl group, an ethyl group, a n-propyl group, an isopropyl group, a n-butyl group, or a tert-butyl group is preferable, a methyl group or an ethyl group is more preferable, and a methyl group is particularly preferable.

The alkyl group represented by $R^{W5}$ is the same as the alkyl group represented by $R^{W1}$. Preferred aspects of the alkyl group represented by $R^{W5}$ are the same as preferred aspects of the alkyl group represented by $R^{W1}$.

Specific examples of the group represented by Formula (a1) will be shown below. However, it is not limited

thereto. In the following structural formulas, Me represents a methyl group, Et represents an ethyl group, and * represents a bonding site.

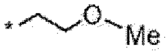 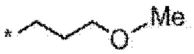 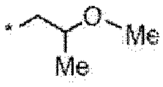 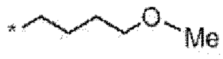 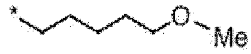

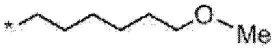 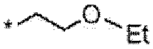 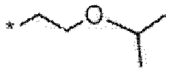 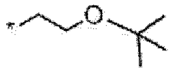

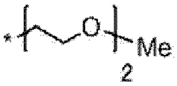 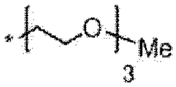 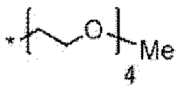 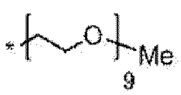 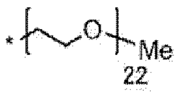

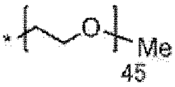 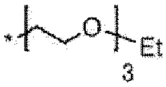 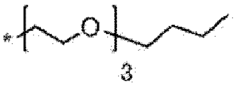 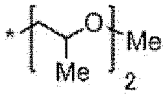 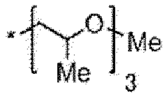

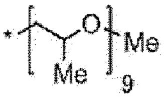 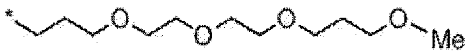

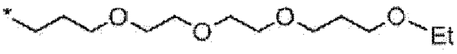 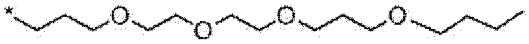

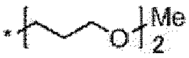 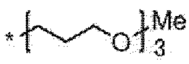 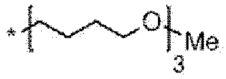

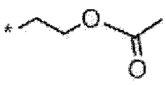 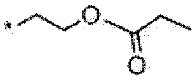 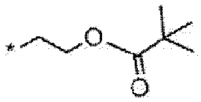 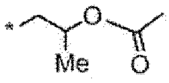 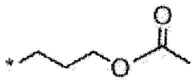

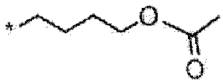 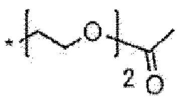 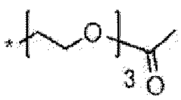 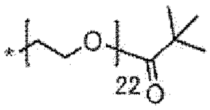

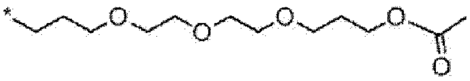

Specific examples of the alkylene group represented by $R^{W2}$ to $R^{W4}$ in Formula (a2) to Formula (a4) include a methylene group, an ethylene group, a n-propylene group, an isopropylene group, a n-butylene group, an isobutylene group, a n-pentylene group, an isopentylene group, a n-hexyl group, an isohexyl group, a n-octylene group, a n-dodecylene group, and the like. Among these, an ethylene group, a n-propylene group, an isopropylene group, or a n-butylene group is preferable, and an ethylene group or a n-propylene group is particularly preferable.

**In** Formula (a3), two Ms may be the same as or different from each other.

Examples of the onium group represented by M in Formula (a2) to Formula (a4) include an ammonium group, an iodonium group, a phosphonium group, a sulfonium group, and the like.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula 1-1.

Among the groups represented by Formula (a1) to Formula (a4), the group represented by Formula (a1),

Formula (a2), or Formula (a4) is preferable.

$n_{11}$ and $n_{12}$ in Formula 1-1 are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula 1-1 each independently represent an oxygen atom, a sulfur atom, or a nitrogen atom. Among these, a nitrogen atom is preferable.

$A_1$ and $A_2$ in Formula 1-1 are preferably the same atoms.

Za in Formula 1-1 represents a counterion that neutralizes charge.

In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where two or more among $R^{11}$ to $R^{18}$ and $R^1$-L have an anion structure, Za can also be a countercation.

In a case where the cyanine dye represented by Formula 1-1 has such a structure that the overall charge of the compound is neutral except for Za, Za is unnecessary.

In a case where Za is a counteranion, examples thereof include a sulfonate ion, a carboxylate ion, a tetrafluoroborate ion, a hexafluorophosphate ion, a p-toluenesulfonate ion, a perchlorate ion, and the like. Among these, a tetrafluoroborate ion is preferable.

In a case where Za is a countercation, examples thereof include an alkali metal ion, an alkaline earth metal ion, an ammonium ion, a pyridinium ion, a sulfonium ion, and the like. Among these, a sodium ion, a potassium ion, an ammonium ion, a pyridinium ion, or a sulfonium ion is preferable, and a sodium ion, a potassium ion, or an ammonium ion is more preferable.

From the viewpoint of improving visibility of exposed portions, the decomposable compound is more preferably a compound represented by Formula 1-2 (that is, a cyanine dye).

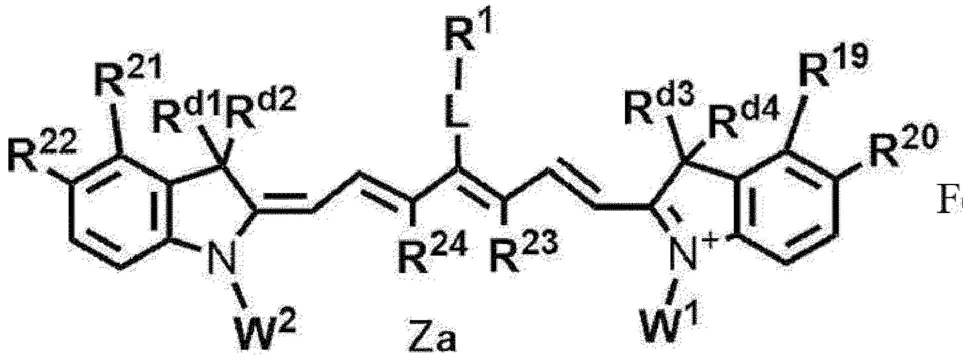

Formula 1-2

In Formula 1-2, $R^1$ represents a group that is represented by any of Formula 2-1 to Formula 4-1, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent a hydrogen atom or $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$ in Formula 1-2 has the same definition as $R^1$ in Formula 1-1, and preferred aspects thereof are also the same.

In Formula 1-2, $R^{19}$ to $R^{22}$ preferably each independently represent a hydrogen atom, a halogen atom, $-R^a$, $-OR^b$, or -CN.

More specifically, $R^{19}$ and $R^{21}$ are preferably a hydrogen atom or $-R^a$.

Furthermore, $R^{20}$ and $R^{22}$ are preferably a hydrogen atom, $-R^a$, $-OR^b$, or -CN.

$-R^a$ represented by $R^{19}$ to $R^{22}$ is preferably an alkyl group or an alkenyl group.

In a case where all of $R^{19}$ to $R^{22}$ are $-R^a$, it is preferable that $R^{19}$ and $R^{20}$ and $R^{21}$ and $R^{22}$ be linked to each other to form a monocyclic or polycyclic ring.

Examples of the ring formed of $R^{19}$ and $R^{20}$ or $R^{21}$ and $R^{22}$ linked to each other include a benzene ring, a naphthalene ring, and the like.

$R^{23}$ and $R^{24}$ in Formula 1-2 are preferably linked to each other to form a monocyclic or polycyclic ring.

The ring formed of $R^{23}$ and $R^{24}$ linked to each other may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring.

$R^{d1}$ to $R^{d4}$ in Formula 1-2 are preferably an unsubstituted alkyl group. Furthermore, all of $R^{d1}$ to $R^{d4}$ are preferably

the same group.

Examples of the unsubstituted alkyl group include unsubstituted alkyl groups having 1 to 4 carbon atoms. Among these, a methyl group is preferable.

From the viewpoint of improving water solubility of the compound represented by Formula 1-2, $W^1$ and $W^2$ in Formula 1-2 preferably each independently represent a substituted alkyl group.

Examples of the substituted alkyl group represented by $W^1$ and $W^2$ include a group represented by any of Formula (a1) to Formula (a4) in Formula 1-1, and preferred aspects thereof are also the same.

From the viewpoint of on-press developability, $W^1$ and $W^2$ preferably each independently represent an alkyl group having a substituent. The alkyl group preferably has at least $-OCH_2CH_2-$, a sulfo group, a salt of a sulfo group, a carboxy group, or a salt of a carboxy group, as the substituent.

Za represents a counterion that neutralizes charge in the molecule.

In a case where all of $R^{19}$ to $R^{22}$, $R^{23}$ and $R^{24}$, $R^{d1}$ to $R^{d4}$, $W^1$, $W^2$, and $R^1$-L are groups having a neutral charge, Za is a monovalent counteranion. Here, $R^{19}$ to $R^{22}$, $R^{23}$ and $R^{24}$, $R^{d1}$ to $R^{d4}$, $W^1$, $W^2$, and $R^1$-L may have an anion structure or a cation structure. For example, in a case where two or more among $R^{19}$ to $R^{22}$, $R^{23}$ and $R^{24}$, $R^{d1}$ to $R^{d4}$, $W^1$, $W^2$, and $R^1$-L have an anion structure, Za can be a countercation.

In a case where the compound represented by Formula 1-2 has such a structure that the overall charge of the compound is neutral except for Za, Za is unnecessary.

Examples of the case where Za is a counteranion are the same as such examples of Za in Formula 1-1, and preferred aspects thereof are also the same. Furthermore, examples of the case where Za is a countercation are the same as such examples of Za in Formula 1-1, and preferred aspects thereof are also the same.

From the viewpoint of decomposition properties and visibility, the cyanine dye as a decomposable compound is even more preferably a compound represented by any of Formula 1-3 to Formula 1-7.

Particularly, from the viewpoint of decomposition properties and visibility, the cyanine dye is preferably a compound represented by any of Formula 1-3, Formula 1-5, and Formula 1-6.

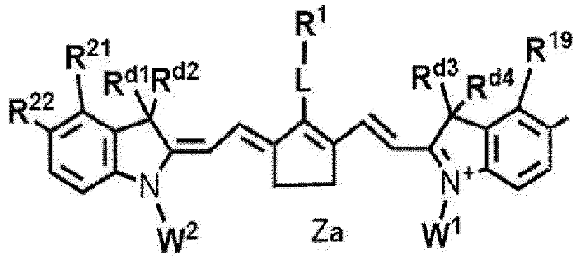
Formula 1-3

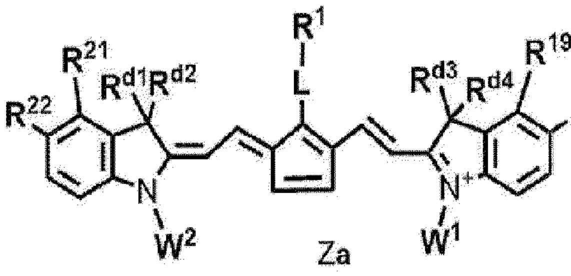
Formula 1-4

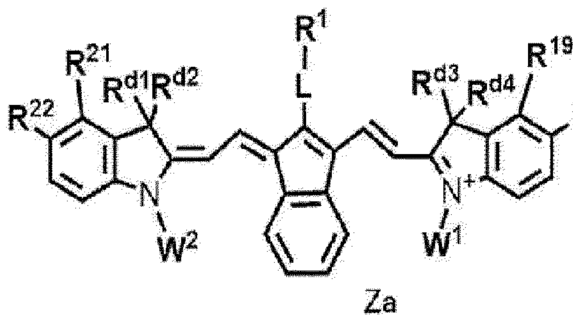
Formula 1-5

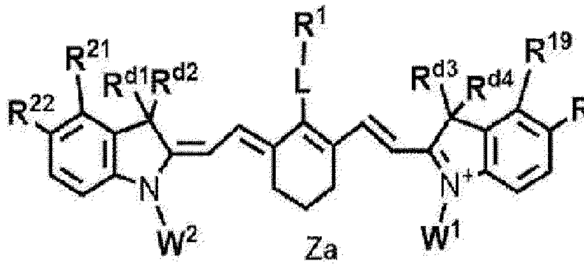

Formula 1-6

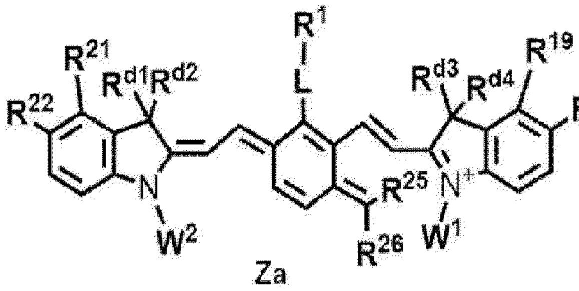

Formula 1-7

In Formula 1-3 to Formula 1-7, $R^1$ represents a group that is represented by any of Formula 2-1 to Formula 4-1, $R^{19}$ to $R^{22}$ each independently represent a hydrogen atom, a halogen atom, $-R^a$, $-OR^b$, -CN, $-SR^c$, or $-NR^dR^e$, $R^{25}$ and $R^{26}$ each independently represent a hydrogen atom, a halogen atom, or $-R^a$, $R^a$ to $R^e$ each independently represent a hydrocarbon group, $R^{19}$ and $R^{20}$, $R^{21}$ and $R^{22}$, or $R^{25}$ and $R^{26}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$, $R^{19}$ to $R^{22}$, $R^{d1}$ to $R^{d4}$, $W^1$, $W^2$, and L in Formula 1-3 to Formula 1-7 have the same definitions as $R^1$, $R^{19}$ to $R^{22}$, $R^{d1}$ to $R^{d4}$, $W^1$, $W^2$, and L in Formula 1-2, and preferred aspects thereof are also the same.

$R^{25}$ and $R^{26}$ in Formula 1-7 preferably each independently represent a hydrogen atom or an alkyl group, more preferably each independently represent an alkyl group, and particularly preferably each independently represent a methyl group.

Specific examples of the cyanine dye as a decomposable compound will be shown below. However, it is not limited thereto.

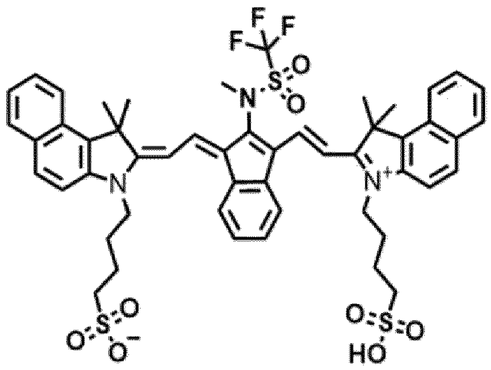

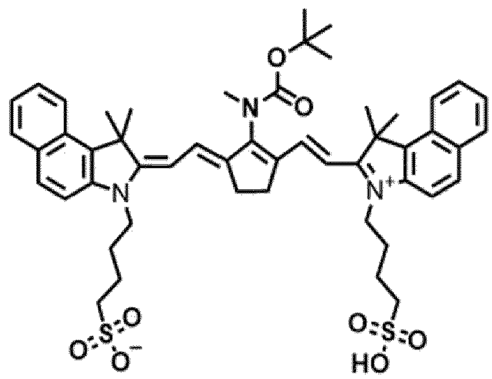

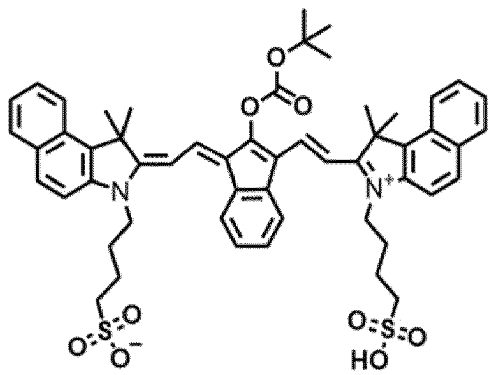

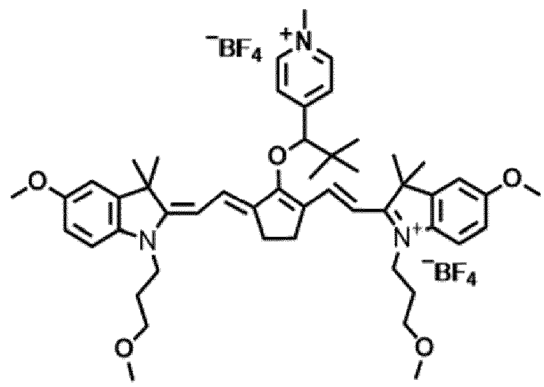

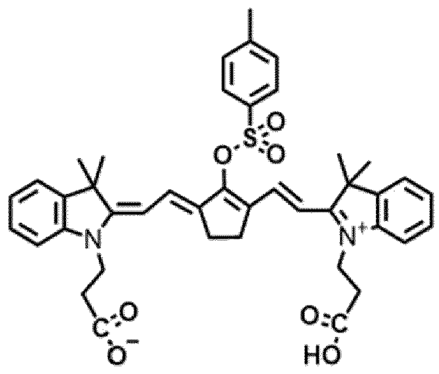

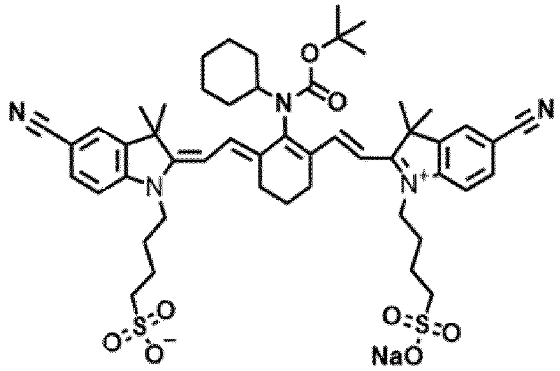

Furthermore, as the cyanine dye which is a decomposable compound, the infrared absorbing compound described in WO2019/219560A can be suitably used.

The discoloring compound may include an acid color developing agent.

As the acid color developing agent, it is possible to use the compounds described above as acid color developing agents in the image-recording layer, and preferred aspects thereof are also the same.

One kind of discoloring compound may be used alone, or two or more kinds of components may be combined and used as the discoloring compound.

As the discoloring compound, the decomposable compound described above and the acid generator that will be described later may be used in combination.

From the viewpoint of visibility, the content of the discoloring compound in the outermost layer with respect to the total mass of the outermost layer is preferably 0.10% by mass to 50% by mass, more preferably 0.50% by mass to 30% by mass, and even more preferably 1.0% by mass to 20% by mass.

From the viewpoint of visibility, $M^X/M^Y$ which is a ratio of a content $M^X$ of the discoloring compound in the outermost layer to a content $M^Y$ of the infrared absorber in the image-recording layer is preferably 0.1 or more, more preferably 0.2 or more, and particularly preferably 0.3 or more and 3.0 or less.

-Water-soluble polymer-

From the viewpoint of development removability (more preferably on-press developability), the outermost layer preferably contains a water-soluble polymer.

Herein, a water-soluble polymer refers to a polymer that dissolves 1 g or more in 100 g of pure water at 70°C and is not precipitated even though a solution of 1 g of the polymer in 100 g of pure water at 70°C is cooled to 25°C.

Examples of the water-soluble polymer used in the outermost layer include polyvinyl alcohol, modified polyvinyl alcohol, polyvinylpyrrolidone, a water-soluble cellulose derivative, polyethylene glycol, poly(meth)acrylonitrile, and the like.

As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.

Preferred examples of the water-soluble polymer include polyvinyl alcohol. Particularly, as the water-soluble

polymer to be used, polyvinyl alcohol having a saponification degree of 50% or more is more preferable.

The saponification degree is preferably 60% or higher, more preferably 70% or higher, and even more preferably 85% or higher. The upper limit thereof of the saponification degree is not particularly limited, and may be 100% or less.

The saponification degree is measured according to the method described in JIS K 6726: 1994.

Preferred examples of the water-soluble polymer also include polyvinylpyrrolidone.

As the water-soluble polymer, it is also preferable to use polyvinyl alcohol and polyvinylpyrrolidone in combination.

One kind of water-soluble polymer may be used alone, or two or more kinds of water-soluble polymers may be used in combination.

**In** a case where the outermost layer contains a water-soluble polymer, the content of the water-soluble polymer with respect to the total mass of the outermost layer is preferably 1% by mass to 99% by mass, more preferably 3% by mass to 97% by mass, and even more preferably 5% by mass to 95% by mass.

-Other components-

The outermost layer may contain other components such as a hydrophobic polymer, an oil sensitizing agent, an acid generator, and an infrared absorber, in addition to the discoloring compound and water-soluble polymer described above.

Hereinafter, those other components will be described.

<<Hydrophobic polymer>>

The outermost layer preferably contains a hydrophobic polymer.

The hydrophobic polymer refers to a polymer that dissolves less than 1 g or does not dissolve in 100 g of pure water at 70°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these polymers, and the like.

The hydrophobic polymer preferably includes a polyvinylidene chloride resin.

Furthermore, the hydrophobic polymer preferably includes a styrene-acrylic copolymer.

**In** addition, from the viewpoint of on-press developability, the hydrophobic polymer is preferably hydrophobic polymer particles.

One kind of hydrophobic polymer may be used alone, or two or more kinds of hydrophobic polymers may be used in combination.

**In** a case where the outermost layer contains a hydrophobic polymer, the content of the hydrophobic polymer with respect to the total mass of the outermost layer is preferably 1% by mass to 80% by mass, and more preferably 5% by mass to 50% by mass.

<<Acid generator>>

**In** a case where an acid color developing agent is used as a discoloring compound, the outermost layer preferably contains an acid generator.

"Acid generator" is a compound that generates an acid by light or heat. Specifically, the acid generator refers to a compound that generates an acid by being decomposed by exposure to infrared.

The acid to be generated is preferably a strong acid having a pKa of 2 or less, such as sulfonic acid or hydrochloric acid. The acid generated from the acid generator enables the acid color developing agent to discolor.

Specifically, as the acid generator, from the viewpoint of sensitivity and stability, an onium salt compound is preferable.

Specific examples of onium salts suitable as the acid generator include the compounds described in paragraphs "0121" to "0124" of WO2016/047392A.

Particularly, sulfonate, carboxylate, $BPh_4^-$, $BF_4^-$, $PF_6^-$, $ClO_4^-$ of triarylsulfonium or diaryliodonium, and the like are preferable. Ph represents a phenyl group.

One kind of acid generator may be used alone, or two or more kinds of acid generators may be used in combination.

In a case where the outermost layer contains an acid generator, the content of the acid generator with respect to the total mass of the outermost layer is preferably 0.5% by mass to 30% by mass, and more preferably 1% by mass to 20% by mass.

The outermost layer may contain known additives such as an oil sensitizing agent, an inorganic lamellar

compound, and a surfactant, in addition to the components described above.

The outermost layer is formed by coating by a known method and drying.

The coating amount of the outermost layer (solid content) is preferably 0.01 $g/m^2$ to 10 $g/m^2$, more preferably 0.02 $g/m^2$ to 3 $g/m^2$, and particularly preferably 0.1 $g/m^2$ to 2.0 $g/m^2$.

The film thickness of the outermost layer is preferably 0.1 μm to 5.0 μm, and more preferably 0.3 μm to 4.0 μm.

The film thickness of the outermost layer is preferably 0.1 times to 5.0 times the film thickness of the image-recording layer that will be described later, and more preferably 0.2 times to 3.0 times the film thickness of the image-recording layer that will be described later.

The outermost layer may contain known additives such as a plasticizer for imparting flexibility, a surfactant for improving coating properties, and inorganic particles for controlling surface sliding properties.

<Undercoat layer>

The lithographic printing plate precursor preferably has an undercoat layer (also called interlayer in some cases) between the image-recording layer and the aluminum support. The undercoat layer enhances the adhesion between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. **In** order to improve adhesiveness to the image-recording layer, polymers having adsorbent groups and hydrophilic groups plus crosslinking groups are preferable. The compounds that are used in the undercoat layer may be low-molecular-weight compounds or polymers. As necessary, as the compounds that are used in the undercoat layer, two or more kinds of compounds may be used by being mixed together.

**In** a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

-Hydrophilic compound-

From the viewpoint of developability, it is preferable that the undercoat layer contain a hydrophilic compound.

The hydrophilic compound is not particularly limited, and known hydrophilic compounds used for the undercoat layer can be used.

Preferred examples of the hydrophilic compound include phosphonic acids having an amino group such as carboxymethyl cellulose and dextrin, an organic phosphonic acid, an organic phosphoric acid, an organic phosphinic acid, amino acids, a hydrochloride of an amine having a hydroxy group, and the like.

In addition, examples of preferable hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of scratch and contamination suppressiveness, it is preferable that the hydrophilic compound include hydroxycarboxylic acid or a salt thereof.

Furthermore, from the viewpoint of scratch and contamination suppressiveness, it is preferable that the hydrophilic compound, which is preferably hydroxycarboxylic acid or a salt thereof, be contained in a layer on the aluminum support. The layer on the aluminum support is preferably a layer on the side where the image-recording layer is formed or a layer in contact with the aluminum support.

Preferred examples of the layer on the aluminum support include a layer in contact with the aluminum support, such as the undercoat layer or the image-recording layer. Furthermore, a layer other than the layer in contact with the aluminum support, for example, the protective layer or the image-recording layer may contain a hydrophilic compound and preferably contains hydroxycarboxylic acid or a salt thereof.

In the lithographic printing plate precursor, from the viewpoint of scratch and contamination suppressiveness, it is preferable that the image-recording layer contain hydroxycarboxylic acid or a salt thereof.

Moreover, regarding the lithographic printing plate precursor , for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer on the side of the image-recording layer that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method, which result in excellent scratch and contamination suppressiveness.

"Hydroxycarboxylic acid" is the generic term for organic compounds having one or more carboxy groups and one or more hydroxy groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represent a hydrogen atom, an alkali metal, or an onium, and mhc and nhc each independently represent an integer of 1 or more. In a case where n is 2 or more, Ms may be **the same** as or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like. Examples of the substituent include an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a

phenoxycarbonylphenyl group, and the like. Furthermore, the linking group is composed of at least one atom selected from the group consisting of a hydrogen atom, a carbon atom, an oxygen atom, a nitrogen atom, a sulfur atom, and a halogen atom, and the number of atoms is preferably 1 to 50. Specific examples thereof include an alkylene group, a substituted alkylene group, an arylene group, a substituted arylene group, and the like. The linking group may have a structure in which a plurality of these divalent groups is linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable. Examples of the onium include ammonium, phosphonium, sulfonium, and the like. Among these, ammonium is particularly preferable.

From the viewpoint of scratch and contamination suppressiveness, $M^{HC}$ is preferably an alkali metal or an onium, and more preferably an alkali metal.

The sum of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the hydroxycarboxylic acid include gluconic acid, glycolic acid, lactic acid, tartronic acid, hydroxybutyrate (such as 2-hydroxybutyrate, 3-hydroxybutyrate, or γ-hydroxybutyrate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of scratch and contamination suppressiveness, a compound having two or more hydroxy groups is preferable, a compound having 3 or more hydroxy groups is more preferable, a compound having 5 or more hydroxy groups is even more preferable, and a compound having 5 to 8 hydroxy groups is particularly preferable.

Furthermore, as a hydroxycarboxylic acid having one carboxy group and two or more hydroxy groups, gluconic acid or shikimic acid is preferable.

As hydroxycarboxylic acid having two or more carboxy groups and one hydroxy group, citric acid or malic acid is preferable.

As hydroxycarboxylic acid having two or more carboxy groups and two or more hydroxy groups, tartaric acid is preferable.

Among these, gluconic acid is particularly preferable as the aforementioned hydroxycarboxylic acid.

One kind of hydrophilic compound may be used alone, or two or more kinds of hydrophilic compounds may be used in combination.

In a case where the undercoat layer contains a hydrophilic compound, which is preferably hydroxycarboxylic acid or a salt thereof, the content of the hydrophilic compound, which is preferably hydroxycarboxylic acid or a salt thereof, with respect to the total mass of the undercoat layer is preferably 0.01% by mass to 50% by mass, more preferably 0.1% by mass to 40% by mass, and particularly preferably 1.0% by mass to 30% by mass.

In order to prevent contamination over time, the undercoat layer may contain a chelating agent, a secondary or tertiary amine, a polymerization inhibitor, and the like, in addition to the following compounds for an undercoat layer.

The undercoat layer is formed by known coating methods.

The coating amount (solid content) of the undercoat layer is preferably 0.1 $mg/m^2$ to 300 $mg/m^2$, and more preferably 5 $mg/m^2$ to 200 $mg/m^2$.

The lithographic printing plate precursor may have other layers in addition to those described above.

Known layers can be adopted as those other layers without particular limitations. For example, as necessary, a backcoat layer may be provided on a surface of the support that is opposite to the image-recording layer side.

(Method of preparing lithographic printing plate and lithographic printing method)

The method of preparing a lithographic printing plate according to the present invention includes a step of exposing the lithographic printing plate precursor according to the invention in the shape of an image (exposure step) and a step of removing the image-recording layer in a non-image area by supplying at least one material selected from the group consisting of a printing ink and dampening water to the lithographic printing plate precursor having undergone exposure on a printer (on-press development step).

The lithographic printing method according to the present invention preferably includes a step of exposing the

lithographic printing plate precursor according to the present disclosure in the shape of an image (exposure step), a step of removing the image-recording layer in a non-image area by supplying at least one material selected from the group consisting of a printing ink and dampening water on a printer such that a lithographic printing plate is prepared (on-press development step), and a step of performing printing by using the obtained lithographic printing plate (hereinafter, also called "printing step").

<Exposure step>

The method of preparing a lithographic printing plate according to the present invention includes an exposure step of exposing the lithographic printing plate precursor according to the invention in the shape of an image such that an exposed portion and a non-exposed portion are formed. The lithographic printing plate precursor according to the invention is preferably exposed to a laser through a transparent original picture having a linear image, a halftone dot image, or the like or exposed in the shape of an image by laser light scanning according to digital data or the like.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method of preparing a lithographic printing plate according to the invention includes an on-press development step of removing the image-recording layer in a non-image area by supplying at least one selected from the group consisting of printing ink and dampening water on a printer.

Hereinafter, the on-press development method will be described.

[On-press development method]

In the on-press development method, the lithographic printing plate precursor having undergone image exposure is preferably supplied with an oil-based ink and an aqueous component on a printer, such that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic surface. What is supplied first to the surface of the plate may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

As the laser used for performing image exposure on the lithographic printing plate precursor, a light source having a wavelength of 750 nm to 1,400 nm is preferably used. As the light source having a wavelength of 750 nm to 1,400 nm, the light sources described above are preferably used.

<Printing step>

The lithographic printing method includes a printing step of printing a recording medium by supplying a printing ink to the lithographic printing plate.

The printing ink is not particularly limited, and various known inks can be used as desired. In addition, preferred examples of the printing ink include oil-based ink or ultraviolet-curable ink (UV ink).

In the printing step, as necessary, dampening water may be supplied.

Furthermore, the printing step may be successively carried out after the on-press development step or the development step using a developer, without stopping the printer.

The recording medium is not particularly limited, and known recording media can be used as desired.

In the method of preparing a lithographic printing plate from the lithographic printing plate precursor according to the invention and in the lithographic printing method, as necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Examples

Hereinafter, the present invention will be specifically described based on examples, but the present invention is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a polystyrene-equivalent molecular weight measured by gel permeation chromatography (GPC).

(Examples 1 to 19 and Comparative Examples 1 and 2)

<Preparation of supports of Examples 1 to 8 and Comparative Examples 1 and 2>

In Examples 1 to 8 and Comparative Examples 1 and 2, a surface was treated in the following sequence, and the concentration of the solution for electrochemical roughening and the alkaline etching amount after electrochemical roughening (including a case where no alkaline etching treatment was performed) were changed, thereby preparing each support.

-Alkaline etching treatment-

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 g/m$^2$.

-Desmutting treatment using aqueous acidic solution (first desmutting treatment)-

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1: 1, and the current density was 75 A/dm$^2$ in terms of the peak current value of the alternating current waveform. In addition, the quantity of electricity was 450 C/dm$^2$ which was the total quantity of electricity used for

the aluminum plate to have an anodic reaction, and the electrolysis treatment was performed 4 times by conducting electricity of 112.5 C/$dm^2$ for 4 seconds at each treatment session. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. Then, a rinsing treatment was performed.

-Desmutting treatment using aqueous acidic solution-

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 35°C.

-Anodization treatment-

By using the anodization device for direct current electrolysis, an anodization treatment was performed in a sulfuric acid solution.

<Preparation of supports of Examples 9 to 19>

In Examples 9 to 19, a surface was treated in the following sequence, and the concentration of the solution for electrochemical roughening and the alkaline etching amount after electrochemical roughening were changed, the voltage of the first-stage anodization treatment was controlled to change the pore density, and the alkaline etching amount after the first-stage anodization (including a case where no alkaline etching treatment was performed) was changed, thereby preparing each support.

(a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 g/$m^2$.

(b) Desmutting treatment using aqueous acidic solution (first desmutting treatment)

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

(c) Electrochemical roughening treatment

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1: 1, and the current density was 75 A/$dm^2$ in terms of the peak current value of the alternating current waveform. In addition, the quantity of electricity was 450 C/$dm^2$ which was the total quantity of electricity used for the aluminum plate to have an anodic reaction, and the electrolysis treatment was performed 4 times by conducting electricity of 112.5 C/$dm^2$ for 4 seconds at each treatment session. A carbon electrode was used as the counter electrode of the aluminum plate. Then, a rinsing treatment was performed.

(d) Alkaline etching treatment

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/$m^2$. Then, a rinsing treatment was performed.

(e) Desmutting treatment using aqueous acidic solution

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

(f) First-stage anodization treatment

By using the anodization treatment device 610 for direct current electrolysis having the structure shown in Fig. 5, a first-stage anodization treatment (also called first anodization treatment) was performed. Specifically, the first anodization treatment was performed under the conditions described in the column of "First anodization treatment" shown in the following Table 1, thereby forming an anodic oxide film having a predetermined film amount.
Hereinafter, the anodization treatment device 610 shown in Fig. 5 will be described.
In the anodization treatment device 610 shown in Fig. 5, an aluminum plate 616 is transported as indicated by the arrow in Fig. 5. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodization treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634.

(g) Pore widening treatment

Under the conditions shown in the following Table 1, the aluminum plate having undergone the above anodization treatment was immersed in an aqueous solution of caustic soda at a temperature of 40°C and having a caustic soda concentration of 5% by mass and an aluminum ion concentration of 0.5% by mass, thereby performing a pore widening treatment. Then, rinsing was performed by means of spraying.

(h) Second anodization treatment

By using the anodization treatment device 610 for direct current electrolysis having the structure shown in Fig. 5, a second-stage anodization treatment (also called second anodization treatment) was performed. Specifically, the second anodization treatment was performed under the conditions described in the column of "Second anodization treatment" shown in the following Table 1, thereby forming an anodic oxide film having a predetermined film amount.

By the above method, a support was prepared.

For the obtained support, Table 2 shows the brightness L* of the micropores within the surface of the anodic oxide film in the L*a*b* color system, the average diameter and depth of the large diameter portion of the micropores within the surface of the oxide film, the average diameter (nm) and depth of the small diameter portion of the micropores at a communicate position, the depth (nm) of the large diameter portion and the small diameter portion, the micropore density, and the thicknesses of the anodic oxide film (also called film thicknesses) from the bottom portion of the small diameter portion to the surface of the aluminum plate.
In Table 1, Film amount (AD) in the column of First anodization treatment and Film amount (AD) in the column of

Second anodization treatment represent the amount of film obtained by each treatment. As electrolytic solutions, the aqueous solutions containing the components in Table 1 were used.

[Table 1]

<table>
<tr><td rowspan="6">Support</td><td colspan="7">First anodization treatment</td></tr>
<tr><td>Liquid type</td><td>Liquid component</td><td>Liquid concentration (g/L)</td><td>Temperature (°C)</td><td>Current density (Å/dm$^2$)</td><td>Time (s)</td><td>Film amount (g/m$^2$)</td></tr>
<tr><td>Sulfuric acid</td><td>$H_2SO_4$</td><td>15</td><td>35</td><td>4.5</td><td>12</td><td>1</td></tr>
<tr><td colspan="4">Pore widening treatment</td><td colspan="3" rowspan="3"></td></tr>
<tr><td colspan="2">Liquid component</td><td>Temperature (°C)</td><td>Time (s)</td></tr>
<tr><td colspan="2">NaOH5%/A10.5%</td><td>40°C</td><td>3s</td></tr>
<tr><td rowspan="3"></td><td colspan="7">Second anodization treatment</td></tr>
<tr><td>Liquid type</td><td>Liquid component</td><td>Liquid concentration (g/L)</td><td>Temperature (°C)</td><td>Current density (Å/dm$^2$)</td><td>Time (s)</td><td>Film amount (g/m$^2$)</td></tr>
<tr><td>Sulfuric acid</td><td>$H_2SO_4$/Al</td><td>170/5</td><td>50</td><td>15</td><td>10.5</td><td>1.4</td></tr>
</table>

[Table 2]

| Support | Large diameter portion | | | | Small diameter portion | | | Micropore density (number/$\mu m^2$) | Film thickness (nm) | Brightness L* |
|---|---|---|---|---|---|---|---|---|---|---|
| | Average diameter (nm) | Average diameter of bottom portion (nm) | Shape | Depth (nm) | Average diameter at communicate position (nm) | Shape | Depth (nm) | | | |
| | 35 | 35 | Straight tubular | 100 | 10 | Straight tubular | 570 | 320 | 1,000 | 80 |

<Formation of undercoat layer>

The obtained support was coated with a coating liquid for an undercoat layer having the following composition such that the dry coating amount of 20 mg/m$^2$ was obtained, and the support was dried in an oven at 100°C for 30 seconds, thereby forming an undercoat layer.

-Composition of coating liquid for undercoat layer-

·Polymer (U-1) [the following structure]: 0.18 parts

·Hydroxyethyl iminodiacetic acid: 0.10 parts

·Water: 61.4 parts

(U-1)

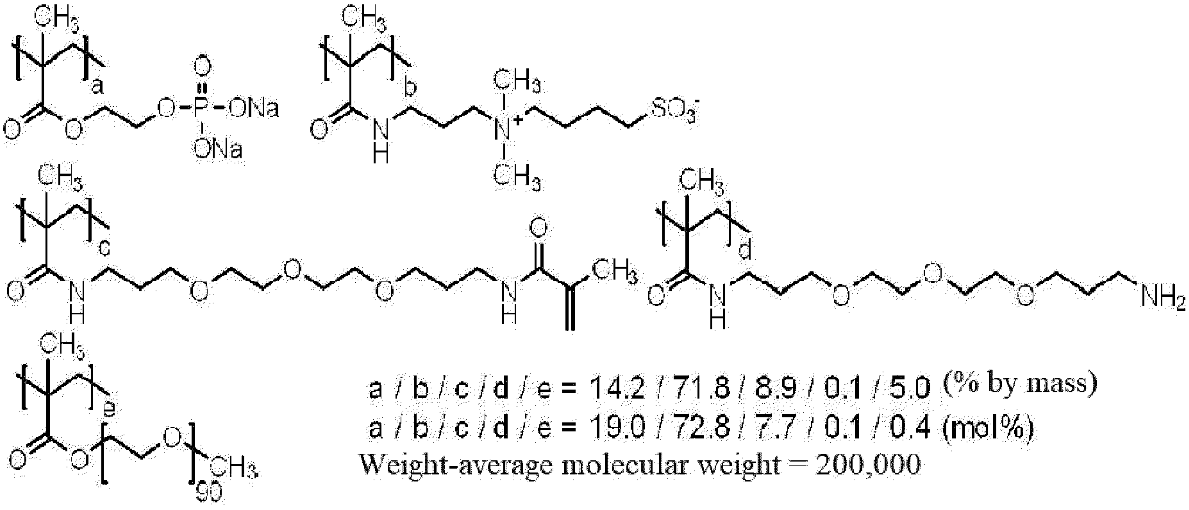

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Weight-average molecular weight = 200,000

-Synthesis of polymer (U-1)-

<<Purification of monomer M-1>>

LIGHT ESTER P-1M (2-methacryloyloxyethyl acid phosphate, manufactured by KYOEISHA CHEMICAL Co., LTD.) (420 parts), 1,050 parts of diethylene glycol dibutyl ether, and 1,050 parts of distilled water were added to a separating funnel, vigorously stirred, and then left to stand. The upper layer was discarded, 1,050 parts of diethylene glycol dibutyl ether was then added thereto, the solution was vigorously stirred, and then left to stand. The upper layer was discarded, thereby obtaining 1,300 parts of an aqueous solution of a monomer M-1 (10.5% by mass in terms of solid content).

<<Synthesis of polymer (U-1)>>

Distilled water (53.73 parts) and 3.66 parts of monomer M-2 were added to a three-neck flask, and heated to 55°C in a nitrogen atmosphere. Then, the following dripping liquid 1 was added dropwise thereto for 2 hours, the obtained solution was stirred for 30 minutes, and 0.386 parts of VA-046B (manufactured by FUJIFILM Wako Pure Chemical Corporation) was added thereto. The solution was heated to 80°C and stirred for 1.5 hours. The reaction solution was returned to room temperature (25°C), a 30% by mass aqueous sodium hydroxide solution was added thereto such that the pH was adjusted to 8.0, and then 0.005 parts of 4-hydroxy-2,2,6,6-tetramethylpiperidin-1-oxyl (4-OH-TEMPO) was added thereto. By the above operation, 180 parts of an aqueous solution of a polymer (U-1) was obtained. The polyethylene glycol-equivalent weight-average molecular weight (Mw) thereof that was measured by gel permeation chromatography (GPC) was 200,000.

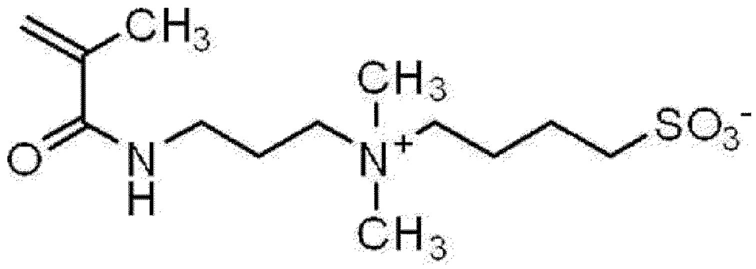

Monomer M-2

<<Composition of dripping liquid 1>>

- ·Aqueous solution of the monomer M-1: 87.59 parts
- ·The above monomer M-2: 14.63 parts
- ·VA-046B (2,2'-azobis[2-(2-imidazolin-2-yl)propane]disulfate dihydrate, manufactured by FUJIFILM Wako Pure Chemical Corporation): 0.386 parts
- ·Distilled water: 20.95 parts

<Formation of image-recording layer>

The undercoat layer was bar-coated with the coating liquid for an image-recording layer described in Table 3, followed by drying in an oven at 120°C for 40 seconds, thereby forming an image-recording layer having a dry coating amount of 1.0 g/m$^2$.

-Composition of coating liquid 1 for image-recording layer-

Electron-accepting polymerization initiator Int-1 (the following compound): 0.06 parts by mass

Polymethine colorant IR-11 (the following compound): 0.026 parts by mass
Electron-donating polymerization initiator TPB (Sodium tetraphenyl borate): 0.05 parts by mass
Polymerizable compound M-1 (the following compound): 0.25 parts by mass
Polymerizable compound M-2 (the following compound): 0.25 parts by mass
Binder polymer (S-LEC BL10, partially acetylated polyvinyl butyral): 0.15 parts by mass
Acid color developing agent S-3: 0.03 parts by mass

-Composition of coating liquid 2 for image-recording layer-

Electron-accepting polymerization initiator Int-1 (the following compound): 0.06 parts by mass
Polymethine colorant IR-11 (the following compound): 0.026 parts by mass
Polymerizable compound M-1 (the following compound): 0.25 parts by mass
Polymerizable compound M-2 (the following compound): 0.25 parts by mass
Binder polymer (S-LEC BL10, partially acetylated polyvinyl butyral): 0.15 parts by mass
Acid color developing agent S-3: 0.03 parts by mass

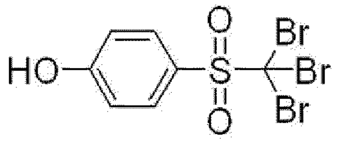

Int-1

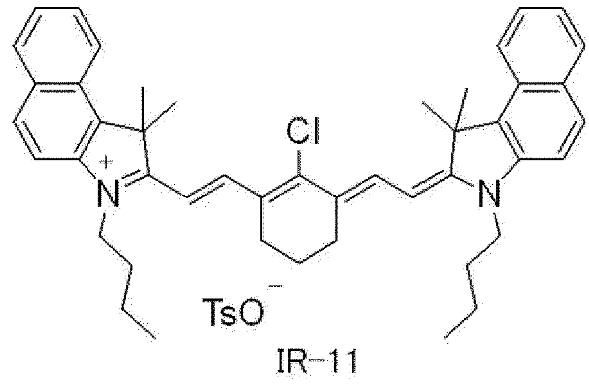

IR-11

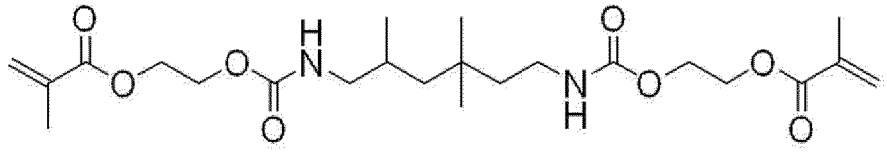

M - 1

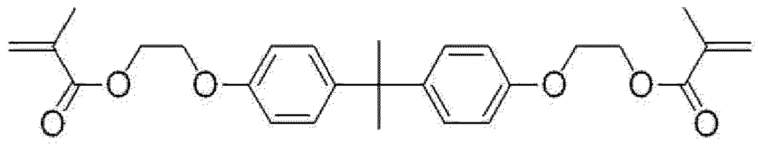

M - 2

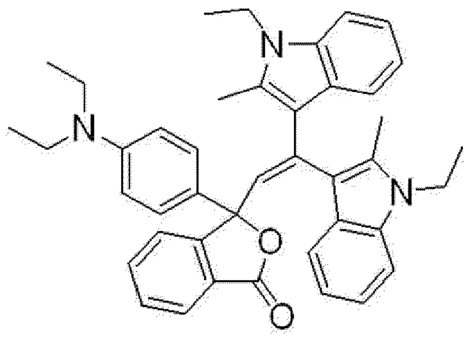

S - 3

<Formation of outermost layer>

The image-recording layer was bar-coated with a coating liquid for an outermost layer described in Table 3 and dried in an oven at 120°C for 60 seconds, thereby forming an outermost layer having a dry coating amount of 0.15 g/$m^2$.

-Composition of coating liquid 1 for outermost layer-

IR colorant IR-1 (the following compound): 0.02 parts by mass
Water-soluble polymer Mowiol 4-88 (polyvinyl alcohol (PVA), manufactured by Sigma-Aldrich Co. LLC.):0.7 parts by mass
Water-soluble polymer Mowiol 8-88 (polyvinyl alcohol (PVA), manufactured by Sigma-Aldrich Co. LLC.):0.2 parts by mass
Hydrophobic polymer P-1 (aqueous polyvinylidene chloride dispersion, Diofan (registered trademark) A50 manufactured by Solvin S.A.): 0.2 parts by mass

-Composition of coating liquid 2 for outermost layer-

Water-soluble polymer Mowiol 4-88 (polyvinyl alcohol (PVA), manufactured by Sigma-Aldrich Co. LLC.):0.7 parts by mass
Water-soluble polymer Mowiol 8-88 (polyvinyl alcohol (PVA), manufactured by Sigma-Aldrich Co. LLC.):0.2 parts by mass
Hydrophobic polymer P-1 (the following polymer): 0.2 parts by mass

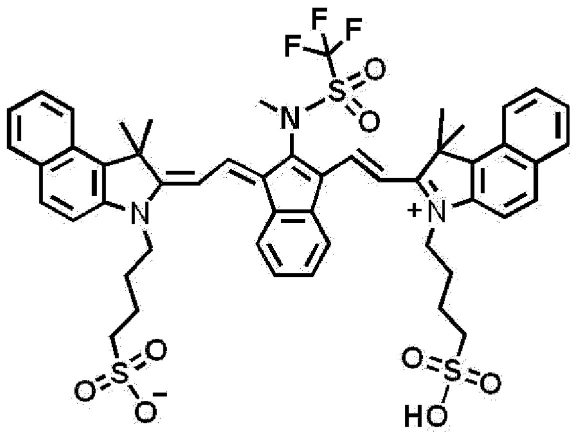

**IR - 1**

<Preparation of lithographic printing plate precursor>

As shown in Table 3, lithographic printing plate precursors of Examples 1 to 19 and Comparative Examples 1 and 2 were prepared according to the methods of forming each of the aluminum supports and layers as described above.

<Evaluation of lithographic printing plate precursor>

[Visibility]

In Trendsetter 3244VX manufactured by CREO CO., LTD. that was equipped with a water cooling-type 40 W infrared semiconductor laser, each of the obtained lithographic printing plate precursors was exposed under the conditions of an output of 11.5 W, an outer drum rotation speed of 220 rpm, and a resolution of 2,400 dpi. The exposure was carried out in an environment of 25°C and 50% RH.

For each of the lithographic printing plate precursor immediately after exposure (also called initial lithographic printing plate precursor) and the lithographic printing plate precursor stored for 3 days under the conditions of 25°C and 70% RH after exposure (also called lithographic printing plate precursor after a lapse of time), color development was measured. The measurement was performed by the specular component excluded (SCE) method by using a spectrocolorimeter CM2600d and operation software CM-S100W manufactured by Konica Minolt, Inc. The visibility (visibility of exposed portions) was evaluated by a difference ΔL' between an L* value of the exposed portion and an L* value of the non-exposed portion by using L* values (brightness) of the L*a*b* color system. The evaluation standard is shown below. It can be said that the higher the value of ΔL, the better the visibility.

A: ΔL is 4 or more.
B: ΔL is 2 or more and less than 4.
C: ΔL is less than 2.

[On-press developability]

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm, and a resolution of 2,400 dpi (dots per inch, 1 inch is equal to 2.54

cm) (irradiation energy equivalent to 110 mJ/cm$^2$). The exposure image included a solid image and an amplitude modulation screen (AM screen) as a 50% halftone dot chart.

The obtained exposed precursor was mounted on a Kikuban-sized cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were supplied by a standard automatic printing start method, and then printing was performed on 200 sheets of TOKUBISHI art paper (ream weight: 76.5 kg, manufactured by MITSUBISHI PAPER MILLS LIMITED.) at a printing rate of 10,000 sheets/hour.

During the on-press development described above, the number of printing papers used until no ink was transferred to a non-image area was measured (hereinafter, also called number of sheets of on-press development). The evaluation standard is shown below. It can be said that the smaller the number of sheets of on-press development, the better the on-press developability.

A: The number of sheets of on-press development is less than 20.
B: The number of sheets of on-press development is 20 or more and less than 40.
C: The number of sheets of on-press development is 40 or more.

[Contamination suppressiveness]

Printing was performed using the lithographic printing plate obtained in the evaluation of on-press developability described above, MITSUBISHI DIAMOND F2 printer (manufactured by Mitsubishi Heavy Industries, Ltd), and DIC-GEOS (s) red ink. After 10,000 sheets were printed, the contamination of the blanket was visually checked and evaluated according to the following standard.

A: The blanket is not contaminated.
B: Although the blanket is contaminated, the level of contamination is unproblematic for practical use.
C: The blanket is contaminated, and the printed matter is markedly contaminated.

[Printing durability of halftone dot portion of oil-based ink]

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm (revolutions per minute), and a resolution of 2,400 dpi (irradiation energy equivalent to 110 mJ/cm$^2$). The exposure image included a solid image and a 10% halftone dot chart of Amplitude Modulation Screen (AM screen).

The obtained exposed precursor was mounted on a Kikuban-sized cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and DIC Fusion Black H (oil-based ink, manufactured by DIC Corporation) was used as printing ink. The dampening water and ink were supplied by a standard automatic printing start method, and then printing was performed on 500 sheets of TOKUBISHI art paper (ream weight: 76.5 kg, manufactured by MITSUBISHI PAPER MILLS LIMITED.) at a printing rate of 10,000 sheets/hour.

Then, printing was performed further. As the number of printing sheets increased, the image area gradually wore out, and thus the ink density on the printed matter decreased. The area ratio of the 10% halftone dot AM screen in the printed matter was measured using a Gretag density meter (manufactured by GretagMacbeth). The number of printing sheets at a point in time when the measured area ratio was 3% lower than the area ratio measured after 500 sheets were printed was adopted as the number of sheets of completed printing and used for evaluation of printing durability.

[Printing durability of halftone dot portion of UV ink]

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm (revolutions per minute), and a resolution of 2,400 dpi (irradiation energy equivalent to 110 mJ/cm$^2$). The exposure image included a solid image and a 10% halftone dot chart of Amplitude Modulation Screen (AM screen).

The obtained exposed precursor was mounted on a Kikuban-sized cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (UV ink, manufactured by T&K TOKA CO., LTD.) was used as printing ink. The dampening water and ink were supplied by a standard automatic printing start method, and then printing was performed on 500 sheets of TOKUBISHI art paper (ream weight: 76.5 kg, manufactured by MITSUBISHI PAPER MILLS LIMITED.) at a printing rate of 10,000 sheets/hour.

Then, printing was performed further. As the number of printing sheets increased, the image area gradually wore out, and thus the ink density on the printed matter decreased. The area ratio of the 10% halftone dot AM screen in the printed matter was measured using a Gretag density meter (manufactured by GretagMacbeth). The number of printing sheets at a point in time when the measured area ratio was 3% lower than the area ratio measured after 500 sheets were printed was adopted as the number of sheets of completed printing and used for evaluation of printing durability.

[Table 3]

| | Physical properties of aluminum support | | | | | | | | Coating liquid for image-recording layer | Coating liquid for outermost layer | Evaluation result | | | | |
|---|---|---|---|---|---|---|---|---|---|---|---|---|---|---|---|
| | Steepness a45 of component having wavelength of 0.2 μm to 2 μm (%) | Brightness $L^*$ | Specific surface area ΔS (%) | Density of recess portions having depth of 0.7 μm or more (number of recess portions/400 $\mu m^2$) | Opening ratio by micropores (%) | Pore density (number of pores/$\mu m^2$) | Pore depth of large diameter portion (nm) | Pore diameter within surfaces (nm) | | | Visibility | Contamination suppressiveness | On-press developability | Printing durability of halftone dot portion of oil-based ink (10,000 sheets) | Printing durability of halftone dot portion of UV ink (10,000 sheets) |
| Example 1 | 13 | 79 | 37 | 370 | 14 | 380 | - | 12 | 1 | 1 | A | A | A | 4.5 | 3.6 |
| Example 2 | 21 | 77 | 44 | 360 | 14 | 380 | - | 12 | 1 | 1 | A | B | B | 4.9 | 3.7 |
| Example 3 | 27 | 73 | 48 | 370 | 14 | 380 | - | 12 | 1 | 1 | B | B | B | 5.2 | 3.8 |
| Example 4 | 8 | 85 | 35 | 350 | 14 | 380 | - | 12 | 1 | 1 | A | A | A | 4.0 | 3.5 |
| Example 5 | 25 | 76 | 43 | 350 | 14 | 380 | - | 12 | 1 | 1 | B | B | B | 5.0 | 3.8 |
| Example 6 | 29 | 70 | 53 | 360 | 14 | 380 | - | 12 | 1 | 1 | B | B | B | 5.8 | 4.0 |
| Example 7 | 16 | 80 | 38 | 760 | 14 | 380 | - | 12 | 1 | 1 | A | A | A | 5.5 | 4.4 |
| Example 8 | 18 | 81 | 37 | 870 | 14 | 380 | - | 12 | 1 | 1 | A | A | A | 5.7 | 4.7 |
| Example 9 | 13 | 79 | 37 | 370 | 17 | 380 | 100 | 14 | 1 | 1 | A | A | A | 4.6 | 3.8 |
| Example 10 | 13 | 79 | 37 | 370 | 36 | 380 | 100 | 21 | 1 | 1 | A | A | A | 5.3 | 4.5 |
| Example 11 | 13 | 79 | 37 | 370 | 53 | 380 | 100 | 32 | 1 | 1 | A | A | A | 5.5 | 5.2 |
| Example 12 | 13 | 79 | 37 | 370 | 66 | 380 | 100 | 37 | 1 | 1 | A | A | A | 5.7 | 5.4 |
| Example 13 | 13 | 79 | 37 | 370 | 78 | 380 | 100 | 43 | 1 | 1 | A | A | A | 6.1 | 5.9 |
| Example 14 | 13 | 79 | 37 | 370 | 53 | 690 | 100 | 35 | 1 | 1 | A | A | A | 5.7 | 5.6 |
| Example 15 | 13 | 79 | 37 | 370 | 55 | 1050 | 100 | 29 | 1 | 1 | A | A | A | 5.8 | 5.7 |
| Example 16 | 13 | 79 | 37 | 370 | 52 | 1800 | 100 | 21 | 1 | 1 | A | A | A | 5.9 | 5.8 |
| Example 17 | 13 | 79 | 37 | 370 | 53 | 380 | 160 | 32 | 1 | 1 | A | A | A | 5.8 | 5.4 |
| Example 18 | 13 | 79 | 37 | 370 | 53 | 380 | 320 | 32 | 1 | 1 | A | A | A | 6.0 | 6.0 |
| Example 19 | 13 | 79 | 37 | 370 | 53 | 380 | 570 | 32 | 2 | 1 | B | A | A | 6.2 | 6.3 |
| Comparative Example 1 | 13 | 79 | 37 | 650 | 56 | 380 | - | 12 | 1 | 2 | C | A | B | 4.3 | 3.0 |
| Comparative Example 2 | 37 | 72 | 51 | 500 | 41 | 380 | - | 12 | 1 | 1 | B | C | C | 5.7 | 4.2 |

The values of various physical properties of the aluminum support on Table 3, such as the steepness a45, are values measured by the measuring method described above.

As is evident from the results shown in Table 3, it has been revealed that compared to the lithographic printing plate precursors according to comparative examples, the lithographic printing plate precursors according to examples are better in visibility and contamination suppressiveness. In addition, it has been revealed that the lithographic printing plate precursor according to the present invention is also excellent in on-press developability, and the lithographic printing plate obtained from the precursor is also excellent in the printing durability of the halftone dot portion of an oil-based ink and the printing durability of the halftone dot portion of a UV ink.

Explanation of References

ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate
12a, 12b: aluminum support
14: undercoat layer
16: image-recording layer
18: aluminum plate
20a, 20b: anodic oxide film
22a, 22b: micropore
24: large diameter portion
26: small diameter portion
D: depth of large diameter portion
50: main electrolytic cell
51: alternating current power source
52: radial drum roller
53a, 53b: main pole
54: electrolytic solution supply port
55: electrolytic solution
56: auxiliary anode
60: auxiliary anode tank
W: aluminum plate
S: solution supply direction
Ex: electrolytic solution discharge direction
610: anodization treatment device
612: power supply tank
614: electrolytic treatment tank
616: aluminum plate
618, 26: electrolytic solution
620: power supply electrode
622, 628: roller
624: nip roller
630: electrolysis electrode
632: cell wall
634: direct current power source

**Claims**

1. An on-press development type lithographic printing plate precursor comprising, in the following order:

an aluminum support;

an image-recording layer; and
an outermost layer,
wherein the image-recording layer contains an infrared absorber, a polymerization initiator, and a polymerizable compound,
the aluminum support has an aluminum plate and an anodic oxide film of aluminum disposed on the aluminum plate,
a steepness a45 that represents an area ratio of a portion where a component having a wavelength of 0.2 μm to 2 μm has an inclination of 45° or more within a surface of the anodic oxide film on a side of the image-recording layer is 30% or less,
the outermost layer contains a discoloring compound, wherein the discoloring compound is a compound which undergoes change in absorption in the visible light region which has a wavelength of 400 nm or more and less than 750 nm, due to the exposure to infrared, wherein infrared has a wavelength of 750 nm to 1 mm; and

a density of recess portions having a depth of 0.7 μm or more from a centerline in a roughness curve, the density being obtained by measuring a 400 μm × 400 μm region of a surface of the aluminum support on a side of the image-recording layer by using a non-contact three-dimensional roughness meter, is 300 or more.

**2.** The on-press development type lithographic printing plate precursor according to claim 1,
wherein in a L*a*b* color system, a value of brightness L* of the surface of the anodic oxide film on the side of the image-recording layer is 70 to 90.

**3.** The on-press development type lithographic printing plate precursor according to claim 1 or 2,
wherein in a case where $S_X$ represents an actual area obtained by an approximate three-point method from three-dimensional data obtained by measuring 512 × 512 points in a 25 μm × 25 μm region within the surface of the anodic oxide film on the side of the image-recording layer by using an atomic force microscope, and $S_0$ represents a geometrically measured area, a specific surface area ΔS which is a value calculated by Equation (i) is 25% or more,

$$\Delta S = (S_X - S_0)/S_0 \times 100\ (\%) \cdots (i).$$

**4.** The on-press development type lithographic printing plate precursor according to any one of claims 1 to 3,

wherein the anodic oxide film has micropores extending in a depth direction from the surface on the side of the image-recording layer, and
an opening ratio by the micropores is 20% to 80% with respect to a total area of the anodic oxide film.

**5.** The on-press development type lithographic printing plate precursor according to claim 4,

wherein the micropores are each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position,
an average diameter of the large diameter portion within the surface of the anodic oxide film is 15 nm to 100 nm, and
an average diameter of the small diameter portion at the communicate position is 13 nm or less.

**6.** The on-press development type lithographic printing plate precursor according to any one of claims 1 to 5,
wherein the discoloring compound includes a compound that develops color due to exposure to infrared.

**7.** The on-press development type lithographic printing plate precursor according to any one of claims 1 to 6,
wherein the discoloring compound includes a decomposable compound that decomposes due to exposure to infrared.

**8.** The on-press development type lithographic printing plate precursor according to any one of claims 1 to 7,
wherein the discoloring compound is a cyanine dye.

**9.** The on-press development type lithographic printing plate precursor according to any one of claims 1 to 8,

wherein the discoloring compound is a compound represented by Formula 1-1,

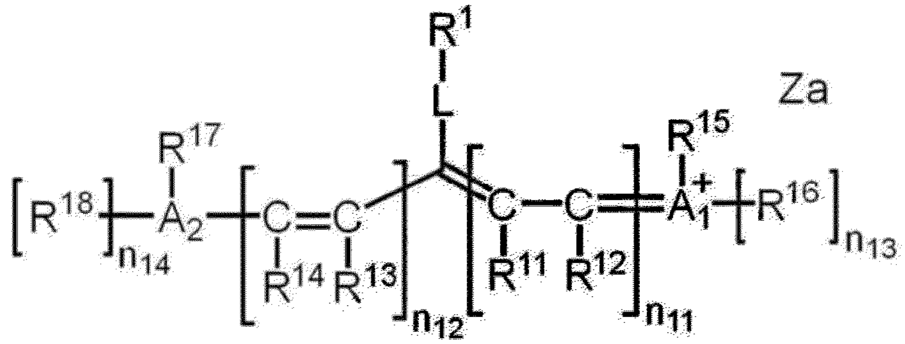

Formula 1-1

in Formula 1-1, $R^1$ represents a group that is represented by any of Formula 2-1 to Formula 4-1, $R^{11}$ to $R^{18}$ each independently represent a hydrogen atom, a halogen atom, $-R^a$, - $OR^b$, $-SR^c$, or $-NR^dR^e$, $R^a$ to $R^e$ each independently represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, a sum of $n_{11}$ and $n_{12}$ is 2 or more, $n_{13}$ and $n_{14}$ each independently represent 0 or 1, L represents an oxygen atom, a sulfur atom, or - $N(R^{10})$-, $R^{10}$ represents a hydrogen atom, an alkyl group, or an aryl group, and Za represents a counterion that neutralizes charge,

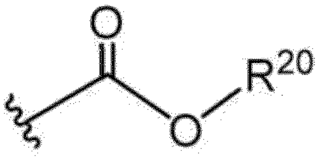

Formula 2-1

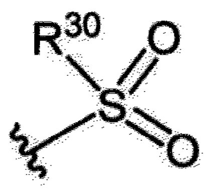

Formula 3-1

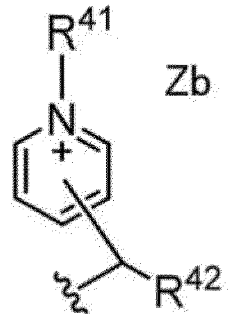

Formula 4-1

in Formula 2-1 to Formula 4-1, $R^{20}$, $R^{30}$, $R^{41}$, and $R^{42}$ each independently represent an alkyl group or an aryl group, Zb represents a counterion that neutralizes charge, and a wavy line represents a bonding site with a group represented by L in Formula 1-1.

**10.** The on-press development type lithographic printing plate precursor according to claim 9,

wherein the discoloring compound is a compound represented by Formula 1-2, or a compound represented by any of Formula 1-3 to 1-7

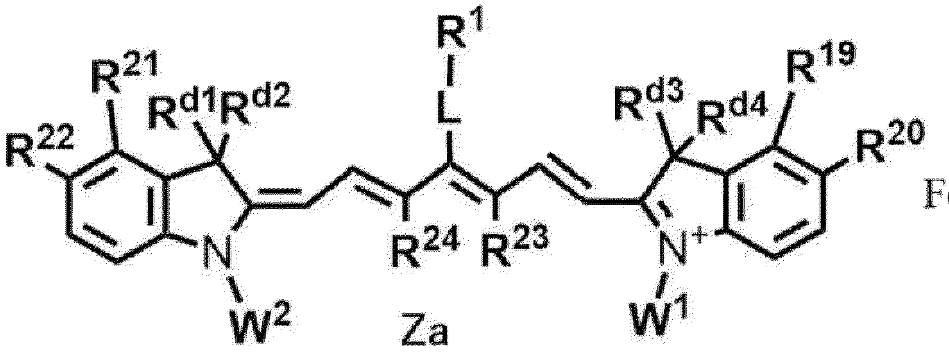

Formula 1-2

in Formula 1-2, $R^1$ represents a group that is represented by any of Formula 2-1 to Formula 4-1, $R^{19}$ to $R^{22}$ each

independently represent a hydrogen atom, a halogen atom, $-R^a$, $-OR^b$, -CN, $-SR^c$, or $-NR^dR^e$, $R^{23}$ and $R^{24}$ each independently represent $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-N(R^{10})-$, $R^{10}$ represents a hydrogen atom, an alkyl group, or an aryl group, $R^{d1}$ to $R^{d4}$ each independently represent an alkyl group which may have a substituent, $W^1$ and $W^2$ each independently represent an alkyl group having a substituent and have at least $-OCH_2CH_2-$, a sulfo group, a salt of a sulfo group, a carboxy group, or a salt of a carboxy group as the substituent, and Za represents a counterion that neutralizes charge,

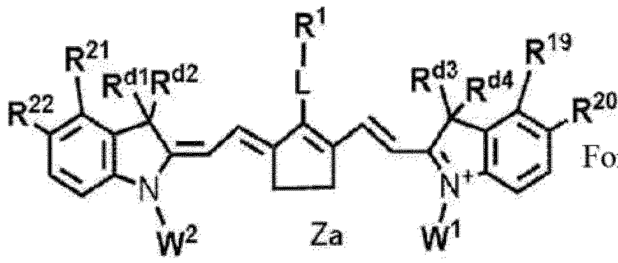

Formula 1-3

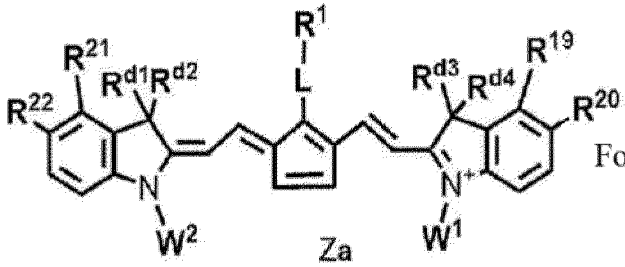

Formula 1-4

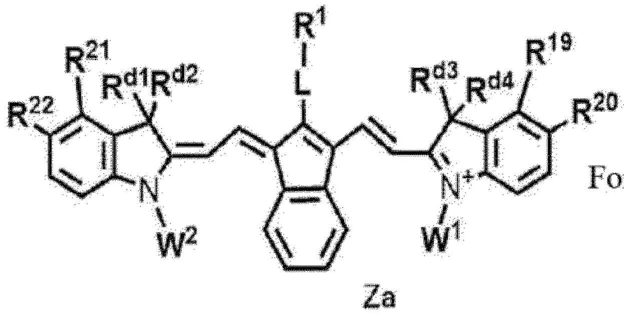

Formula 1-5

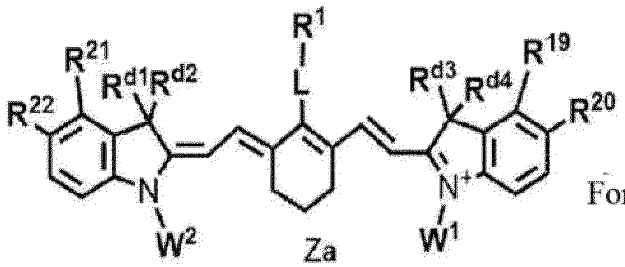

Formula 1-6

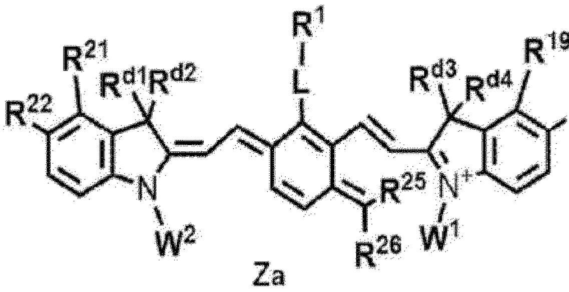

Formula 1-7

in Formula 1-3 to Formula 1-7, $R^1$ represents a group that is represented by any of Formula 2-1 to Formula 4-1, $R^{19}$ to $R^{22}$ each independently represent a hydrogen atom, a halogen atom, $-R^a$, $-OR^b$, -CN, $-SR^c$, or $-NR^dR^e$, $R^{25}$ and $R^{26}$ each independently represent a hydrogen atom, a halogen atom, or $-R^a$, $R^a$ to $R^e$ each independently represent a hydrocarbon group, $R^{19}$ and $R^{20}$, $R^{21}$ and $R^{22}$, or $R^{25}$ and $R^{26}$ may be linked to each other to form a monocyclic or polycyclic ring, L represents an oxygen atom, a sulfur atom, or $-N(R^{10})-$, $R^{10}$ represents a hydrogen atom, an alkyl group, or an aryl group, $R^{d1}$ to $R^{d4}$ each independently represent an alkyl group which may have a substituent, $W^1$ and $W^2$ each independently represent an alkyl group having a substituent and have at least $-OCH_2CH_2-$, a sulfo group, a salt of a sulfo group, a carboxy group, or a salt of a carboxy group as the substituent, and Za represents a counterion that neutralizes charge.

**11.** The on-press development type lithographic printing plate precursor according to claim 1, wherein the polymerization initiator includes an electron-donating polymerization initiator, and wherein the polymerization initiator further includes an electron-accepting polymerization initiator.

**12.** The on-press development type lithographic printing plate precursor according to any one of claims 1 to 11, wherein the polymerization initiator includes a compound that is a salt formed of a cation having a structure of an electron-accepting polymerization initiator and an anion having a structure of an electron-donating polymerization initiator.

**13.** The on-press development type lithographic printing plate precursor according to claim 11,

wherein the electron-accepting polymerization initiator includes a compound represented by Formula (II),

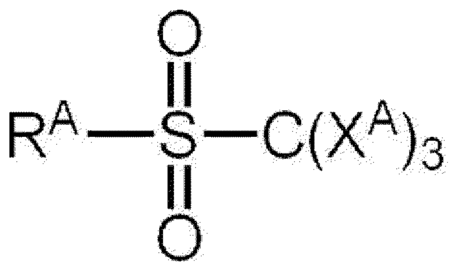

( II )

in Formula (II), $X^A$ represents a halogen atom, and $R^A$ represents an aryl group.

**14.** A method of preparing a lithographic printing plate, comprising:

a step of exposing the on-press development type lithographic printing plate precursor according to any one of claims 1 to 13 in a shape of an image; and

a step of supplying at least one material selected from the group consisting of a printing ink and dampening water on a printer to remove the image-recording layer in a non-image area.

**Patentansprüche**

**1.** Lithographischer Druckplattenvorläufer des Auf-Presse-Entwicklungstyps, umfassend, in der folgenden Reihenfolge:

einen Aluminiumträger;
eine Bildaufzeichnungsschicht; und
eine äußerste Schicht,
wobei die Bildaufzeichnungsschicht einen Infrarotabsorber, einen Polymerisationsinitiator und eine polymerisierbare Verbindung enthält,
der Aluminiumträger eine Aluminiumplatte und einen anodischen Oxidfilm von Aluminium, der auf der Aluminiumplatte angeordnet ist, aufweist,
eine Steilheit a45, die ein Flächenverhältnis eines Abschnitts, in dem eine Komponente mit einer Wellenlänge von 0,2 μm bis 2 μm eine Neigung von 45° oder mehr innerhalb einer Oberfläche des anodischen Oxidfilms auf einer Seite der Bildaufzeichnungsschicht aufweist, darstellt, 30 % oder weniger beträgt,
die äußerste Schicht eine Verfärbungsverbindung enthält, wobei die Verfärbungsverbindung eine Verbindung ist, die aufgrund der Exposition gegenüber Infrarot Änderung von Absorption in dem sichtbaren Lichtbereich, der eine Wellenlänge von 400 nm oder mehr und weniger als 750 nm aufweist, erfährt, wobei Infrarot eine Wellenlänge von 750 nm bis 1 mm aufweist; und
eine Dichte von Aussparungsabschnitten, die eine Tiefe von 0,7 μm oder mehr von einer Mittellinie in einer Rauheitskurve aufweisen, wobei die Dichte durch Messen eines 400 μm × 400 μm-Bereichs einer Oberfläche des Aluminiumträgers auf einer Seite der Bildaufzeichnungsschicht durch Verwenden eines kontaktlosen dreidimensionalen Rauheitsmessers erhalten wird, 300 oder mehr beträgt.

2. Lithographischer Druckplattenvorläufer des Auf-Presse-Entwicklungstyps nach Anspruch 1, wobei in einem L*a*b*-Farbsystem ein Wert von Helligkeit L* der Oberfläche des anodischen Oxidfilms auf der Seite der Bildaufzeichnungsschicht 70 bis 90 beträgt.

3. Lithographischer Druckplattenvorläufer des Auf-Presse-Entwicklungstyps nach Anspruch 1 oder 2, wobei in einem Fall, in dem $S_X$ eine tatsächliche Fläche, die durch ein ungefähres Drei-Punkt-Verfahren aus dreidimensionalen Daten, die durch Messen von 512 × 512 Punkten in einem 25 μm × 25 μm-Bereich innerhalb der Oberfläche des anodischen Oxidfilms auf der Seite der Bildaufzeichnungsschicht durch Verwenden eines Rasterkraftmikroskops erhalten werden, erhalten wird, darstellt und $S_0$ eine geometrisch gemessene Fläche darstellt, eine spezifische Oberfläche △S, die ein Wert ist, der durch Gleichung (i) berechnet wird, 25 % oder mehr beträgt,

$$\triangle S = (S_X - S_0)/S_0 \times 100\ (\%) \cdots (i).$$

4. Lithographischer Druckplattenvorläufer des Auf-Presse-Entwicklungstyps nach einem der Ansprüche 1 bis 3,

wobei der anodische Oxidfilm Mikroporen, die sich in einer Tiefenrichtung von der Oberfläche auf der Seite der Bildaufzeichnungsschicht erstrecken, aufweist, und
ein Öffnungsverhältnis durch die Mikroporen 20 % bis 80 % in Bezug auf eine Gesamtfläche des anodischen Oxidfilms beträgt.

5. Lithographischer Druckplattenvorläufer des Auf-Presse-Entwicklungstyps nach Anspruch 4,

wobei die Mikroporen jeweils aus einem Abschnitt mit großem Durchmesser, der sich zu einer Position in einer Tiefe von 10 nm bis 1.000 nm von der Oberfläche des anodischen Oxidfilms erstreckt, und einem Abschnitt mit kleinem Durchmesser, der mit einem Bodenabschnitt des Abschnitts mit großem Durchmesser in Kommunikation steht und sich zu einer Position in einer Tiefe von 20 nm bis 2.000 nm von einer Kommunikationsposition erstreckt, aufgebaut sind,
ein durchschnittlicher Durchmesser des Abschnitts mit großem Durchmesser innerhalb der Oberfläche des anodischen Oxidfilms 15 nm bis 100 nm beträgt, und
ein durchschnittlicher Durchmesser des Abschnitts mit kleinem Durchmesser an der Kommunikationsposition 13 nm oder weniger beträgt.

6. Lithographischer Druckplattenvorläufer des Auf-Presse-Entwicklungstyps nach einem der Ansprüche 1 bis 5, wobei die Verfärbungsverbindung eine Verbindung, die Farbe aufgrund von Exposition gegenüber Infrarot entwickelt, enthält.

7. Lithographischer Druckplattenvorläufer des Auf-Presse-Entwicklungstyps nach einem der Ansprüche 1 bis 6,

wobei die Verfärbungsverbindung eine zersetzbare Verbindung, die aufgrund von Exposition gegenüber Infrarot zersetzt wird, enthält.

**8.** Lithographischer Druckplattenvorläufer des Auf-Presse-Entwicklungstyps nach einem der Ansprüche 1 bis 7, wobei die Verfärbungsverbindung ein Cyaninfarbstoff ist.

**9.** Lithographischer Druckplattenvorläufer des Auf-Presse-Entwicklungstyps nach einem der Ansprüche 1 bis 8,

wobei die Verfärbungsverbindung eine durch Formel 1-1 dargestellte Verbindung ist,

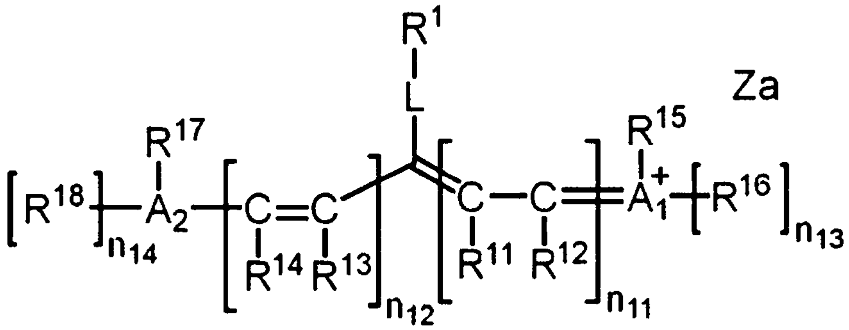

Formel 1-1

in Formel 1-1 $R^1$ eine Gruppe darstellt, die durch beliebige von Formel 2-1 bis Formel 4-1 dargestellt wird, $R^{11}$ bis $R^{18}$ jeweils unabhängig voneinander ein Wasserstoffatom, ein Halogenatom, $-R^a$, $-OR^b$, $-SR^c$ oder $-NR^dR^e$ darstellen, $R^a$ bis $R^e$ jeweils unabhängig voneinander eine Kohlenwasserstoffgruppe darstellen, $A_1$, $A_2$ und mehrere von $R^{11}$ bis $R^{18}$ so miteinander verbunden sein können, dass sie einen monozyklischen oder polyzyklischen Ring bilden, $A_1$ und $A_2$ jeweils unabhängig voneinander ein Sauerstoffatom, ein Schwefelatom oder ein Stickstoffatom darstellen, $n_{11}$ und $n_{12}$ jeweils unabhängig voneinander eine ganze Zahl von 0 bis 5 darstellen, eine Summe aus $n_{11}$ und $n_{12}$ 2 oder mehr beträgt, $n_{13}$ und $n_{14}$ jeweils unabhängig voneinander 0 oder 1 darstellen, L ein Sauerstoffatom, ein Schwefelatom oder $-N(R^{10})-$ darstellt, $R^{10}$ ein Wasserstoffatom, eine Alkylgruppe oder eine Arylgruppe darstellt und Za ein Gegenion, das Ladung neutralisiert, darstellt,

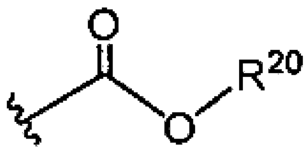

Formel 2-1

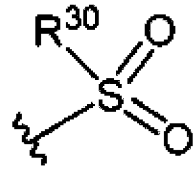

Formel 3-1

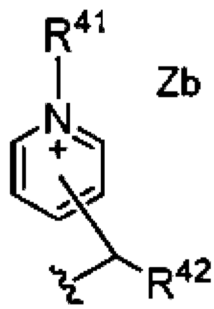

Formel 4-1

in Formel 2-1 bis Formel 4-1 $R^{20}$, $R^{30}$, $R^{41}$ und $R^{42}$ jeweils unabhängig voneinander eine Alkylgruppe oder eine Arylgruppe darstellen, Zb ein Gegenion darstellt, das Ladung neutralisiert, und eine Wellenlinie eine Bindungsstelle mit einer Gruppe, die durch L in Formel 1-1 dargestellt wird, darstellt.

**10.** Lithographischer Druckplattenvorläufer des Auf-Presse-Entwicklungstyps nach Anspruch 9,

wobei die Verfärbungsverbindung eine Verbindung ist, die durch Formel 1-2 dargestellt wird, oder eine Verbindung, die durch beliebige von Formel 1-3 bis 1-7 dargestellt wird,

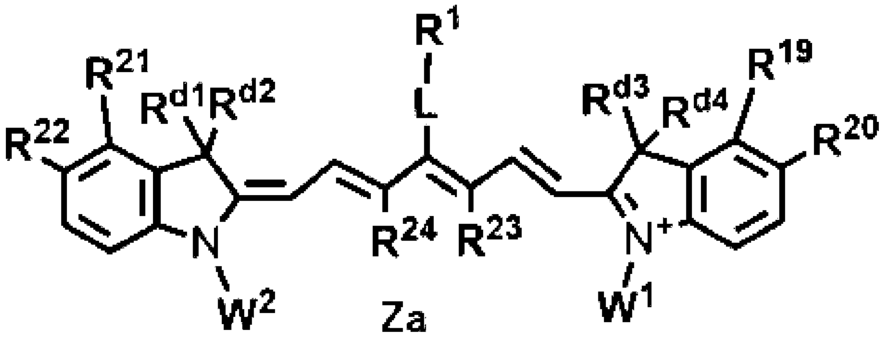

Formel 1-2

in Formel 1-2 $R^1$ eine Gruppe darstellt, die durch beliebige von Formel 2-1 bis Formel 4-1 dargestellt wird, $R^{19}$ bis $R^{22}$ jeweils unabhängig voneinander ein Wasserstoffatom, ein Halogenatom, $-R^a$, $-OR^b$, -CN, $-SR^c$ oder $-NR^dR^e$ darstellen, $R^{23}$ und $R^{24}$ jeweils unabhängig voneinander $-R^a$ darstellen, $R^a$ bis $R^e$ jeweils unabhängig voneinander eine Kohlenwasserstoffgruppe darstellen, $R^{19}$ und $R^{20}$, $R^{21}$ und $R^{22}$ oder $R^{23}$ und $R^{24}$ miteinander verbunden sein können, dass sie einen monozyklischen oder polyzyklischen Ring bilden, L ein Sauerstoffatom, ein Schwefelatom oder $-N(R^{10})$-darstellt, $R^{10}$ ein Wasserstoffatom, eine Alkylgruppe oder eine Arylgruppe darstellt, $R^{d1}$ bis $R^{d4}$ jeweils unabhängig voneinander eine Alkylgruppe, die einen Substituenten aufweisen kann, darstellen, $W^1$ und $W^2$ jeweils unabhängig voneinander eine Alkylgruppe mit einem Substituenten darstellen und mindestens $-OCH_2CH_2-$, eine Sulfogruppe, ein Salz einer Sulfogruppe, eine Carboxygruppe oder ein Salz einer Carboxygruppe als den Substituenten aufweisen und Za ein Gegenion, das Ladung neutralisiert, darstellt,

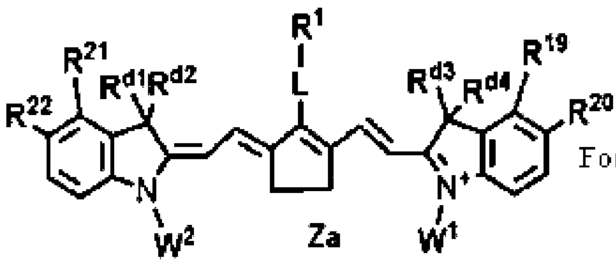

Formel 1-3

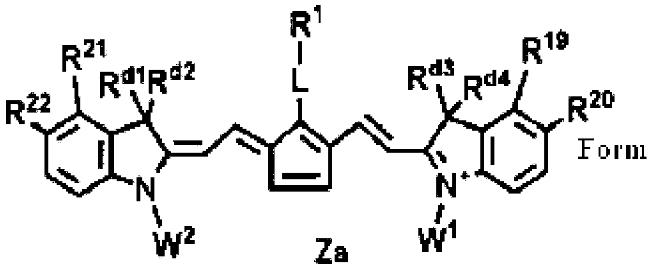

Formel 1-4

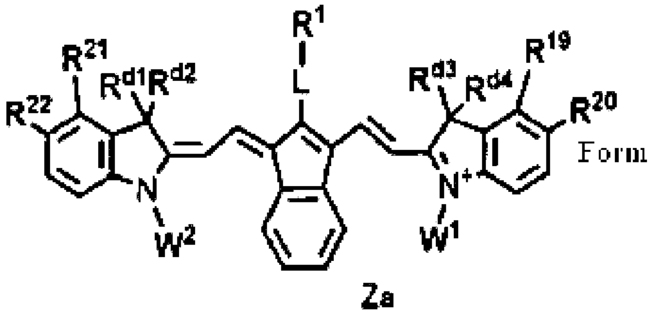

Formel 1-5

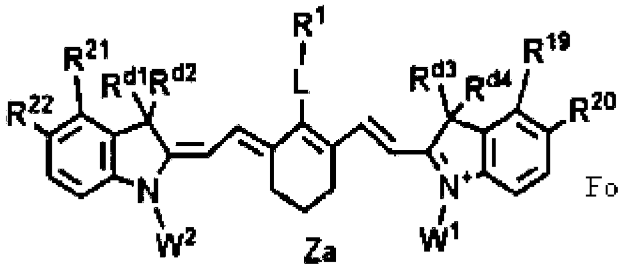

Formel 1-6

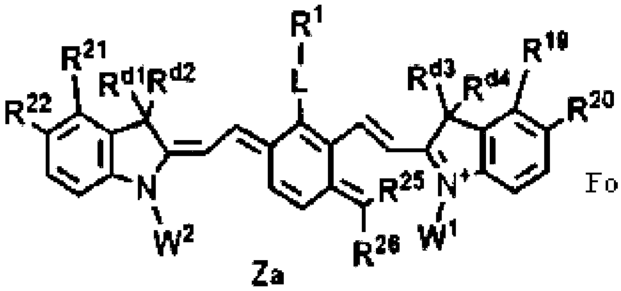

Formel 1-7

in Formel 1-3 bis Formel 1-7 $R^1$ eine Gruppe darstellt, die durch beliebige von Formel 2-1 bis Formel 4-1 dargestellt wird, $R^{19}$ bis $R^{22}$ jeweils unabhängig voneinander ein Wasserstoffatom, ein Halogenatom, $-R^a$, $-OR^b$, -CN, $-SR^c$ oder $-NR^dR^e$ darstellen, und $R^{26}$ jeweils unabhängig voneinander ein Wasserstoffatom, ein Halogenatom oder - $R^a$ darstellen, $R^a$ bis $R^e$ jeweils unabhängig voneinander eine Kohlenwasserstoffgruppe darstellen, $R^{19}$ und $R^{20}$, $R^{21}$ und $R^{22}$ oder $R^{25}$ und $R^{26}$ miteinander verbunden sein können, dass sie einen monozyklischen oder polyzyklischen Ring bilden, L ein Sauerstoffatom, ein Schwefelatom oder $-N(R^{10})-$ darstellt, $R^{10}$ ein Wasserstoffatom, eine Alkylgruppe oder eine Arylgruppe darstellt, $R^{d1}$ bis $R^{d4}$ jeweils unabhängig voneinander eine Alkylgruppe, die einen Substituenten aufweisen kann, darstellen, $W^1$ und $W^2$ jeweils unabhängig voneinander eine Alkylgruppe mit einem Substituenten darstellen und mindestens $-OCH_2CH_2-$, eine Sulfogruppe, ein Salz einer Sulfogruppe, eine Carboxygruppe oder ein Salz einer Carboxygruppe als den Substituenten aufweisen und Za ein Gegenion, das Ladung neutralisiert, darstellt.

**11.** Lithographischer Druckplattenvorläufer des Auf-Presse-Entwicklungstyps nach Anspruch 1,
wobei der Polymerisationsinitiator einen elektronenabgebenden Polymerisationsinitiator enthält und wobei der Polymerisationsinitiator ferner einen elektronenaufnehmenden Polymerisationsinitiator enthält.

**12.** Lithographischer Druckplattenvorläufer des Auf-Presse-Entwicklungstyps nach einem der Ansprüche 1 bis 11,
wobei der Polymerisationsinitiator eine Verbindung enthält, die ein Salz ist, das aus einem Kation, das eine Struktur eines elektronenaufnehmenden Polymerisationsinitiators aufweist, und einem Anion, das eine Struktur eines elektronenabgebenden Polymerisationsinitiators aufweist, gebildet ist.

**13.** Lithographischer Druckplattenvorläufer des Auf-Presse-Entwicklungstyps nach Anspruch 11,

wobei der elektronenaufnehmende Polymerisationsinitiator eine durch Formel (II) dargestellte Verbindung enthält,

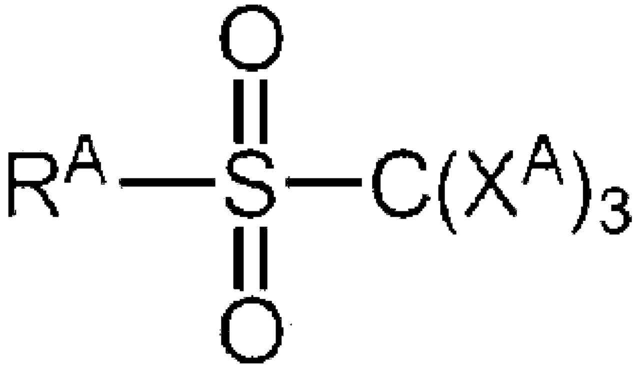

( II )

in Formel (II) $X^A$ ein Halogenatom darstellt und $R^A$ eine Arylgruppe darstellt.

**14.** Verfahren des Herstellens einer lithographischen Druckplatte, umfassend:

einen Schritt des Belichtens des lithographischen Druckplattenvorläufers des Auf-Presse-Entwicklungstyps nach einem der Ansprüche 1 bis 13 in einer Form eines Bildes; und
einen Schritt des Zuführens von mindestens einem Material, das aus der Gruppe ausgewählt wird, die aus einer Druckfarbe und Feuchtwasser besteht, auf einen Drucker, um die Bildaufzeichnungsschicht in einem Nichtbildbereich zu entfernen.

## Revendications

**1.** Précurseur de plaque d'impression lithographique de type développement sur presse comprenant, dans l'ordre suivant :

un support en aluminium ;
une couche d'enregistrement d'images ; et
une couche la plus externe,
dans lequel la couche d'enregistrement d'images contient un absorbeur infrarouge, un initiateur de polymérisation et un composé polymérisable,
le support en aluminium comporte une plaque en aluminium et un film d'oxyde anodique d'aluminium disposé sur la plaque en aluminium,
une pente a45 qui représente un rapport de surface d'une partie où un composant ayant une longueur d'onde de 0,2 μm à 2 μm a une inclinaison de 45° ou plus à une surface du film d'oxyde anodique sur un côté de la couche d'enregistrement d'images est de 30 % ou moins,
la couche la plus externe contient un composé décolorant, dans lequel le composé décolorant est un composé qui subit un changement d'absorption dans la région de lumière visible qui a longueur d'onde de 400 nm ou plus et inférieure à 750 nm, en raison de l'exposition à infrarouge, dans lequel infrarouge a une longueur d'onde de 750 nm à 1 mm; et
une densité de parties en creux ayant une profondeur de 0,7 μm ou plus à partir d'une ligne centrale dans une courbe de rugosité, la densité étant obtenue en mesurant une région de 400 μm × 400 μm d'une surface du support en aluminium sur un côté de la couche d'enregistrement d'images à l'aide d'un rugosimètre tridimensionnel sans contact, est de 300 ou plus.

**2.** Précurseur de plaque d'impression lithographique de type développement sur presse selon la revendication 1, dans lequel dans un système colorimétrique L*a*b, une valeur de luminosité L* de la surface du film d'oxyde anodique sur le côté de la couche d'enregistrement d'images est de 70 à 90.

**3.** Précurseur de plaque d'impression lithographique de type développement sur presse selon la revendication 1 ou la revendication 2,
dans lequel dans un cas où $S_X$ représente une surface réelle obtenue par une méthode approximative à trois points à partir de données tridimensionnelles obtenues en mesurant 512 × 512 points dans une région de 25 μm × 25 μm à la surface du film d'oxyde anodique sur le côté de la couche d'enregistrement d'images à l'aide d'un microscope à force atomique, et $S_0$ représente une surface mesurée géométriquement, une surface spécifique △S qui est une valeur calculée par Équation (i) est de 25 % ou plus,

$$\triangle S = (S_X - S_0)/S_0 \times 100\ (\%) \cdots (i).$$

**4.** Précurseur de plaque d'impression lithographique de type développement sur presse selon l'une quelconque des revendications 1 à 3,

dans lequel le film d'oxyde anodique comporte des micropores s'étendant dans une direction de profondeur à partir de la surface sur le côté de la couche d'enregistrement d'images, et
un taux d'ouverture par les micropores est de 20 % à 80 % par rapport à une surface totale du film d'oxyde anodique.

**5.** Précurseur de plaque d'impression lithographique de type développement sur presse selon la revendication 4,

dans lequel les micropores sont chacun composés d'une partie de grand diamètre qui s'étend jusqu'à une position à une profondeur de 10 nm à 1 000 nm à partir de la surface du film d'oxyde anodique et d'une partie de petit diamètre qui est en communication avec une partie inférieure de la partie de grand diamètre et s'étend jusqu'à une position à une profondeur de 20 nm à 2 000 nm à partir d'une position de communication,
un diamètre moyen de la partie de grand diamètre à la surface du film d'oxyde anodique est de 15 nm à 100 nm, et un diamètre moyen de la partie de petit diamètre à la position de communication est de 13 nm ou moins.

**6.** Précurseur de plaque d'impression lithographique de type développement sur presse selon l'une quelconque des revendications 1 à 5,
dans lequel le composé décolorant inclut un composé qui développe une couleur en raison d'une exposition à infrarouge.

**7.** Précurseur de plaque d'impression lithographique de type développement sur presse selon l'une quelconque des revendications 1 à 6,
dans lequel le composé décolorant inclut un composé décomposable qui se décompose en raison d'une exposition à infrarouge.

**8.** Précurseur de plaque d'impression lithographique de type développement sur presse selon l'une quelconque des revendications 1 à 7,
dans lequel le composé décolorant est un colorant cyanine.

**9.** Précurseur de plaque d'impression lithographique de type développement sur presse selon l'une quelconque des revendications 1 à 8,

dans lequel le composé décolorant est un composé représenté par Formule 1-1,

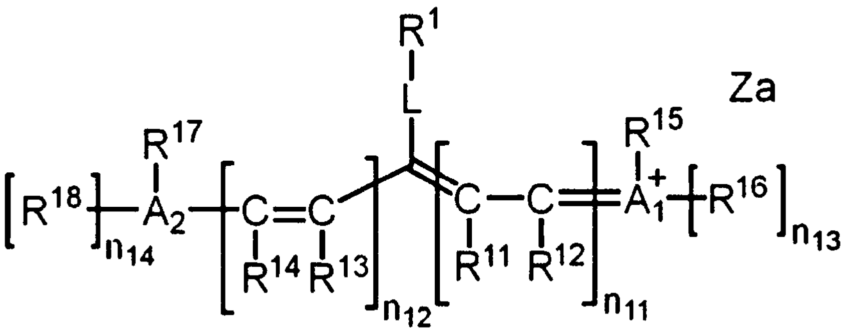

Formule 1-1

dans Formule 1-1, $R^1$ représente un groupe qui est représenté par l'une de Formule 2-1 à Formule 4-1, $R^{11}$ à $R^{18}$ représentent chacun indépendamment un atome d'hydrogène, un atome d'halogène, $-R^a$, $-OR^b$, $-SR^c$ ou $-NR^dR^e$, $R^a$ à $R^e$ représentent chacun indépendamment un groupe hydrocarboné, $A_1$, $A_2$, et une pluralité de $R^{11}$ à $R^{18}$ peuvent être liés entre eux pour former un cycle monocyclique ou polycyclique, $A_1$ et $A_2$ représentent chacun indépendamment un atome d'oxygène, un atome de soufre ou un atome d'azote, $n_{11}$ et $n_{12}$ représentent chacun indépendamment un entier de 0 à 5, une somme de $n_{11}$ et $n_{12}$ est de 2 ou plus, $n_{13}$ et $n_{14}$ représentent chacun indépendamment 0 ou 1, L représente un atome d'oxygène, un atome de soufre ou $-N(R^{10})-$, $R^{10}$ représente un atome d'hydrogène, un groupe alkyle ou un groupe aryle, et Za représente un contre-ion qui neutralise une charge,

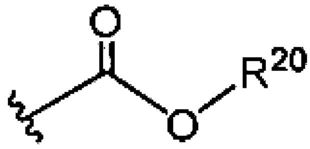

Formule 2-1

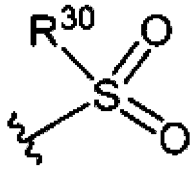

Formule 3-1

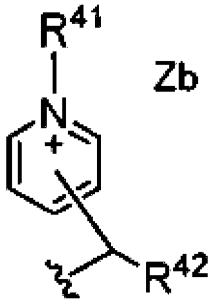

Formule 4-1

dans Formule 2-1 à Formule 4-1, $R^{20}$, $R^{30}$, $R^{41}$ et $R^{42}$ représentent chacun indépendamment un groupe alkyle ou un groupe aryle, Zb représente un contre-ion qui neutralise une charge, et une ligne ondulée représente un site de liaison avec un groupe représenté par L dans Formule 1-1.

**10.** Précurseur de plaque d'impression lithographique de type développement sur presse selon la revendication 9,

dans lequel le composé décolorant est un composé représenté par Formule 1-2, ou un composé représenté par l'une quelconque de Formule 1-3 à 1-7

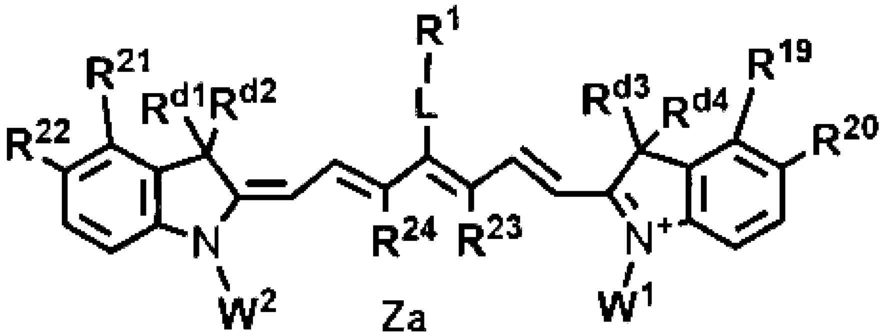

Formule 1-2

dans Formule 1-2, $R^1$ représente un groupe qui est représenté par l'une quelconque de Formule 2-1 à Formule 4-1, $R^{19}$ à $R^{22}$ représentent chacun indépendamment un atome d'hydrogène, un atome d'halogène, $-R^a$, $-OR^b$, -CN, $-SR^c$ ou $-NR^dR^e$, $R^{23}$ et $R^{24}$ représentent chacun indépendamment $-R^a$, $R^a$ à $R^e$ représentent chacun indépendamment un groupe hydrocarboné, $R^{19}$ et $R^{20}$, $R^{21}$ et $R^{22}$ ou $R^{23}$ et $R^{24}$ peuvent être liés entre eux pour former un cycle monocyclique ou polycyclique, L représente un atome d'oxygène, un atome de soufre ou $-N(R^{10})-$, $R^{10}$ représente un atome d'hydrogène, un groupe alkyle ou un groupe aryle, $R^{d1}$ à $R^{d4}$ représentent chacun indépendamment un groupe alkyle qui peut avoir un substituant, $W^1$ et $W^2$ représentent chacun indépendamment un groupe alkyle ayant un substituant et ont au moins $-OCH_2CH_2-$, un groupe sulfo, un sel d'un groupe sulfo, un groupe carboxyle ou un sel d'un groupe carboxyle comme le substituant, et Za représente un contre-ion qui neutralise une charge,

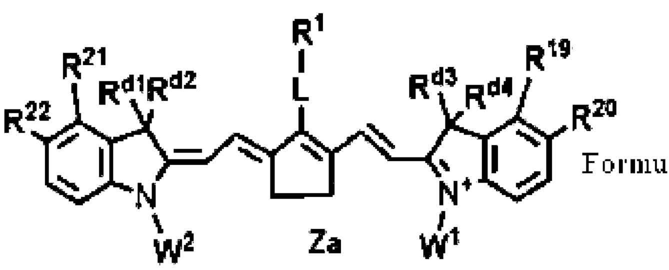

Formule 1-3

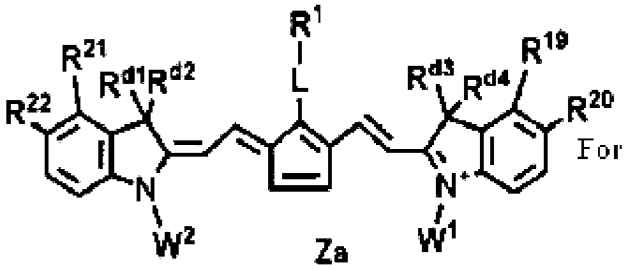

Formule 1-4

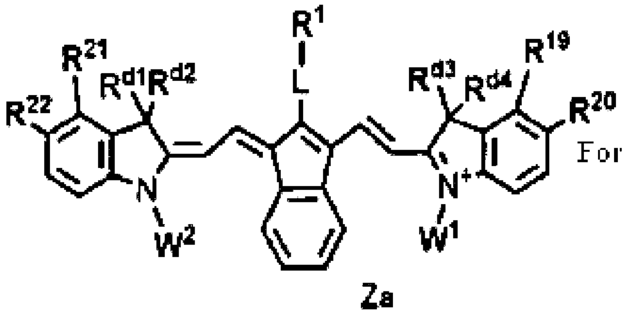

Formule 1-5

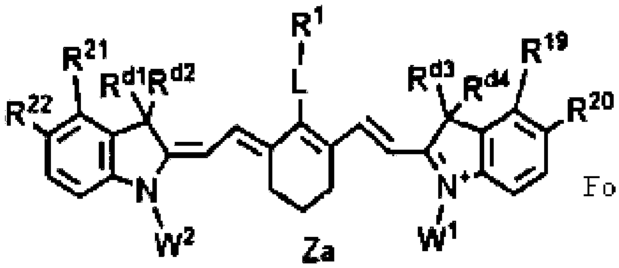

Formule 1-6

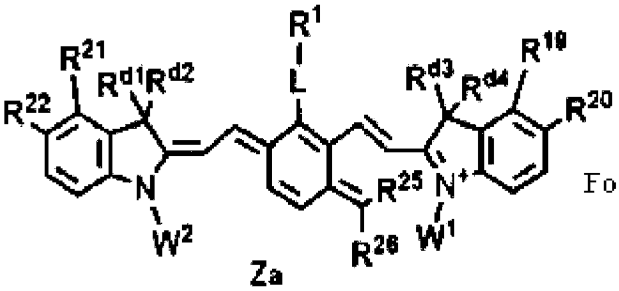

Formule 1-7

dans Formule 1-3 à Formule 1-7, $R^1$ représente un groupe qui est représenté par l'une quelconque de Formule 2-1 à Formule 4-1, $R^{19}$ à $R^{22}$ représentent chacun indépendamment un atome d'hydrogène, un atome d'halogène, $-R^a$, $-OR^b$, -CN, $-SR^c$ ou $-NR^dR^e$, $R^{25}$ et $R^{26}$ représentent chacun indépendamment un atome d'hydrogène, un atome d'halogène ou $-R^a$, $R^a$ à $R^e$ représentent chacun indépendamment un groupe hydrocarboné, $R^{19}$ et $R^{20}$, $R^{21}$ et $R^{22}$ ou $R^{25}$ et $R^{26}$ peuvent être liés entre eux pour former un cycle monocyclique ou polycyclique, L représente un atome d'oxygène, un atome de soufre ou $-N(R^{10})-$, $R^{10}$ représente un atome d'hydrogène, un groupe alkyle ou un groupe aryle, $R^{d1}$ à $R^{d4}$ représentent chacun indépendamment un groupe alkyle qui peut avoir un substituant, $W^1$ et $W^2$ représentent chacun indépendamment un groupe alkyle ayant un substituant et ont au moins $-OCH_2CH_2-$, un groupe sulfo, un sel d'un groupe sulfo, un groupe carboxyle ou un sel d'un groupe carboxyle comme le substituant, et Za représente un contre-ion qui neutralise une charge.

**11.** Précurseur de plaque d'impression lithographique de type développement sur presse selon la revendication 1, dans lequel l'initiateur de polymérisation inclut un initiateur de polymérisation donneur d'électrons, et dans lequel l'initiateur de polymérisation inclut en outre un initiateur de polymérisation accepteur d'électrons.

**12.** Précurseur de plaque d'impression lithographique de type développement sur presse selon l'une quelconque des

revendications 1 à 11,

dans lequel l'initiateur de polymérisation inclut un composé qui est un sel formé d'un cation ayant une structure d'un initiateur de polymérisation accepteur d'électrons et d'un anion ayant une structure d'un initiateur de polymérisation donneur d'électrons.

**13.** Précurseur de plaque d'impression lithographique de type développement sur presse selon la revendication 11,

dans lequel l'initiateur de polymérisation accepteur d'électrons inclut un composé représenté par Formule (II),

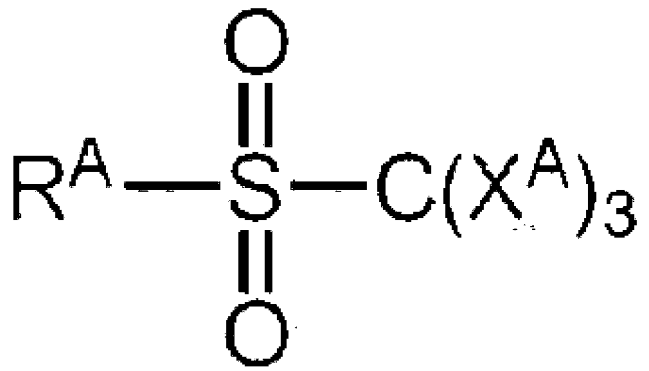

(II)

dans Formule (II), $X^A$ représente un atome d'halogène, et $R^A$ représente un groupe aryle.

**14.** Procédé de préparation d'une plaque d'impression lithographique, comprenant :

une étape d'exposition du précurseur de plaque d'impression lithographique de type développement sur presse selon l'une quelconque des revendications 1 à 13 sous une forme d'une image ; et

une étape de fourniture d'au moins un matériau choisi dans le groupe constitué d'une encre d'impression et d'eau de mouillage sur une presse pour éliminer la couche d'enregistrement d'images dans une zone sans image.

FIG. 1

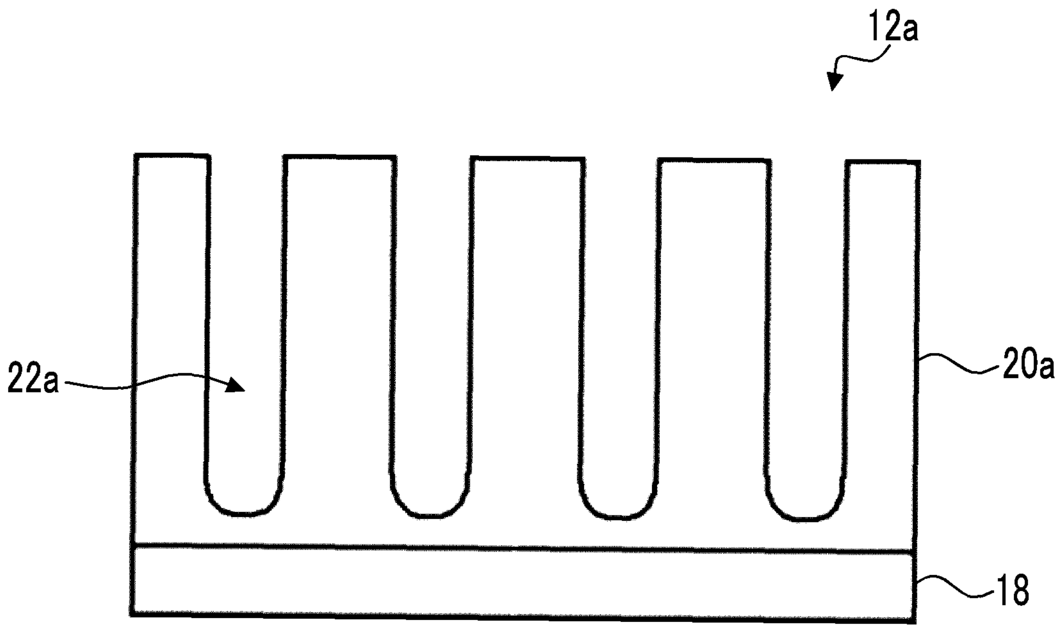


FIG. 2

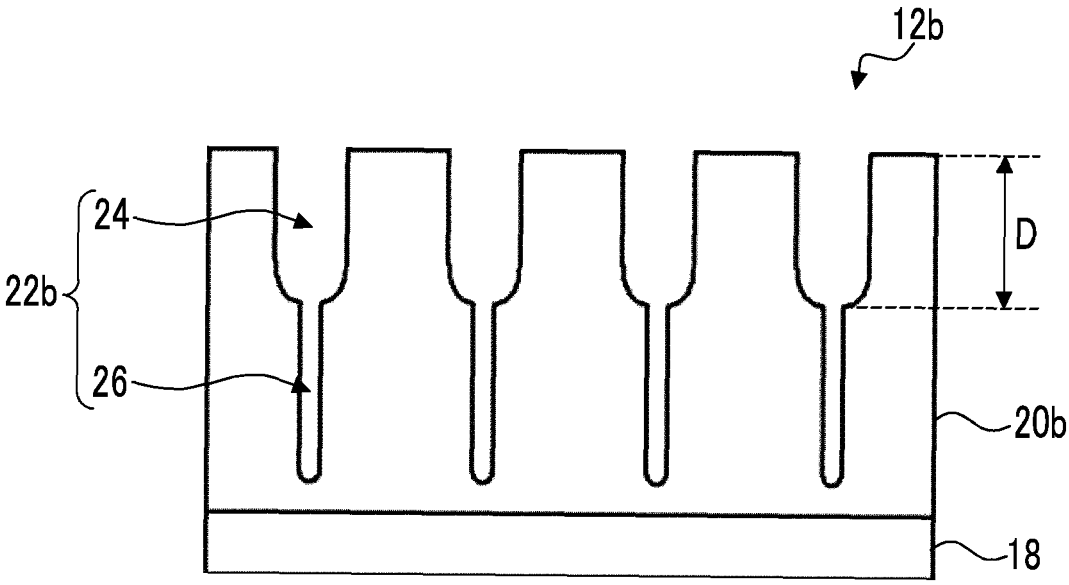

FIG. 3

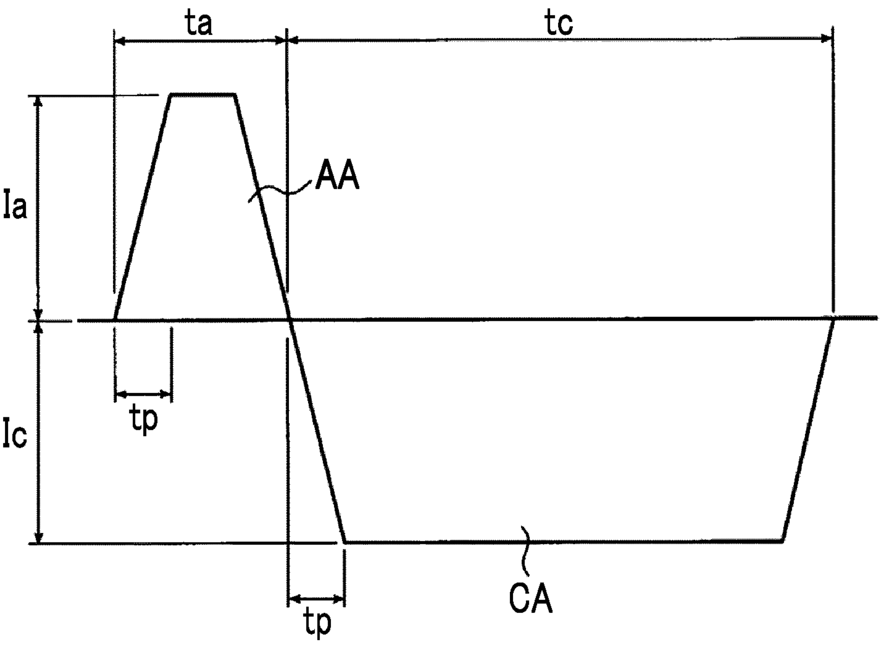


FIG. 4

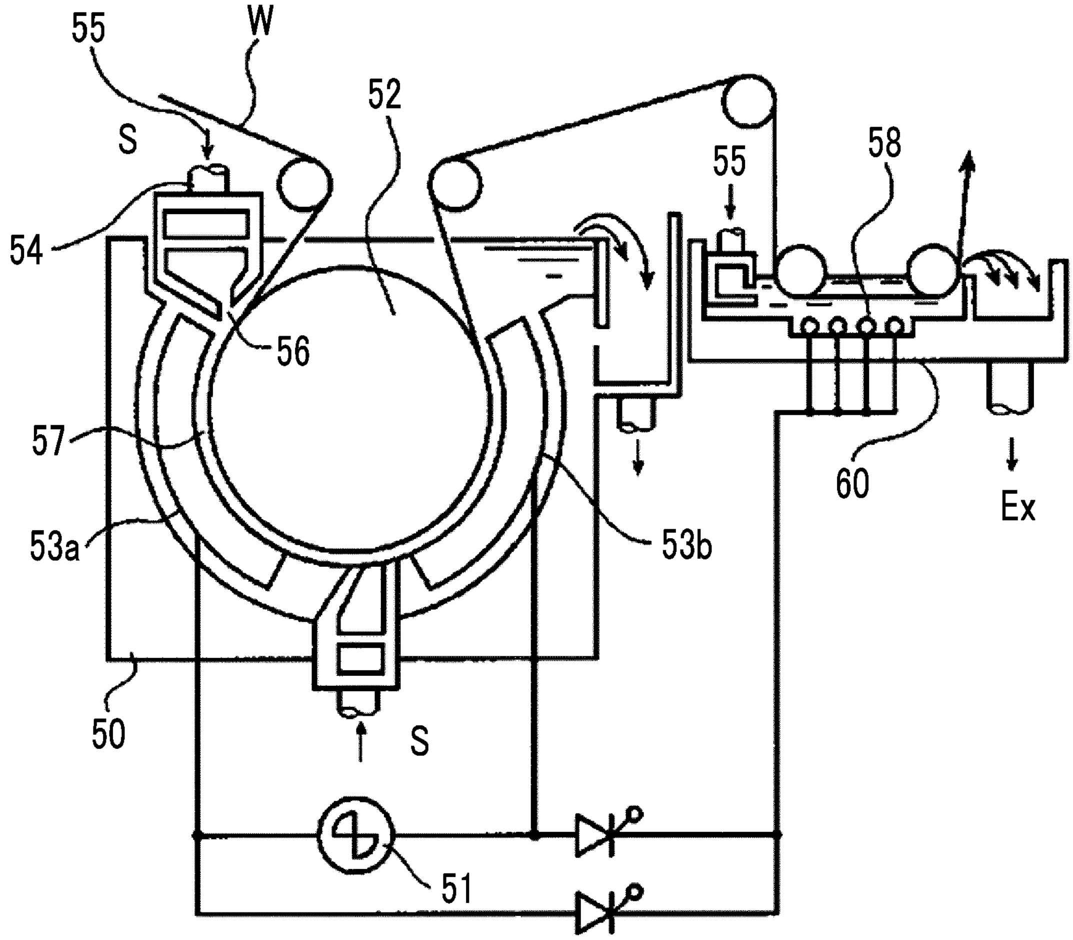

FIG. 5

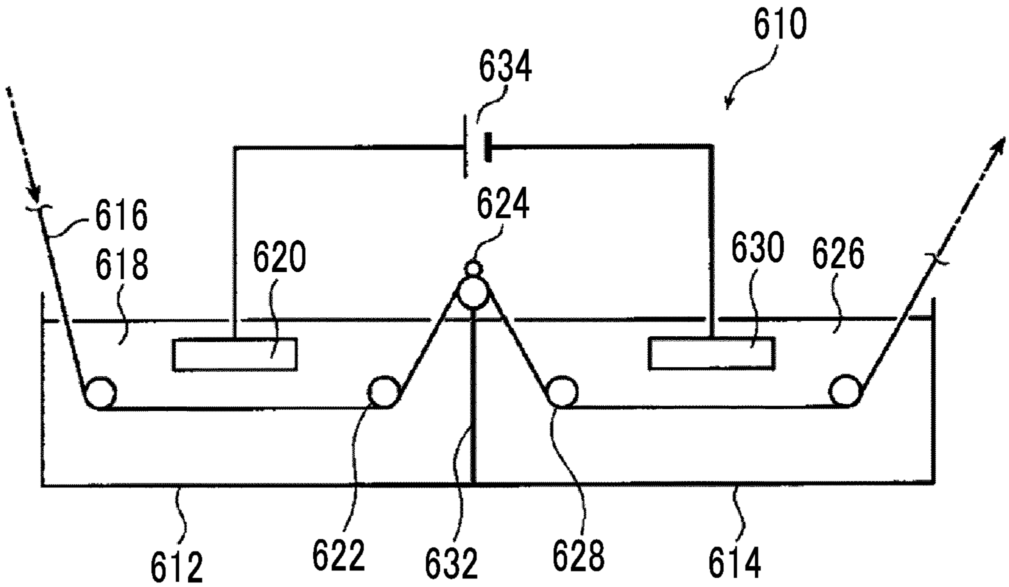

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019219560 A
- EP 3511174 A
- EP 3991983 A
- JP 50040047 B
- JP S5040047 B
- JP 5045885 A
- JP H545885 A
- JP 6035174 A
- JP H635174 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- WO 2018043259 A
- JP 2019064269 A
- JP 2009255434 A
- JP 2012187907 A
- JP 2012148555 A
- JP 2019018412 A
- JP 2005250216 A
- JP 2006259137 A
- WO 2016047392 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A


### Non-patent literature cited in the description


- Dye Handbooks. Society of Synthetic Organic Chemistry. 1970
- *Research Disclosure No. 33303*, January 1992
- **IWANAMI**. Dictionary of Physics and Chemistry. Iwanami Shoten, Publishers, 1998